Europäisches Patentamt

European Patent Office

Office européen des brevets

(19)

(11) **EP 1 387 484 A1**

(12) **EUROPEAN PATENT APPLICATION**
published in accordance with Art. 158(3) EPC

(43) Date of publication:
04.02.2004 Bulletin 2004/06

(51) Int Cl.7: **H03D 1/22**, H04B 1/30, H04L 27/38

(21) Application number: 01926146.0

(22) Date of filing: 08.05.2001

(86) International application number:
PCT/JP2001/003833

(87) International publication number:
WO 2002/091564 (14.11.2002 Gazette 2002/46)

(84) Designated Contracting States:
AT BE CH CY DE DK ES FI FR GB GR IE IT LI LU MC NL PT SE TR
Designated Extension States:
AL LT LV MK RO SI

(71) Applicants:
• Sony Corporation
Tokyo 141-0001 (JP)
• Sony International (Europe) GmbH
10785 Berlin (DE)

(72) Inventors:
• ABE, Masayoshi, c/o SONY CORPORATION
Tokyo 141-0001 (JP)

• SASHO, Noboru, c/o SONY CORPORATION
Tokyo 141-0001 (JP)
• KRUPEZEVIC, Dragan,
SONY INT.(EUROPE) G.M.B.H.
10785 Berlin (DE)
• BRANKOVIC, Veselin,
SONY INT. (EUROPE)G.M.B.H.
10785 Berlin (DE)
• RATNI, Mohamed,
SONY INT. (EUROPE) G.M.B.H.
10785 Berlin (DE)

(74) Representative: Thévenet, Jean-Bruno et al
Cabinet Beau de Loménie
158, rue de l'Université
75340 Paris Cédex 07 (FR)

(54) **DEMODULATOR AND RECEIVER USING IT**

(57)     A high performance demodulator able to realize a further wide band property, low distortion characteristic, and low power consumption in comparison with a conventional multi-port demodulator and having a small fluctuation in characteristics with respect to fluctuation in temperatures and aging including a first branch circuit 1001 for branching a reception signal to first to third three signals; a second branch circuit 1002 for branching a local signal to first and second two signals; a first phase shifter 1003 for shifting the phase of the first local signal from the second branch circuit 1002 by a shift amount θ1; a second phase shifter 1004 for shifting the phase of the second local signal from the second branch circuit 1002 by a shift amount θ2; a first coupler circuit 1005 for coupling the second reception signal from the first branch circuit 1001 and the local signal shifted in the phase by the shift amount θ1 by the first phase shifter 1003; a second coupler circuit 1006 for coupling the third reception signal from the first branch circuit 1001 and the local signal shifted in the phase by the shift amount θ2 by the second phase shifter 1004; a first power detector 1007 for detecting an amplitude component of the first reception signal by the first branch circuit 1001; a second power detector 1008 for detecting the amplitude component of a vector sum signal by the first coupler circuit 1005; a third power detector 1009 for detecting the amplitude component of a vector sum signal by the second coupler circuit 1006; and a multi-port signal-to-IQ signal conversion circuit 1010 receiving output signals P1, P2, and P3 of the first to third power detectors 1007 to 1009 and converting the result to an In-phase signal I(t) and a quadrature signal Q(t) as demodulated signals.

FIG.8

**Description**

TECHNICAL FIELD

The present invention relates to a demodulator of direct conversion system used in for example a communication apparatus for transmitting and receiving high frequency signals and effective also for impedance measurement at a high frequency band such as the GHz band and to a receiver using the same.

BACKGROUND ART

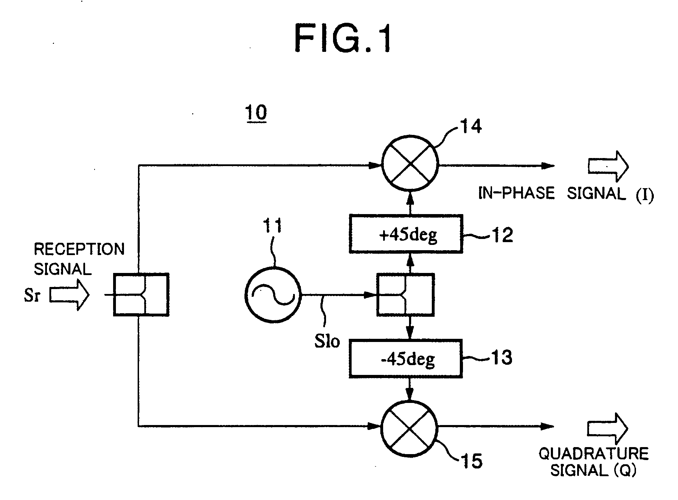

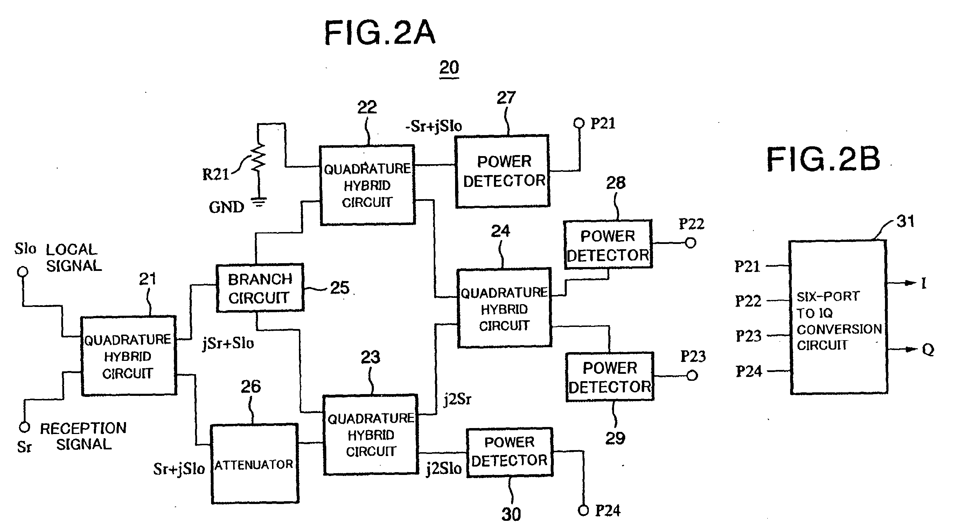

FIG. 1 is a circuit diagram of the configuration of principal parts of a general demodulator.
As shown in FIG. 1, this demodulator 10 has a local signal generation circuit 11, a +45 degree phase shifter 12, a -45 degree phase shifter 13, and RF mixers 14 and 15 as main components.
In this demodulator 10, a local signal S1o having a predetermined frequency generated by the local signal generation circuit 11 is shifted in phase by 45 degrees by the +45-degree phase shifter 12 and supplied to the RF mixer 14 or shifted in phase by -45 degrees by the -45 degree phase shifter 13 and supplied to the RF mixer 15.
Then, a signal Sr received via for example a not illustrated antenna element or a low noise amplifier is supplied to the RF mixers 14 and 15, the reception signal Sr and the local signal shifted in phase by exactly +45 degrees are multiplied at the RF mixer 14 to obtain an In-phase signal (I), and the reception signal Sr and the local signal shifted in phase by exactly -45 degrees are multiplied at the RF mixer 15 to obtain a quadrature signal (Q).
In the demodulator 10 using mixers as shown in FIG. 1, however, it is difficult to broaden the band, so a high local level must be supplied to the mixer. Further, the mixers are in a nonlinear operating state due to the high local power, so there is the disadvantage that demodulation with a low distortion is difficult.
Therefore, in recent years, a demodulator of a six-port system (multi-port demodulator) based on a principle different from FIG. 1 using a power detection circuit (power detector) is proposed.
In this six-port system demodulator, the power detector easily broadens the band in comparison with the mixer used in the above demodulation system. Due to this, a multi-port demodulator can be tell to have a good compatability with a software wireless system in which a multi-band or a wide band characteristic is demanded. Further, recent wireless communication tends to use a higher frequency as the carrier frequency and can even meet the demand for higher frequency.
Further, in a demodulation system using mixers, a high local level must be applied to the mixer. Contrary to this, in the multi-port system, the power detector operates in a linear region. Accordingly, with the multi-port system, demodulation is possible even with a low local signal power.
Further, in a demodulation system using mixers, the mixers are in a nonlinear operating state due to the high local power. Contrary to this, in the multi-port system, the power detector operates in the linear region. Accordingly, with a multi-port system, demodulation with a low distortion is possible.
Below, an explanation will be given of four examples of a six-port demodulator with reference to FIG. 2 to FIG. 5.
FIG. 2A is a block diagram of a first example of the configuration of a six-port demodulator (see Reference [1]: Ji Li et al.: "Dual Tone Calibration of Six-Port Junction and Its Application to the Six-Port Direct Digital Millimetric Receiver", IEEE Trans. On MTT, Vol. MTT-44, No. 1, Jan. '96.)
This six-port demodulator 20 has, as shown in FIG. 2A, quadrature hybrid circuits 21 to 24, a branch circuit 25, an attenuator 26, power detectors 27 to 30. and a low resistance element R21.
In the six-port demodulator 20, the reception signal Sr and the local signal S1o are input to the quadrature hybrid circuit 21, whereby signals jSr+Slo and Sr+jSlo are generated. Then, the signal jSr+Slo is branched at the branch circuit 25 and supplied to the quadrature hybrid circuits 22 and 23, while the signal Sr+jSlo is supplied via the attenuator 26 to the quadrature hybrid circuit 23.
The quadrature hybrid circuit 22 generates signals - Sr+jSlo and Sr+jSlo and supplies them to the power detector 27 and the quadrature hybrid circuit 24. Further, the quadrature hybrid circuit 23 generates signals j2Sr and j2Slo and supplies them to the quadrature hybrid circuit 24 and the power detector 30. The two output signals of the quadrature hybrid circuit 24 are supplied to the power detectors 28 and 29.
Then, the power detectors 27 to 30 detect for example envelope levels or power levels of input signals and output them as signals P21 to P24.
The baseband output signals from the power detectors 27 to 30, that is, the detection signals P21 to P24, are input to a multi-port signal-to-IQ signal conversion circuit 31 as shown in FIG. 2B and converted to the In-phase signal (I) and the quadrature signal (Q) included in the reception signal here.

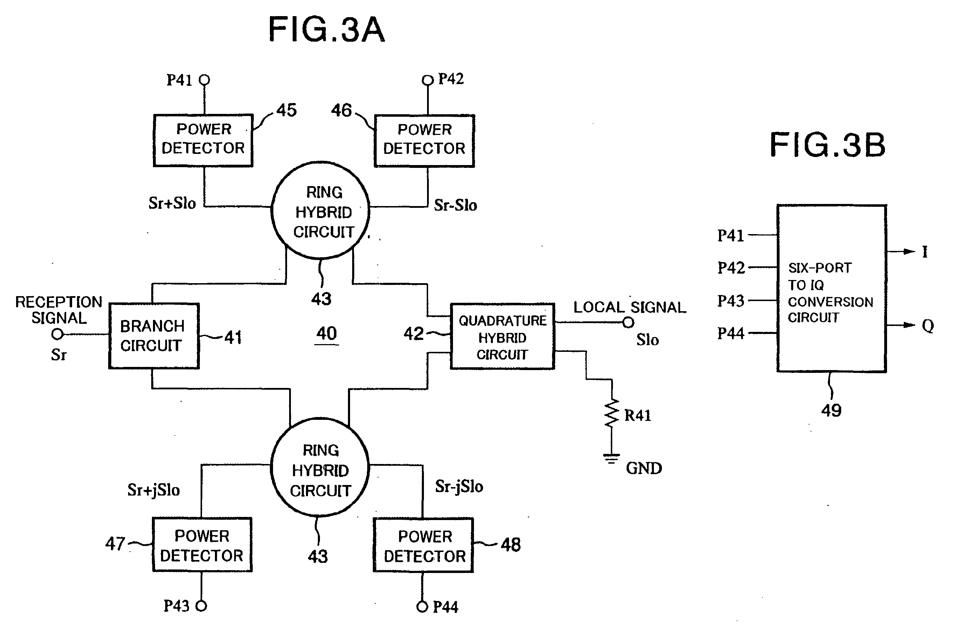

FIG. 3A is a block diagram of a second example of the configuration of a six-port demodulator (see Reference [2]: Kangasmaa et al.: "Six-Port Direct Conversion Receiver", European Microwave Conference '97).

This six-port demodulator 40 has, as shown in FIG. 3A, a branch circuit 41, a quadrature hybrid circuit 42, ring hybrid circuits 43 and 44, power detectors 45 to 48, and a resistance element R41.

The six-port demodulator 40 branches the reception signal Sr from the branch circuit 41 and supplies the result to the ring hybrid circuits 43 and 44. Further, the local signal S1o is subjected to predetermined quadrature processing at the quadrature hybrid circuit 42 and supplied to the ring hybrid circuits 43 and 44.

The ring hybrid circuit 43 generates signals Sr+Slo and Sr-Slo based on the input reception signal and local signal and supplies them to the power detectors 45 and 46. Further, the ring hybrid circuit 44 generates signals Sr+jSlo and Sr-jSlo based on the input reception signal and local signal and supplies them to the power detectors 47 and 48.

Then, the power detectors 45 to 48 detect for example envelope levels or power levels of the input signals and output them as signals P41 to P44.

The baseband output signals from the power detectors 45 to 48, that is, the detection signals P41 to P44, are input to a multi-port signal-to-IQ signal conversion circuit 49 as shown in FIG. 3B and converted to the In-phase signal (I) and the quadrature signal (Q) included in the reception signal here.

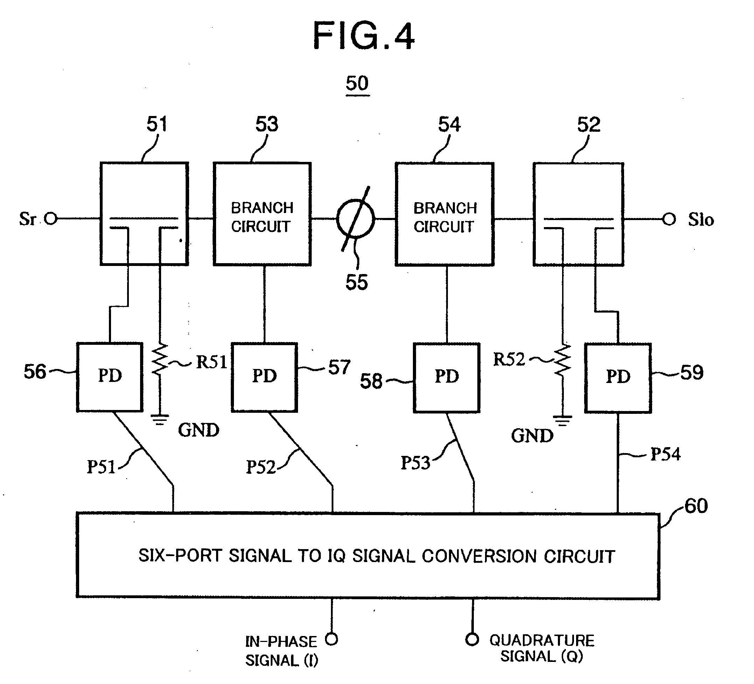

FIG. 4 is a block diagram of a third example of the configuration of a six-port demodulator (see Reference [3]: EP97122438.1 (DEC. 18, '97)).

This six-port demodulator 50 has couplers 51 and 52, branch circuits 53 and 54, a phase shifter 55, power detectors 56 to 59, resistance elements R51 and R52, and a six-port signal-to-IQ signal conversion circuit 60.

This six-port demodulator 50 inputs the reception signal Sr to the branch circuit 53 by the coupler 51 and inputs one part thereof to the power detector 56. The reception signal input to the branch circuit 53 is branched to two signals. One branched signal is input to the power detector 57, and the other signal is input to the phase shifter 55. The phase shifter 55 gives a phase shift θ to the reception signal by the branch circuit 53, then the phase shifted signal is input to the branch circuit 54 and branched to two signals. The branch circuit 54 inputs one branched signal to the power detector 58 and inputs the other signal to the coupler 52.

Further, the local signal S1o is input to the branch circuit 54 by the coupler 52, and one part thereof is input to the power detector 59. The local signal input to the branch circuit 54 is branched to two signals. One branched signal is input to the power detector 58, and the other signal is input to the phase shifter 55. The phase shifter 55 gives a phase shift θ to the local signal by the branch circuit 54, then the phase shifted signal is input to the branch circuit 53 and branched to two signals. The branch circuit 53 inputs one branched signal to the power detector 57 and inputs the other signal to the coupler 51.

The reception signal is supplied to the power detector 56. The power detector 56 detects an amplitude component of the supplied signal and supplies it as a signal P51 to the conversion circuit 60.

The power detector 57 is supplied with the reception signal and the local signal given the phase shift θ. The power detector 57 detects the amplitude component of the supplied signal and supplies it as a signal P52 to the conversion circuit 60.

Further, the power detector 58 is supplied with the local signal and the reception signal given the phase shift θ. The power detector 58 detects the amplitude component of the supplied signal and supplies it as a signal P53 to the conversion circuit 60.

Further, the power detector 59 is supplied with the local signal. The power detector 59 detects the amplitude component of the supplied signal and supplies it as a signal P54 to the conversion circuit 60.

Then, the conversion circuit 60 converts and outputs the input signal to the In-phase signal (I) and the quadrature signal (Q) as the demodulated signals.

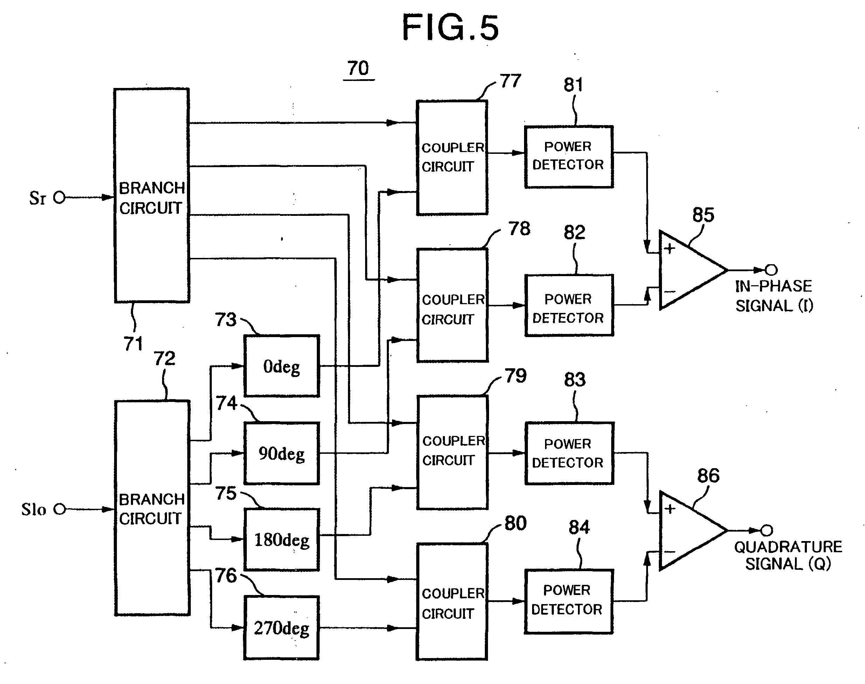

FIG. 5 is a block diagram of a fourth example of the configuration of a six-port demodulator (see Reference [4]: Hyyrulainen et al. "An Improved Correlator Circuit for a Six-Port Receiver", EP97308945.1 (filing date Nov. 07, '97).

This six-port demodulator 70 has branch circuits 71 and 72, a 0-degree phase shifter 73, a 90-degree phase shifter 74, a 180-degree phase shifter 75, a 270-degree phase shifter 76, coupler circuits 77 to 80, power detectors 81 to 84, and conversion circuits 85 and 86.

This six-port demodulator 70 branches the reception signal Sr to four signals by the branch circuit 71. The four branched signals are supplied to different coupler circuits 77 to 80.

Further, the branch circuit 72 branches the local signal S1o to four signals. The branched first local signal is input to the 0-degree phase shifter 73, held in phase as it is, and supplied to the coupler circuit 77. The branched second local signal is input to the 90-degree phase shifter 74, shifted in phase by 90 degrees, and supplied to the coupler circuit 78. The branched third local signal is input to the 180-degree phase shifter 75, shifted in phase by 180 degrees, and supplied to the coupler circuit 79. Then, the branched fourth local signal is input to the 270-degree phase shifter 76, shifted in phase by 270 degrees, and supplied to the coupler circuit 80.

The coupler circuit 77 couples the reception signal and the local signal and supplies the result to the power detector 81. The coupler circuit 78 couples the reception signal and the local signal shifted in phase by 90 degrees and supplies it to the power detector 82. The coupler circuit 79 couples the reception signal and the local signal shifted in phase by 180 degrees and supplies the result to the power detector 83. The coupler circuit 80 couples the reception signal and the local signal shifted in phase by 270 degrees and supplies the result to the power detector 84.

The power detector 81 detects the envelope level or power level of the supplied signal and supplies it to a non-inverted input terminal (+) of the conversion circuit 85. The power detector 82 detects the envelope level or power level of the supplied signal and supplies it to an inverted input terminal (-) of the conversion circuit 85.

The power detector 83 detects the envelope level or power level of the supplied signal and supplies it to a non-inverted input terminal (+) of the conversion circuit 86. The power detector 84 detects the envelope level or power level of the supplied signal and supplies it to an inverted input terminal (-) of the conversion circuit 86.

Then, the conversion circuit 85 generates the In-phase signal (I) included in the reception signal from the two supplied signals. The conversion circuit 86 generates the quadrature signal (Q) included in the reception signal from the two supplied signals.

However, the above multi-port system demodulator has the following disadvantages.

The multi-port demodulators shown in FIG. 2A and FIG. 3A use quadrature hybrid circuits and the ring hybrid circuits, so have room of improvement in terms of the wide band property.

Further, the multi-port demodulator shown in FIG. 4 similarly suffers from a problem in terms of the wide band property since it uses a directional coupler.

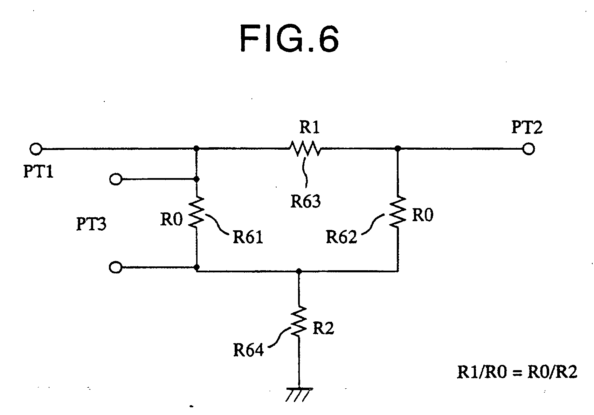

In general, as a directional coupler, use is made of a directional coupler using a Wheatstone bridge shown in FIG. 6. The directional coupler of FIG. 6 outputs a signal input through a port PT1 to a port PT3, but does not output a signal input through a port PT2 to the port PT3.

This directional coupler is configured by just the resistance elements R61 to R64 of resistance values R0 to R2, so has a wide band characteristic.

However, a power detector having a balanced input terminal must be connected to the port PT3. Alternatively, a balance-unbalance conversion circuit becomes necessary. In these circuits, the configuration becomes complex and increases the circuit size. Further, sometimes the frequency band characteristic is limited, and the characteristic is lowered.

Further, the multi-port demodulator shown in FIG. 4 employs a circuit configuration different from those of a power detector connected to a coupler and a power detector connected to a branch circuit. This causes different fluctuations in the detection characteristics such as temperatures and individual variations and consequently causes deterioration of the demodulation performance.

Further, in the multi-port demodulator shown in FIG. 5, while the problem relating to uniformity of characteristics of the power detectors is alleviated, there are the following disadvantages.

Namely, there is a room for improvement in terms of the wide band property. This is because the values of the four phase shifters must be 0 degree, 90 degrees, 180 degrees, and 270 degrees. This limits the usage frequency band.

Further, four power detectors, four coupler circuits, and a four-branch branch circuit are necessary, so there is room for improvement in terms of the complexity and size of the circuit.

DISCLOSURE OF THE INVENTION

The present invention was made in consideration with such a circumstance and has as an object thereof to provide a demodulator able to realize a low power consumption, a low distortion, a wide band characteristic, and a high demodulation performance and in addition able to achieve simplification of the circuit and able to prevent an increase of the circuit size and a receiver using the same.

A demodulator of a first aspect of the present invention comprises a first signal input terminal receiving as input a reception signal; a second signal input terminal receiving as input a local signal; a first branch circuit having an input terminal, a first output terminal, a second output terminal, and a third output terminal, the input terminal being connected to the first signal input terminal, branching the reception signal input to the input terminal to first, second, and third reception signals, outputting the first reception signal from the first output terminal, outputting the second reception signal from the second output terminal, and outputting the third reception signal from the third output terminal; a second branch circuit having an input terminal, a first output terminal, and a second output terminal, the input terminal being connected to the second signal input terminal, branching the local signal input to the input terminal to first and second local signals, outputting the first local signal from the first output terminal, and outputting the second local signal from the second output terminal; a first phase shifter for shifting a phase of the first local signal output from the first output terminal of the second branch circuit by exactly a predetermined amount and outputting the result; a second phase shifter for shifting a phase of the second local signal output from the second output terminal of the second branch circuit by exactly a predetermined amount and outputting the result; a first coupler circuit for coupling the second reception signal output from the second output terminal of the first branch circuit and the first local signal shifted in phase by exactly a predetermined amount output from the first phase shifter and outputting the result; a second coupler circuit for coupling the third reception signal output from the third output terminal of the first branch circuit and the second local signal shifted in phase by exactly a predetermined amount output from the second phase shifter and outputting the result; a first signal level detection circuit for detecting the level of the signal output from the first output terminal of the first branch circuit; a second signal level detection circuit for detecting the level of the signal output from the first coupler circuit; and a third signal level detection circuit for detecting the level of the signal output from the second coupler circuit.

Preferably, provision is further made of a conversion circuit for converting the output signal of the first signal level detection circuit, the output signal of the second signal level detection circuit, and the output signal of the third signal level detection circuit to a plurality of signal components included in the reception signal.

Further, in the demodulator according to the first aspect according to the present invention, the conversion circuit includes a first channel selecting means for selecting a desired channel from the output signal of the first signal level detection circuit, a second channel selecting means for selecting a desired channel from the output signal of the second signal level detection circuit, a third channel selecting means for selecting a desired channel from the output signal of the third signal level detection circuit, and a computation circuit for demodulating the In-phase component signal I and the quadrature component signal Q based on the output signal of the first channel selecting means, the output signal of the second channel selecting means, the output signal of the third channel selecting means, and predetermined circuit parameter constants.

Further, the computation circuit obtains the In-phase component signal I and the quadrature component signal Q by computation based on the following equations:

$$I(t) = h_{i0} + h_{i1}P_1 + h_{i2}P_2 + h_{i3}P_3$$

$$Q(t) = h_{q0} + h_{q1}P_1 + h_{q2}P_2 + h_{q3}P_3$$

Note, $P_1$ is the output signal of the first channel selecting means, $P_2$ is the output signal of the second channel selecting means, $P_3$ is the output signal of the third channel selecting means, and hik, hqk, k = 0, 1, 2, 3 are circuit parameter constants found from the circuit elements of the present demodulator.

Further, preferably, at least one of the first channel selecting means, second channel selecting means, and third channel selecting means includes a low pass filter.

A demodulator according to a second aspect of the present invention comprises a first signal input terminal receiving as input a reception signal; a second signal input terminal receiving as input a local signal; a first branch circuit having an input terminal, a first output terminal, a second output terminal, and a third output terminal, the input terminal being connected to the first signal input terminal, branching the reception signal input to the input terminal to first, second, and third reception signals, outputting the first reception signal from the first output terminal, outputting the second reception signal from the second output terminal, and outputting the third reception signal from the third output terminal; a second branch circuit having an input terminal, a first output terminal, and a second output terminal, the input terminal being connected to the second signal input terminal, branching the local signal input to the input terminal to first and second local signals, outputting the first local signal from the first output terminal, and outputting the second local signal from the second output terminal; a first phase shifter for shifting a phase of the first local signal output from the first output terminal of the second branch circuit by exactly a predetermined amount and outputting the result; a second phase shifter for shifting a phase of the second local signal output from the second output terminal of the second branch circuit by exactly a predetermined amount and outputting the result; a first coupler circuit for coupling the second reception signal output from the second output terminal of the first branch circuit and the first local signal shifted in phase by exactly a predetermined amount output from the first phase shifter and outputting the result; a second coupler circuit for coupling the third reception signal output from the third output terminal of the first branch circuit and the second local signal shifted in phase by exactly a predetermined amount output from the second phase shifter and outputting the result; a first signal level detection circuit for detecting the level of the signal output from the first output terminal of the first branch circuit; a second signal level detection circuit for detecting the level of the signal output from the first coupler circuit; a third signal level detection circuit for detecting the level of the signal output from the second coupler circuit; a first analog/digital converter for converting the output signal of the first signal level detection circuit from an analog signal to a digital signal; a second analog/digital converter for converting the output signal of the second signal level detection circuit from an analog signal to a digital signal; a third analog/digital converter for converting the output signal of the third signal level detection circuit from an analog signal to a digital signal; and a conversion circuit for converting the output digital signal of the first analog/digital converter, the output digital signal of the second analog/digital converter, and the output digital signal of the third analog/digital converter to a plurality of signal components included in the reception signal.

Preferably, the demodulator according to the second aspect of the present invention further comprises a first filter for removing a high frequency component of the output signal of the first signal level detection circuit and inputting the result to the first analog/digital converter; a second filter for removing the high frequency component of the output signal of the second signal level detection circuit and inputting the result to the second analog/digital converter; and a third filter for removing the high frequency component of the output signal of the third signal level detection circuit and inputting the result to the third analog/digital converter, wherein the conversion circuit includes a first channel selecting means for selecting a desired channel from the output signal of the first analog/digital converter, a second channel selecting means for selecting a desired channel from the output signal of the second analog/digital converter, a third channel selecting means for selecting a desired channel from the output signal of the third analog/digital converter, and a computation circuit for demodulating the In-phase component signal I and the quadrature component signal Q based on the output signal of the first channel selecting means, the output signal of the second channel selecting means, the output signal of the third channel selecting means, and predetermined circuit parameter constants.

Further, preferably, the demodulator according to the second aspect of the present invention further comprises a first channel selecting means for selecting a desired channel from the output signal of the first signal level detection circuit and inputting the result to the first analog/digital converter, a second channel selecting means for selecting a desired channel from the output signal of the second signal level detection circuit and inputting the result to the second analog/digital converter, and a third channel selecting means for selecting a desired channel from the output signal of the third signal level detection circuit and inputting the result to the third analog/digital converter, wherein the conversion circuit includes a computation circuit for demodulating the In-phase component signal I and the quadrature component signal Q based on the output digital signal of the first analog/digital converter, the output digital signal of the second analog/digital converter, the output digital signal of the third analog/digital converter, and the predetermined circuit parameter constants.

Further, the computation circuit obtains the In-phase component signal I and the quadrature component signal Q by computation based on the following equations:

$$I(t) = h_{i0} + h_{i1}P_1 + h_{i2}P_2 + h_{i3}P_3$$

$$Q(t) = h_{q0} + h_{q1}P_1 + h_{q2}P_2 + h_{q3}P_3$$

Note, $P_1$ is the output signal of the first channel selecting means, $P_2$ is the output signal of the second channel selecting means, $P_3$ is the output signal of the third channel selecting means, and hik, hqk, k = 0, 1, 2, 3 are circuit parameter constants found from the circuit elements of the present demodulator.

Further, preferably, at least one of the first channel selecting means, second channel selecting means, and third channel selecting means includes a low pass filter.

A demodulator of a third aspect of the present invention comprises a first signal input terminal receiving as input a reception signal; a second signal input terminal receiving as input a local signal; a first branch circuit having an input terminal, a first output terminal, a second output terminal, and a third output terminal, the input terminal being connected to the first signal input terminal, branching the reception signal input to the input terminal to first, second, and third reception signals, outputting the first reception signal from the first output terminal, outputting the second reception signal from the second output terminal, and outputting the third reception signal from the third output terminal; a second branch circuit having an input terminal, a first output terminal, a second output terminal, and a third output terminal, the input terminal being connected to the second signal input terminal, branching the local signal input to the input terminal to first, second, and third local signals, outputting the first local signal from the first output terminal, outputting the second local signal from the second output terminal, and outputting the third local signal from the third output terminal; a first phase shifter for shifting a phase of the first local signal output from the first output terminal of the second branch circuit by exactly a predetermined amount and outputting the result; a second phase shifter for shifting a phase of the second local signal output from the second output terminal of the second branch circuit by exactly a predetermined amount and outputting the result; a first coupler circuit for coupling the second reception signal output from the second output terminal of the first branch circuit and the first local signal shifted in phase by exactly a predetermined amount output from the first phase shifter and outputting the result; a second coupler circuit for coupling the third reception signal output from the third output terminal of the first branch circuit and the second local signal shifted in phase by exactly a predetermined amount output from the second phase shifter and outputting the result; a third coupler circuit for coupling the first reception signal output from the first output terminal of the first branch circuit and the third local signal output from the third output terminal of the second branch circuit and outputting the result; a first signal level detection circuit for detecting the level of the signal output from the third coupler circuit; a second signal level detection circuit for detecting the level of the signal output from the first coupler circuit; and a third signal level detection circuit for detecting the level of the signal output from the second coupler circuit.

Preferably, provision is further made of a conversion circuit for converting the output signal of the first signal level detection circuit, the output signal of the second signal level detection circuit, and the output signal of the third signal level detection circuit to a plurality of signal components included in the reception signal.

Further, in the demodulator according to the third aspect of the present invention, the conversion circuit includes a first channel selecting means for selecting a desired channel from the output signal of the first signal level detection circuit, a second channel selecting means for selecting a desired channel from the output signal of the second signal level detection circuit, a third channel selecting means for selecting a desired channel from the output signal of the third signal level detection circuit, and a computation circuit for demodulating the In-phase component signal I and the quadrature component signal Q based on the output signal of the first channel selecting means, the output signal of the second channel selecting means, the output signal of the third channel selecting means, and predetermined circuit parameter constants.

Further, the computation circuit obtains the In-phase component signal I and the quadrature component signal Q by computation based on the following equations:

$$I(t) = h_{i0} + h_{i1}P_1 + h_{i2}P_2 + h_{i3}P_3$$

$$Q(t) = h_{q0} + h_{q1}P_1 + h_{q2}P_2 + h_{q3}P_3$$

Note, $P_1$ is the output signal of the first channel selecting means, $P_2$ is the output signal of the second channel selecting means, $P_3$ is the output signal of the third channel selecting means, and hik, hqk, k = 0, 1, 2, 3 are circuit parameter constants found from the circuit elements of the present demodulator.

Further, preferably, at least one of the first channel selecting means, second channel selecting means, and third channel selecting means includes a low pass filter.

A demodulator of a fourth aspect of the present invention comprises a first signal input terminal receiving as input a reception signal; a second signal input terminal receiving as input a local signal; a first branch circuit having an input terminal, a first output terminal, and a second output terminal, the input terminal being connected to the first signal input terminal, branching the reception signal input to the input terminal to first and second reception signals, outputting the first reception signal from the first output terminal, and outputting the second reception signal from the second output terminal; a second branch circuit having an input terminal, a first output terminal, and a second output terminal, the input terminal being connected to the first output terminal of the first branch circuit, branching the reception signal input to the input terminal to third and fourth reception signals, outputting the third reception signal from the first output terminal, and outputting the fourth reception signal from the second output terminal; a third branch circuit having an input terminal, a first output terminal, and a second output terminal, the input terminal being connected to the second signal input terminal, branching the local signal input to the input terminal to first and second local signals, outputting the first local signal from the first output terminal, and outputting the second local signal from the second output terminal; a first phase shifter for shifting a phase of the first local signal output from the first output terminal of the third branch circuit by exactly a predetermined amount and outputting the result; a second phase shifter for shifting a phase of the second local signal output from the second output terminal of the third branch circuit by exactly a predetermined amount and outputting the result; a first coupler circuit for coupling the third reception signal output from the first output terminal of the second branch circuit and the first local signal shifted in phase by exactly a predetermined amount output from the first phase shifter and outputting the result; a second coupler circuit for coupling the fourth reception signal output from the second output terminal of the second branch circuit and the second local signal shifted in phase by exactly a predetermined amount output from the second phase shifter and outputting the result; a first signal level detection circuit for detecting the level of the signal output from the first coupler circuit; a second signal level detection circuit for detecting the level of the signal output from the second coupler circuit; and a third signal level detection circuit for detecting the level of the signal output from the second output terminal of the first branch circuit.

Preferably, provision is further made of a conversion circuit for converting the output signal of the first signal level detection circuit, the output signal of the second signal level detection circuit, and the output signal of the third signal level detection circuit to a plurality of signal components included in the reception signal.

Further, in the demodulator according to the fourth aspect of the present invention, the conversion circuit includes a first channel selecting means for selecting a desired channel from the output signal of the first signal level detection circuit, a second channel selecting means for selecting a desired channel from the output signal of the second signal level detection circuit, a third channel selecting means for selecting a desired channel from the output signal of the third signal level detection circuit, and a computation circuit for demodulating the In-phase component signal I and the quadrature component signal Q based on the output signal of the first channel selecting means, the output signal of the second channel selecting means, the output signal of the third channel selecting means, and predetermined circuit parameter constants.

Further, the computation circuit obtains the In-phase component signal I and the quadrature component signal Q by computation based on the following equations:

$$I(t) = h_{i0} + h_{i1}P_1 + h_{i2}P_2 + h_{i3}P_3$$

$$Q(t) = h_{q0} + h_{q1}P_1 + h_{q2}P_2 + h_{q3}P_3$$

Note, $P_1$ is the output signal of the first channel selecting means, $P_2$ is the output signal of the second channel selecting means, $P_3$ is the output signal of the third channel selecting means, and hik, hqk, k = 0, 1, 2, 3 are circuit parameter constants found from the circuit elements of the present demodulator.

Further, preferably; at least one of the first channel selecting means, second channel selecting means, and third channel selecting means includes a low pass filter.

Further, in the demodulator according to the fourth aspect of the present invention, an amplifier for amplifying the output signal from the first output terminal is connected to at least the first output terminal between the first output terminal and the second output terminal of the first branch circuit.

A demodulator according to a fifth aspect of the present invention comprises a first signal input terminal receiving as input a reception signal; a second signal input terminal receiving as input a local signal; a first branch circuit having an input terminal, a first output terminal, a second output terminal, and a third output terminal, the input terminal being connected to the first signal input terminal, branching the reception signal input to the input terminal to first, second, and third reception signals, outputting the first reception signal from the first output terminal, outputting the second reception signal from the second output terminal, and outputting the third reception signal from the third output terminal; a second branch circuit having an input terminal, a first output terminal, and a second output terminal, the input terminal being connected to the second signal input terminal, branching the local signal input to the input terminal to first and second local signals, outputting the first local signal from the first output terminal, and outputting the second local signal from the second output terminal; a first phase shifter for shifting a phase of the first local signal output from the first output terminal of the second branch circuit by exactly a predetermined amount and outputting the result; a second phase shifter for shifting a phase of the third reception signal output from the third output terminal of the first branch circuit by exactly a predetermined amount and outputting the result; a first coupler circuit for coupling the second reception signal output from the second output terminal of the first branch circuit and the first local signal shifted in phase by exactly a predetermined amount output from the first phase shifter and outputting the result; a second coupler circuit for coupling the third reception signal shifted in phase by exactly a predetermined amount output from the second phase shifter and the second local signal output from the second branch circuit and outputting the result; a first signal level detection circuit for detecting the level of the signal output from the first output terminal of the first branch circuit; a second signal level detection circuit for detecting the level of the signal output from the first coupler circuit; and a third signal level detection circuit for detecting the level of the signal output from the second coupler circuit.

Preferably, provision is further made of a conversion circuit for converting the output signal of the first signal level detection circuit, the output signal of the second signal level detection circuit, and the output signal of the third signal level detection circuit to a plurality of signal components included in the reception signal.

Further, in the demodulator according to the fifth aspect of the present invention, the conversion circuit includes a first channel selecting means for selecting a desired channel from the output signal of the first signal level detection circuit, a second channel selecting means for selecting a desired channel from the output signal of the second signal level detection circuit, a third channel selecting means for selecting a desired channel from the output signal of the third signal level detection circuit, and a computation circuit for demodulating the In-phase component signal I and the quadrature component signal Q based on the output signal of the first channel selecting means, the output signal of the second channel selecting means, the output signal of the third channel selecting means, and predetermined circuit parameter constants.

Further, the computation circuit obtains the In-phase component signal I and the quadrature component signal Q by computation based on the following equations:

$$I(t) = h_{i0} + h_{i1}P_1 + h_{i2}P_2 + h_{i3}P_3$$

$$Q(t) = h_{q0} + h_{q1}P_1 + h_{q2}P_2 + h_{q3}P_3$$

Note, $P_1$ is the output signal of the first channel selecting means, $P_2$ is the output signal of the second channel selecting means, $P_3$ is the output signal of the third channel selecting means, and hik, hqk, k = 0, 1, 2, 3 are circuit parameter constants found from the circuit elements of the present demodulator.

Further, preferably, at least one of the first channel selecting means, second channel selecting means, and third channel selecting means includes a low pass filter.

A demodulator of a sixth aspect of the present invention comprises a first signal input terminal receiving as input a reception signal; a second signal input terminal receiving as input a local signal; a first branch circuit having an input terminal, a first output terminal, and a second output terminal, the input terminal being connected to the first signal input terminal, branching the reception signal input to the input terminal to first and second reception signals, outputting the first reception signal from the first output terminal, and outputting the second reception signal from the second output terminal; a second branch circuit having an input terminal, a first output terminal, and a second output terminal, the input terminal being connected to the first output terminal of the first branch circuit, branching the reception signal input to the input terminal to third and fourth reception signals, outputting the third reception signal from the first output terminal, and outputting the fourth reception signal from the second output terminal; a third branch circuit having an input terminal, a first output terminal, and a second output terminal, the input terminal being connected to the second signal input terminal, branching the local signal input to the input terminal to first and second local signals, outputting the first local signal from the first output terminal, and outputting the second local signal from the second output terminal; a fourth branch circuit having an input terminal, a first output terminal, and a second output terminal, the input terminal being connected to the first output terminal of the third branch circuit, branching the local signal input to the input terminal to third and fourth local signals, outputting the third local signal from the first output terminal, and outputting the fourth local signal from the second output terminal; a first phase shifter for shifting a phase of the third local signal output from the first output terminal of the fourth branch circuit by exactly predetermined amount and outputting the result; a second phase shifter for shifting a phase of the fourth local signal output from the second output terminal of the fourth branch circuit by exactly a predetermined amount and outputting the result; a first coupler circuit for coupling the third reception signal output from the first output terminal of the second branch circuit and the third local signal shifted in phase by exactly a predetermined amount output from the first phase shifter and outputting the result; a second coupler circuit for coupling the fourth reception signal output from the second output terminal of the second branch circuit and the fourth local signal shifted in phase by exactly a predetermined amount output from the second phase shifter and outputting the result; a first signal level detection circuit for detecting the level of the signal output from the first coupler circuit; a second signal level detection circuit for detecting the level of the signal output from the second coupler circuit; a third signal level detection circuit for detecting the level of the signal output from the second output terminal of the first branch circuit; and a fourth signal level detection circuit for detecting the level of the signal output from the second output terminal of the third branch circuit.

Preferably, provision is further made of a conversion circuit for converting the output signal of the first signal level detection circuit, the output signal of the second signal level detection circuit, the output signal of the third signal level detection circuit, and the output signal of the fourth signal level detection circuit to a plurality of signal components included in the reception signal.

Further, in the demodulator according to the sixth aspect of the present invention, the conversion circuit obtains the In-phase component signal I and the quadrature component signal Q by computation based on the following equations:

$$I(t) = h_{i0} + h_{i1}P_1/P_4 + h_{i2}P_1/P_4 + h_{i3}P_1/P_4$$

$$Q(t) = h_{q0} + h_{q1}P_1/P_4 + h_{q2}P_1/P_4 + h_{q3}P_1/P_4$$

Note, $P_1$ is the output signal of the first signal level detection circuit, and $P_4$ is the output signal of the fourth signal level detection circuit, and hik, hqk, k = 0, 1, 2, 3 are circuit parameter constants found from the circuit elements of the present demodulator.

Further, in the demodulator according to the sixth aspect of the present invention, an amplifier for amplifying the output signal from the first output terminal is connected to at least the first output terminal between the first output terminal and the second output terminal of the first branch circuit.

A demodulator of a seventh aspect of the present invention comprises a first signal input terminal receiving as input a reception signal; a second signal input terminal receiving as input a local signal; a branch circuit having an input terminal, a first output terminal, and a second output terminal, the input terminal being connected to the first signal input terminal, branching the reception signal input to the input terminal to first and second reception signals, outputting the first reception signal from the first output terminal, and outputting the second reception signal from the second output terminal; a first phase divider having an input terminal, a first output terminal, and a second output terminal, the input terminal being connected to the first output terminal of the branch circuit, branching the reception signal input to the input terminal to third and fourth reception signals having inverse phases to each other, outputting the third reception signal from the first output terminal, and outputting the fourth reception signal from the second output terminal; a second phase divider having an input terminal, a first output terminal, and a second output terminal, the input terminal being connected to the second signal input terminal, branching the local signal input to the input terminal to first and second local signals having inverse phases to each other, outputting the first local signal from the first output terminal, and outputting the second local signal from the second output terminal; a first phase shifter for shifting a phase of the first local signal output from the first output terminal of the second phase divider by exactly a predetermined amount and outputting the result; a second phase shifter for shifting a phase of the second local signal output from the second output terminal of the second phase divider by exactly a predetermined amount and outputting the result; a first coupler circuit for coupling the third reception signal output from the first output terminal of the first phase divider and the first local signal shifted in phase by exactly a predetermined amount output from the first phase shifter and outputting the result; a second coupler circuit for coupling the fourth reception signal output from the second output terminal of the first phase divider and the second local signal shifted in phase by exactly a predetermined amount output from the second phase shifter and outputting the result; a first signal level detection circuit for detecting the level of the signal output from the first coupler circuit; a second signal level detection circuit for detecting the level of the signal output from the second coupler circuit; and a third signal level detection circuit for detecting the level of the signal output from the second output terminal of the branch circuit.

Preferably, provision is further made of a conversion circuit for converting the output signal of the first signal level detection circuit, the output signal of the second signal level detection circuit, and the output signal of the third signal level detection circuit to a plurality of signal components included in the reception signal.

Further, in the demodulator according to the seventh aspect of the present invention, the conversion circuit includes a first channel selecting means for selecting a desired channel from the output signal of the first signal level detection circuit, a second channel selecting means for selecting a desired channel from the output signal of the second signal level detection circuit, a third channel selecting means for selecting a desired channel from the output signal of the third signal level detection circuit, and a computation circuit for demodulating the In-phase component signal I and the quadrature component signal Q based on the output signal of the first channel selecting means, the output signal of the second channel selecting means, the output signal of the third channel selecting means, and predetermined circuit parameter constants.

Further, the computation circuit obtains the In-phase component signal I and the quadrature component signal Q by computation based on the following equations:

$$I(t) = h_{i0} + h_{i1}P_1 + h_{i2}P_2 + h_{i3}P_3$$

$$Q(t) = h_{q0} + h_{q1}P_1 + h_{q2}P_2 + h_{q3}P_3$$

Note, $P_1$ is the output signal of the first channel selecting means, $P_2$ is the output signal of the second channel selecting means, $P_3$ is the output signal of the third channel selecting means, and hik, hqk, k = 0, 1, 2, 3 are circuit parameter constants found from the circuit elements of the present demodulator.

Further, preferably, at least one of the first channel selecting means, second channel selecting means, and third channel selecting means includes a low pass filter.

A receiver according to an eighth aspect of the present invention comprises a demodulator having a first signal input terminal receiving as input a reception signal, a second signal input terminal receiving as input a local signal, a first branch circuit having an input terminal, a first output terminal, a second output terminal, and a third output terminal, the input terminal being connected to the first signal input terminal, branching the reception signal input to the input terminal to first, second, and third reception signals, outputting the first reception signal from the first output terminal, outputting the second reception signal from the second output terminal, and outputting the third reception signal from the third output terminal, a second branch circuit having an input terminal, a first output terminal, and a second output terminal, the input terminal being connected to the second signal input terminal, branching the local signal input to the input terminal to first and second local signals, outputting the first local signal from the first output terminal, and outputting the second local signal from the second output terminal, a first phase shifter shifting a phase of the first local signal output from the first output terminal of the second branch circuit by exactly a predetermined amount and outputting the result, a second phase shifter for shifting a phase of the second local signal output from the second output terminal of the second branch circuit by exactly a predetermined amount and outputting the result, a first coupler circuit for coupling the second reception signal output from the second output terminal of the first branch circuit and the first local signal shifted in phase by exactly a predetermined amount output from the first phase shifter and outputting the result, a second coupler circuit for coupling the third reception signal output from the third output terminal of the first branch circuit and the second local signal shifted in phase by exactly a predetermined amount output from the second phase shifter and outputting the result, a first signal level detection circuit for detecting the level of the signal output from the first output terminal of the first branch circuit, a second signal level detection circuit for detecting the level of the signal output from the first coupler circuit, a third signal level detection circuit for detecting the level of the signal output from the second coupler circuit, and a conversion circuit for converting the output signal of the first signal level detection circuit, the output signal of the second signal level detection circuit, and the output signal of the third signal level detection circuit to a plurality of signal components included in the reception signal; a gain control circuit for adjusting the level of the reception signal to a desired level and supplying the result to the first signal input terminal of the demodulator; and a local signal generation circuit for generating the local signal with a desired oscillation frequency and supplying the result to the second signal input terminal of the demodulator.

In the receiver according to the eighth aspect of the present invention, provision is further made of a mean signal power computation circuit receiving the output signal of the first signal level detection circuit of the demodulator and computing a mean signal power and a gain control signal generation circuit for outputting the control signal to the variable gain circuit so that the reception signal levels input to the demodulator become constant based on the mean power found at the mean signal power computation circuit, and the variable gain circuit adjusts the input reception signal to the level in accordance with the control signal by the gain control signal generation circuit and supplies the result to the first signal input terminal of the demodulator.

Further, the mean signal power computation circuit obtains the mean signal power by computation based on the following signal:

$$\overline{d^2} = \overline{h_{d1}P_1}$$

Note, $d^2$ is the reception signal power, and hdk and k = 0, 1, 2, 3 are the circuit parameter constants found from the circuit elements of the demodulator.

Further, preferably, provision is further made of a frequency error detection circuit for detecting a frequency error based on a plurality of signal components obtained at the conversion circuit of the demodulator and supplying the result to the local signal generation circuit, and the local signal generation circuit sets an oscillation frequency of the local signal so as to become a frequency substantially equal to a carrier frequency of the reception signal based on the frequency error value detected at the frequency error detection circuit.

Further, preferably, the conversion circuit of the demodulator includes a first channel selecting means for selecting a desired channel from the output signal of the first signal level detection circuit, a second channel selecting means for selecting a desired channel from the output signal of the second signal level detection circuit, a third channel selecting means for selecting a desired channel from the output signal of the third signal level detection circuit, and a computation circuit for demodulating the In-phase component signal I and the quadrature component signal Q based on the output signal of the first channel selecting means, the output signal of the second channel selecting means, the output signal of the third channel selecting means, and the predetermined circuit parameter constants.

Then, the computation circuit obtains the In-phase component signal I and the quadrature component signal Q by computation based on the following equations:

$$I(t) = h_{i0}+h_{i1}P_1+h_{i2}P_2+h_{i3}P_3$$

$$Q(t) = h_{q0}+h_{q1}P_1+h_{q2}P_2+h_{q3}P_3$$

Note, $P_1$ is the output signal of the first channel selecting means, $P_2$ is the output signal of the second channel selecting means, $P_3$ is the output signal of the third channel selecting means, and hik, hqk, k = 0, 1, 2, 3 are circuit parameter constants found from the circuit elements of the present demodulator.

Further, preferably, provision is further made of a frequency error detection circuit for detecting a frequency error based on the In-phase component signal I and the quadrature component signal Q obtained at the conversion circuit of the demodulator and supplying the result to the local signal generation circuit, and the local signal generation circuit sets an oscillation frequency of the local signal so as to become a frequency substantially equal to the carrier frequency of the reception signal based on the frequency error value detected at the frequency error detection circuit.

Further, preferably, at least one of the first channel selecting means, second channel selecting means, and third channel selecting means includes a low pass filter.

A receiver according to a ninth aspect of the present invention comprises a demodulator having a first signal input terminal receiving as input a reception signal, a second signal input terminal receiving as input a local signal, a first branch circuit having an input terminal, a first output terminal, a second output terminal, and a third output terminal, the input terminal being connected to the first signal input terminal, branching the reception signal input to the input terminal to first, second, and third reception signals, outputting the first reception signal from the first output terminal, outputting the second reception signal from the second output terminal, and outputting the third reception signal from the third output terminal, a second branch circuit having an input terminal, a first output terminal, and a second output terminal, the input terminal being connected to the second signal input terminal, branching the local signal input to the input terminal to first and second local signals, outputting the first local signal from the first output terminal, and outputting the second local signal from the second output terminal, a first phase shifter for shifting a phase of the first local signal output from the first output terminal of the second branch circuit by exactly a predetermined amount and outputting the result, a second phase shifter for shifting a phase of the second local signal output from the second output terminal of the second branch circuit by exactly a predetermined amount and outputting the result, a first coupler circuit for coupling the second reception signal output from the second output terminal of the first branch circuit and the first local signal shifted in phase by exactly a predetermined amount output from the first phase shifter and outputting the result, a second coupler circuit for coupling the third reception signal output from the third output terminal of the first branch circuit and the second local signal shifted in phase by exactly a predetermined amount output from the second phase shifter and outputting the result, a first signal level detection circuit for detecting the level of the signal output from the first output terminal of the first branch circuit, a second signal level detection circuit for detecting the level of the signal output from the first coupler circuit, a third signal level detection circuit for detecting the level of the signal output from the second coupler circuit, a first analog/digital converter for converting the output signal of the first signal level detection circuit from an analog signal to a digital signal, a second analog/digital converter for converting the output signal of the second signal level detection circuit from an analog signal to a digital signal, a third analog/digital converter for converting the output signal of the third signal level detection circuit from an analog signal to a digital signal, and a conversion circuit for converting the output digital signal of the first analog/digital converter, the output digital signal of the second analog/digital converter, and the output digital signal of the third analog/digital converter to a plurality of signal components included in the reception signal; a gain control circuit for adjusting the level of the reception signal to a desired level and supplying the result to the first signal input terminal of the demodulator; and a local signal generation circuit for generating the local signal with a desired oscillation frequency and supplying the result to the second signal input terminal of the demodulator.

Further, in the receiver according to the ninth aspect of the present invention, provision is further made of a mean signal power computation circuit receiving the output signal of the first signal level detection circuit of the demodulator and computing a mean signal power and a gain control signal generation circuit for outputting the control signal to the variable gain circuit so that the reception signal levels input to the demodulator become constant based on the mean power found at the mean signal power computation circuit, and the variable gain circuit adjusts the input reception signal to the level in accordance with the control signal by the gain control signal generation circuit and supplies the result to the first signal input terminal of the demodulator.

Further, the mean signal power computation circuit obtains the mean signal power by computation based on the following signal:

$$\overline{d^2} = \overline{h_{d1}P_1}$$

Note, $d^2$ is the reception signal power, and hdk and k = 0, 1, 2, 3 are the circuit parameter constants found from the circuit elements of the demodulator.

Further, preferably, provision is further made of a frequency error detection circuit for detecting a frequency error based on a plurality of signal components obtained at the conversion circuit of the demodulator and supplying the result to the local signal generation circuit, and the local signal generation circuit sets an oscillation frequency of the local signal so as to become a frequency substantially equal to a carrier frequency of the reception signal based on the frequency error value detected at the frequency error detection circuit.

Further, in the receiver according to the ninth aspect of the present invention, the demodulator further has a first filter for removing a high frequency component of the output signal of the first signal level detection circuit and inputting the result to the first analog/digital converter; a second filter for removing the high frequency component of the output signal of the second signal level detection circuit and inputting the result to the second analog/digital converter; and a third filter for removing the high frequency component of the output signal of the third signal level detection circuit and inputting the result to the third analog/digital converter, wherein the conversion circuit includes a first channel selecting means for selecting a desired channel from the output signal of the first analog/digital converter, a second channel selecting means for selecting a desired channel from the output signal of the second analog/digital converter,

a third channel selecting means for selecting a desired channel from the output signal of the third analog/digital converter, and a computation circuit for demodulating the In-phase component signal I and the quadrature component signal Q based on the output signal of the first channel selecting means, the output signal of the second channel selecting means, the output signal of the third channel selecting means, and predetermined circuit parameter constants.

Further, in the receiver according to the ninth aspect of the present invention, provision is further made of a first channel selecting means for selecting a desired channel from the output signal of the first signal level detection circuit and inputting the result to the first analog/digital converter, a second channel selecting means for selecting a desired channel from the output signal of the second signal level detection circuit and inputting the result to the second analog/digital converter, and a third channel selecting means for selecting a desired channel from the output signal of the third signal level detection circuit and inputting the result to the third analog/digital converter, wherein the conversion circuit includes a computation circuit for demodulating the In-phase component signal I and the quadrature component signal Q based on the output digital signal of the first analog/digital converter, the output digital signal of the second analog/digital converter, the output digital signal of the third analog/digital converter, and the predetermined circuit parameter constants.

Further, the computation circuit obtains the In-phase component signal I and the quadrature component signal Q by computation based on the following equations:

$$I(t) = h_{i0} + h_{i1}P_1 + h_{i2}P_2 + h_{i3}P_3$$

$$Q(t) = h_{q0} + h_{q1}P_1 + h_{q2}P_2 + h_{q3}P_3$$

Note, $P_1$ is the output signal of the first channel selecting means, $P_2$ is the output signal of the second channel selecting means, $P_3$ is the output signal of the third channel selecting means, and hik, hqk, k = 0, 1, 2, 3 are circuit parameter constants found from the circuit elements of the present demodulator.

Further, preferably, provision is further made of a frequency error detection circuit for detecting the frequency error based on the In-phase component signal I and the quadrature component signal Q obtained at the conversion circuit of the demodulator and supplying the result to the local signal generation circuit, and the local signal generation circuit sets an oscillation frequency of the local signal so as to become a frequency substantially equal to the carrier frequency of the reception signal based on the frequency error value detected at the frequency error detection circuit.

Further, preferably, at least one of the first channel selecting means, second channel selecting means, and third channel selecting means includes a low pass filter.

A receiver according to a 10th aspect of the present invention comprises a demodulator having a first signal input terminal receiving as input a reception signal, a second signal input terminal receiving as input a local signal, a first branch circuit having an input terminal, a first output terminal, a second output terminal, and a third output terminal, the input terminal being connected to the first signal input terminal, branching the reception signal input to the input terminal to first, second, and third reception signals, outputting the first reception signal from the first output terminal, outputting the second reception signal from the second output terminal, and outputting the third reception signal from the third output terminal, a second branch circuit having an input terminal, a first output terminal, a second output terminal, and a third output terminal, the input terminal being connected to the second signal input terminal, branching the local signal input to the input terminal to first, second, and third local signals, outputting the first local signal from the first output terminal, outputting the second local signal from the second output terminal, and outputting the third local signal from the third output terminal, a first phase shifter for shifting a phase of the first local signal output from the first output terminal of the second branch circuit by exactly a predetermined amount and outputting the result, a second phase shifter for shifting a phase of the second local signal output from the second output terminal of the second branch circuit by exactly a predetermined amount and outputting the result, a first coupler circuit for coupling the second reception signal output from the second output terminal of the first branch circuit and the first local signal shifted in phase by exactly a predetermined amount output from the first phase shifter and outputting the result, a second coupler circuit for coupling the third reception signal output from the third output terminal of the first branch circuit and the second local signal shifted in phase by exactly a predetermined amount output from the second phase shifter and outputting the result, a third coupler circuit for coupling the first reception signal output from the first output terminal of the first branch circuit and the third local signal output from the third output terminal of the second branch circuit and outputting the result, a first signal level detection circuit for detecting the level of the signal output from the third coupler circuit, a second signal level detection circuit for detecting the level of the signal output from the first coupler circuit, a third signal level detection circuit for detecting the level of the signal output from the second coupler circuit, and a conversion circuit for converting the output signal of the first signal level detection circuit, the output signal of the second signal level detection circuit, and the output signal of the third signal level detection circuit to a plurality of signal components included in the reception signal; a gain control circuit for adjusting the level of the reception signal to a desired level and supplying the result to the first signal input terminal of the demodulator; and a local signal generation circuit for generating the local signal with a desired oscillation frequency and supplying the result to the second signal input terminal of the demodulator.

In the receiver according to the 10th aspect of the present invention, provision is further made of a mean signal power computation circuit receiving the output signal of the first signal level detection circuit of the demodulator and computing a mean signal power and a gain control signal generation circuit for outputting the control signal to the variable gain circuit so that the reception signal levels input to the demodulator become constant based on the mean power found at the mean signal power computation circuit, and the variable gain circuit adjusts the input reception signal to the level in accordance with the control signal by the gain control signal generation circuit and supplies the result to the first signal input terminal of the demodulator.

Then, the mean signal power computation circuit obtains the mean signal power by computation based on the following signal:

$$\overline{d^2} = \overline{h_{d1}P_1}$$

Note, $d^2$ is the reception signal power, and hdk and k = 0, 1, 2, 3 are the circuit parameter constants found from the circuit elements of the demodulator.

Further, preferably, provision is further made of a frequency error detection circuit for detecting a frequency error based on a plurality of signal components obtained at the conversion circuit of the demodulator and supplying the result to the local signal generation circuit, and the local signal generation circuit sets an oscillation frequency of the local signal so as to become a frequency substantially equal to a carrier frequency of the reception signal based on the frequency error value detected at the frequency error detection circuit.

Further, in the receiver according to the 10th aspect of the present invention, the conversion circuit of the demodulator includes a first channel selecting means for selecting a desired channel from the output signal of the first signal level detection circuit, a second channel selecting means for selecting a desired channel from the output signal of the second signal level detection circuit, a third channel selecting means for selecting a desired channel from the output signal of the third signal level detection circuit, and a computation circuit for demodulating the In-phase component signal I and the quadrature component signal Q based on the output signal of the first channel selecting means, the output signal of the second channel selecting means, the output signal of the third channel selecting means, and predetermined circuit parameter constants.

Further, the computation circuit obtains the In-phase component signal I and the quadrature component signal Q by computation based on the following equations:

$$I(t) = h_{i0} + h_{i1}P_1 + h_{i2}P_2 + h_{i3}P_3$$

$$Q(t) = h_{q0} + h_{q1}P_1 + h_{q2}P_2 + h_{q3}P_3$$

Note, $P_1$ is the output signal of the first channel selecting means, $P_2$ is the output signal of the second channel selecting means, $P_3$ is the output signal of the third channel selecting means, and hik, hqk, k = 0, 1, 2, 3 are circuit parameter constants found from the circuit elements of the present demodulator.

Further, preferably, provision is further made of a frequency error detection circuit for detecting the frequency error based on the In-phase component signal I and the quadrature component signal Q obtained at the conversion circuit of the demodulator and supplying the result to the local signal generation circuit, and the local signal generation circuit sets an oscillation frequency of the local signal so as to become a frequency substantially equal to the carrier frequency of the reception signal based on the frequency error value detected at the frequency error detection circuit.

Further, preferably, at least one of the first channel selecting means, second channel selecting means, and third channel selecting means includes a low pass filter.

A receiver according to an 11th aspect of the present invention comprises a demodulator having a first signal input terminal receiving as input a reception signal, a second signal input terminal receiving as input a local signal, a first branch circuit having an input terminal, a first output terminal, and a second output terminal, the input terminal being connected to the first signal input terminal, branching the reception signal input to the input terminal to first and second reception signals, outputting the first reception signal from the first output terminal, and outputting the second reception signal from the second output terminal, a second branch circuit having an input terminal, a first output terminal, and a second output terminal, the input terminal being connected to the first output terminal of the first branch circuit, branching the reception signal input to the input terminal to third and fourth reception signals, outputting the third reception signal from the first output terminal, and outputting the fourth reception signal from the second output terminal, a third branch circuit having an input terminal, a first output terminal, and a second output terminal, the input terminal being connected to the second signal input terminal, branching the local signal input to the input terminal to first and second local signals, outputting the first local signal from the first output terminal, and outputting the second local signal from the second output terminal, a first phase shifter for shifting a phase of the first local signal output from the first output terminal of the third branch circuit by exactly a predetermined amount and outputting the result, a second phase shifter for shifting a phase of the second local signal output from the second output terminal of the third branch circuit by exactly a predetermined amount and outputting the result, a first coupler circuit for coupling the third reception signal output from the first output terminal of the second branch circuit and the first local signal shifted in phase by exactly a predetermined amount output from the first phase shifter and outputting the result, a second coupler circuit for coupling the fourth reception signal output from the second output terminal of the second branch circuit and the second local signal shifted in phase by exactly a predetermined amount output from the second phase shifter and outputting the result, a first signal level detection circuit for detecting the level of the signal output from the first coupler circuit, a second signal level detection circuit for detecting the level of the signal output from the second coupler circuit, a third signal level detection circuit for detecting the level of the signal output from the second output terminal of the first branch circuit, and a conversion circuit for converting the output signal of the first signal level detection circuit, the output signal of the second signal level detection circuit, and the output signal of the third signal level detection circuit to a plurality of signal components included in the reception signal; a gain control circuit for adjusting the level of the reception signal to a desired level and supplying the result to the first signal input terminal of the demodulator; and a local signal generation circuit for generating the local signal with a desired oscillation frequency and supplying the result to the second signal input terminal of the demodulator.

In the receiver according to the 11th aspect of the present invention, provision is further made of a mean signal power computation circuit receiving the output signal of the first signal level detection circuit of the demodulator and computing a mean signal power and a gain control signal generation circuit for outputting the control signal to the variable gain circuit so that the reception signal levels input to the demodulator become constant based on the mean power found at the mean signal power computation circuit, and the variable gain circuit adjusts the input reception signal to the level in accordance with the control signal by the gain control signal generation circuit and supplies the result to the first signal input terminal of the demodulator.

Further, the mean signal power computation circuit obtains the mean signal power by computation based on the following signal:

$$\overline{d^2} = \overline{h_{d1}P_1}$$

Note, $d^2$ is the reception signal power, and hdk and k = 0, 1, 2, 3 are the circuit parameter constants found from the circuit elements of the demodulator.

Further, preferably, provision is further made of a frequency error detection circuit for detecting a frequency error based on a plurality of signal components obtained at the conversion circuit of the demodulator and supplying the result to the local signal generation circuit, and the local signal generation circuit sets an oscillation frequency of the local signal so as to become a frequency substantially equal to a carrier frequency of the reception signal based on the frequency error value detected at the frequency error detection circuit.

Further, preferably, the conversion circuit of the demodulator includes a first channel selecting means for selecting a desired channel from the output signal of the first signal level detection circuit, a second channel selecting means for selecting a desired channel from the output signal of the second signal level detection circuit, a third channel selecting means for selecting a desired channel from the output signal of the third signal level detection circuit, and a computation circuit for demodulating the In-phase component signal I and the quadrature component signal Q based on the output signal of the first channel selecting means, the output signal of the second channel selecting means, the output signal of the third channel selecting means, and predetermined circuit parameter constants.

Then, the computation circuit obtains the In-phase component signal I and the quadrature component signal Q by computation based on the following equations:

$$I(t) = h_{i0} + h_{i1}P_1 + h_{i2}P_2 + h_{i3}P_3$$

$$Q(t) = h_{q0} + h_{q1}P_1 + h_{q2}P_2 + h_{q3}P_3$$

Note, $P_1$ is the output signal of the first channel selecting means, $P_2$ is the output signal of the second channel selecting means, $P_3$ is the output signal of the third channel selecting means, and hik, hqk, k = 0, 1, 2, 3 are circuit parameter constants found from the circuit elements of the present demodulator.

Further, in the receiver according to the 11th aspect of the present invention, provision is further made of a frequency error detection circuit for detecting the frequency error based on the In-phase component signal I and the quadrature component signal Q obtained at the conversion circuit of the demodulator and supplying the result to the local signal generation circuit, and the local signal generation circuit sets an oscillation frequency of the local signal so as to become a frequency substantially equal to the carrier frequency of the reception signal based on the frequency error value detected at the frequency error detection circuit.

Further, preferably, at least one of the first channel selecting means, second channel selecting means, and third channel selecting means includes a low pass filter.

Further, in the receiver according to the 11th aspect of the present invention, an amplifier for amplifying the output signal from the first output terminal is connected to at least the first output terminal between the first output terminal and the second output terminal of the first branch circuit.

A receiver according to a 12th aspect of the present invention comprises a demodulator having a first signal input terminal receiving as input a reception signal, a second signal input terminal receiving as input a local signal, a first branch circuit having an input terminal, a first output terminal, a second output terminal, and a third output terminal, the input terminal being connected to the first signal input terminal, branching the reception signal input to the input terminal to first, second, and third reception signals, outputting the first reception signal from the first output terminal, outputting the second reception signal from the second output terminal, and outputting the third reception signal from the third output terminal, a second branch circuit having an input terminal, a first output terminal, and a second output terminal, the input terminal being connected to the second signal input terminal, branching the local signal input to the input terminal to first and second local signals, outputting the first local signal from the first output terminal, and outputting the second local signal from the second output terminal, a first phase shifter for shifting a phase of the first local signal output from the first output terminal of the second branch circuit by exactly a predetermined amount and outputting the result, a second phase shifter for shifting a phase of the third reception signal output from the third output terminal of the first branch circuit by exactly a predetermined amount and outputting the result, a first coupler circuit for coupling the second reception signal output from the second output terminal of the first branch circuit and the first local signal shifted in phase by exactly a predetermined amount output from the first phase shifter and outputting the result, a second coupler circuit for coupling the third reception signal shifted in phase by exactly a predetermined amount output from the second phase shifter and the second local signal output from the second branch circuit and outputting the result, a first signal level detection circuit for detecting the level of the signal output from the first output terminal of the first branch circuit, a second signal level detection circuit for detecting the level of the signal output from the first coupler circuit, and a third signal level detection circuit for detecting the level of the signal output from the second coupler circuit, and a conversion circuit for converting the output signal of the first signal level detection circuit, the output signal of the second signal level detection circuit, and the output signal of the third signal level detection circuit to a plurality of signal components included in the reception signal; a gain control circuit for adjusting the level of the reception signal to a desired level and supplying the result to the first signal input terminal of the demodulator; and a local signal generation circuit for generating the local signal with a desired oscillation frequency and supplying the result to the second signal input terminal of the demodulator.

In the receiver according to the 12th aspect of the present invention, provision is further made of a mean signal power computation circuit receiving the output signal of the first signal level detection circuit of the demodulator and computing a mean signal power, and a gain control signal generation circuit for outputting the control signal to the variable gain circuit so that the reception signal levels input to the demodulator become constant based on the mean power found at the mean signal power computation circuit, and the variable gain circuit adjusts the input reception signal to the level in accordance with the control signal by the gain control signal generation circuit and supplies the result to the first signal input terminal of the demodulator.

Further, the mean signal power computation circuit obtains the mean signal power by computation based on the following signal:

$$\overline{d^2} = \overline{h_{d1} P_1}$$

Note, $d^2$ is the reception signal power, and hdk and k = 0, 1, 2, 3 are the circuit parameter constants found from the circuit elements of the demodulator.

Further, preferably, provision is further made of a frequency error detection circuit for detecting a frequency error based on a plurality of signal components obtained at the conversion circuit of the demodulator and supplying the result to the local signal generation circuit, and the local signal generation circuit sets an oscillation frequency of the local signal so as to become a frequency substantially equal to a carrier frequency of the reception signal based on the frequency error value detected at the frequency error detection circuit.

Further, preferably, the conversion circuit of the demodulator includes a first channel selecting means for selecting a desired channel from the output signal of the first signal level detection circuit, a second channel selecting means for selecting a desired channel from the output signal of the second signal level detection circuit, a third channel selecting means for selecting a desired channel from the output signal of the third signal level detection circuit, and a computation circuit for demodulating the In-phase component signal I and the quadrature component signal Q based on the output signal of the first channel selecting means, the output signal of the second channel selecting means, the output signal of the third channel selecting means, and predetermined circuit parameter constants.

Then, the computation circuit obtains the In-phase component signal I and the quadrature component signal Q by computation based on the following equations:

$$I(t) = h_{i0} + h_{i1}P_1 + h_{i2}P_2 + h_{i3}P_3$$

$$Q(t) = h_{q0} + h_{q1}P_1 + h_{q2}P_2 + h_{q3}P_3$$

Note, $P_1$ is the output signal of the first channel selecting means, $P_2$ is the output signal of the second channel selecting means, $P_3$ is the output signal of the third channel selecting means, and hik, hqk, k = 0, 1, 2, 3 are circuit parameter constants found from the circuit elements of the present demodulator.

Further, preferably, provision is further made of a frequency error detection circuit for detecting the frequency error based on the In-phase component signal I and the quadrature component signal Q obtained at the conversion circuit of the demodulator and supplying the result to the local signal generation circuit, and the local signal generation circuit sets an oscillation frequency of the local signal so as to become a frequency substantially equal to the carrier frequency of the reception signal based on the frequency error value detected at the frequency error detection circuit.

Further, preferably, at least one of the first channel selecting means, second channel selecting means, and third channel selecting means includes a low pass filter.

A receiver according to a 13th aspect of the present invention comprises a demodulator having a first signal input terminal receiving as input a reception signal, a second signal input terminal receiving as input a local signal, a first branch circuit having an input terminal, a first output terminal, and a second output terminal, the input terminal being connected to the first signal input terminal, branching the reception signal input to the input terminal to first and second reception signals, outputting the first reception signal from the first output terminal, and outputting the second reception signal from the second output terminal, a second branch circuit having an input terminal, a first output terminal, and a second output terminal, the input terminal being connected to the first output terminal of the first branch circuit, branching the reception signal input to the input terminal to third and fourth reception signals, outputting the third reception signal from the first output terminal, and outputting the fourth reception signal from the second output terminal, a third branch circuit having an input terminal, a first output terminal, and a second output terminal, the input terminal being connected to the second signal input terminal, branching the local signal input to the input terminal to first and second local signals, outputting the first local signal from the first output terminal, and outputting the second local signal from the second output terminal, a fourth branch circuit having an input terminal, a first output terminal, and a second output terminal, the input terminal being connected to the first output terminal of the third branch circuit, branching the local signal input to the input terminal to third and fourth local signals, outputting the third local signal from the first output terminal, and outputting the fourth local signal from the second output terminal, a first phase shifter for shifting a phase of the third local signal output from the first output terminal of the fourth branch circuit by exactly a predetermined amount and outputting the result, a second phase shifter for shifting a phase of the fourth local signal output from the second output terminal of the fourth branch circuit by exactly a predetermined amount and outputting the result, a first coupler circuit for coupling the third reception signal output from the first output terminal of the second branch circuit and the third local signal shifted in phase by exactly a predetermined amount output from the first phase shifter and outputting the result, a second coupler circuit for coupling the fourth reception signal output from the second output terminal of the second branch circuit and the fourth local signal shifted in phase by exactly a predetermined amount output from the second phase shifter and outputting the result, a first signal level detection circuit for detecting the level of the signal output from the first coupler circuit, a second signal level detection circuit for detecting the level of the signal output from the second coupler circuit, a third signal level detection circuit for detecting the level of the signal output from the second output terminal of the first branch circuit, a fourth signal level detection circuit for detecting the level of the signal output from the second output terminal of the third branch circuit, and a conversion circuit for converting the output signal of the first signal level detection circuit, the output signal of the second signal level detection circuit, the output signal of the third signal level detection circuit, and the output signal of the fourth signal level detection circuit to a plurality of signal components included in the reception signal; a gain control circuit for adjusting the level of the reception signal to a desired level and supplying the result to the first signal input terminal of the demodulator; and a local signal generation circuit for generating the local signal with a desired oscillation frequency and supplying the result to the second signal input terminal of the demodulator.

In the receiver according to the 13th aspect of the present invention, provision is further made of a mean signal power computation circuit receiving the output signal of the first signal level detection circuit of the demodulator and computing a mean signal power and a gain control signal generation circuit for outputting the control signal to the variable gain circuit so that the reception signal levels input to the demodulator become constant based on the mean power found at the mean signal power computation circuit, and the variable gain circuit adjusts the input reception signal to the level in accordance with the control signal by the gain control signal generation circuit and supplies the result to the first signal input terminal of the demodulator.

Further, the mean signal power computation circuit obtains the mean signal power by computation based on the following signal:

$$\overline{d^2} = \overline{h_{d1}P_1}$$

Note, $d^2$ is the reception signal power, and hdk and k = 0, 1, 2, 3 are the circuit parameter constants found from the circuit elements of the demodulator.

Further, preferably, provision is further made of a frequency error detection circuit for detecting a frequency error based on a plurality of signal components obtained at the conversion circuit of the demodulator and supplying the result to the local signal generation circuit, and the local signal generation circuit sets an oscillation frequency of the local signal so as to become a frequency substantially equal to a carrier frequency of the reception signal based on the frequency error value detected at the frequency error detection circuit.

Then, the conversion circuit obtains the In-phase component signal I and the quadrature component signal Q by computation based on the following equations:

$$I(t) = h_{i0} + h_{i1}P_1/P_4 + h_{i2}P_1/P_4 + h_{i3}P_1/P_4$$

$$Q(t) = h_{q0} + h_{q1}P_1/P_4 + h_{q2}P_1/P_4 + h_{q3}P_1/P_4$$

Note, $P_1$ is the output signal of the first signal level detection circuit, and $P_4$ is the output signal of the fourth signal level detection circuit, and hik, hqk, k = 0, 1, 2, 3 are circuit parameter constants found from the circuit elements of the present demodulator.

A receiver according to a 14th aspect of the present invention comprises a demodulator having a first signal input terminal receiving as input a reception signal, a second signal input terminal receiving as input a local signal, a branch circuit having an input terminal, a first output terminal, and a second output terminal, the input terminal being connected to the first signal input terminal, branching the reception signal input to the input terminal to first and second reception signals, outputting the first reception signal from the first output terminal, and outputting the second reception signal from the second output terminal, a first phase divider having an input terminal, a first output terminal, and a second output terminal, the input terminal being connected to the first output terminal of the branch circuit, branching the reception signal input to the input terminal to third and fourth reception signals having inverse phases to each other, outputting the third reception signal from the first output terminal, and outputting the fourth reception signal from the second output terminal, a second phase divider having an input terminal, a first output terminal, and a second output terminal, the input terminal being connected to the second signal input terminal, branching the local signal input to the input terminal to first and second local signals having inverse phases to each other, outputting the first local signal from the first output terminal, and outputting the second local signal from the second output terminal, a first phase shifter for shifting a phase of the first local signal output from the first output terminal of the second phase divider by exactly a predetermined amount and outputting the result, a second phase shifter for shifting a phase of the second local signal output from the second output terminal of the second phase divider by exactly a predetermined amount and outputting the result, a first coupler circuit for coupling the third reception signal output from the first output terminal of the first phase divider and the first local signal shifted in phase by exactly a predetermined amount output from the first phase shifter and outputting the result, a second coupler circuit for coupling the fourth reception signal output from the second output terminal of the first phase divider and the second local signal shifted in phase by exactly a predetermined amount output from the second phase shifter and outputting the result, a first signal level detection circuit for detecting the level of the signal output from the first coupler circuit, a second signal level detection circuit for detecting the level of the signal output from the second coupler circuit, a third signal level detection circuit for detecting the level of the signal output from the second output terminal of the branch circuit, and a conversion circuit for converting the output signal of the first signal level detection circuit, the output signal of the second signal level detection circuit, and the output signal of the third signal level detection circuit to a plurality of signal components included in the reception signal; a gain control circuit for adjusting the level of the reception signal to a desired level and supplying the result to the first signal input terminal of the demodulator; and a local signal generation circuit for generating the local signal with a desired oscillation frequency and supplying the result to the second signal input terminal of the demodulator.

In the receiver according to the 14th aspect of the present invention, provision is further made of a mean signal power computation circuit receiving the output signal of the first signal level detection circuit of the demodulator and computiny a mean signal power and a gain control signal generation circuit for outputting the control signal to the variable gain circuit so that the reception signal levels input to the demodulator become constant based on the mean power found at the mean signal power computation circuit, and the variable gain circuit adjusts the input reception signal to the level in accordance with the control signal by the gain control signal generation circuit and supplies the result to the first signal input terminal of the demodulator.

Further, the mean signal power computation circuit obtains the mean signal power by computation based on the following signal:

$$\overline{d^2} = \overline{h_{d1}P_1}$$

Note, $d^2$ is the reception signal power, and hdk and k = 0, 1, 2, 3 are the circuit parameter constants found from the circuit elements of the demodulator.

Further, preferably, provision is further made of a frequency error detection circuit for detecting a frequency error based on a plurality of signal components obtained at the conversion circuit of the demodulator and supplying the result to the local signal generation circuit, and the local signal generation circuit sets an oscillation frequency of the local signal so as to become a frequency substantially equal to a carrier frequency of the reception signal based on the frequency error value detected at the frequency error detection circuit.

Further, preferably, the conversion circuit of the demodulator includes a first channel selecting means for selecting a desired channel from the output signal of the first signal level detection circuit, a second channel selecting means for selecting a desired channel from the output signal of the second signal level detection circuit, a third channel selecting means for selecting a desired channel from the output signal of the third signal level detection circuit, and a computation circuit for demodulating the In-phase component signal I and the quadrature component signal Q based on the output signal of the first channel selecting means, the output signal of the second channel selecting means, the output signal of the third channel selecting means, and predetermined circuit parameter constants.

Then, the computation circuit obtains the In-phase component signal I and the quadrature component signal Q by computation based on the following equations:

$$I(t) = h_{i0}+h_{i1}P_1+h_{i2}P_2+h_{i3}P_3$$

$$Q(t) = h_{q0}+h_{q1}P_1+h_{q2}P_2+h_{q3}P_3$$

Note, $P_1$ is the output signal of the first channel selecting means, $P_2$ is the output signal of the second channel selecting means, $P_3$ is the output signal of the third channel selecting means, and hik, hqk, k = 0, 1, 2, 3 are circuit parameter constants found from the circuit elements of the present demodulator.

Further, preferably, provision is further made of a frequency error detection circuit for detecting the frequency error based on the In-phase component signal I and the quadrature component signal Q obtained at the conversion circuit of the demodulator and supplying the result to the local signal generation circuit, the local signal generation circuit sets an oscillation frequency of the local signal so as to become a frequency substantially equal to the carrier frequency of the reception signal based on the frequency error value detected at the frequency error detection circuit.

Preferably, at least one of the first channel selecting means, second channel selecting means, and third channel selecting means includes a low pass filter.

Further, in the demodulators according to the first to seventh aspects and the receivers according to the eighth to 14th aspects, at least one of the first signal level detection circuit, second signal level detection circuit, and third signal level detection circuit of the demodulator has a first field effect transistor having a gate supplied with the input signal, a second field effect transistor having a source connected to a source of the first field effect transistor, a first gate bias supply circuit for supplying a gate bias voltage to the gate of the first field effect transistor, a second gate bias supply circuit for supplying a gate bias voltage to a gate of the second field effect transistor, a current source connected to a connection point of sources of the first field effect transistor and second field effect transistor, a drain bias supply circuit for supplying a drain bias voltage to drains of the first field effect transistor and second field effect transistor, a first capacitor connected between the drain of the first field effect transistor and a reference potential, and a second capacitor connected between the drain of the second field effect transistor and a reference potential, and a voltage difference between the drain voltage of the first field effect transistor and the drain voltage of the second field effect transistor is defined as a detected output.

Preferably, the first field effect transistor and second field effect transistor have substantially same characteristics, the drain bias supply circuit includes a first drain bias use resistance element connected between the drain of the first field effect transistor and a voltage source and a second drain bias use resistance element connected between the drain of the second field effect transistor and a voltage source, a resistance value of the first drain bias use resistance element and a resistance value of the second drain bias use resistance element being set at substantially equal values, and a capacitance value of the first capacitor and a capacitance value of the second capacitor being set at substantially equal values.

Further, preferably, a ratio Wga/Wgb of a gate width Wga of the first field effect transistor and a gate width Wgb of the second field effect transistor is set at N, the drain bias supply circuit includes a first drain bias use resistance element connected between the drain of the first field effect transistor and a voltage source, and a second drain bias use resistance element connected between the drain of the second field effect transistor and a voltage source, a resistance value Ra of the first drain bias use resistance element and a resistance value Rb of the second drain bias use resistance element being set so as to satisfy a condition of Ra/Rb = 1/N, and a capacitance value of the first capacitor and a capacitance value of the second capacitor being set at substantially equal values.

A receiver according to a 15th aspect of the present invention comprises a phased array antenna portion including a plurality of antenna elements for receiving radio signals, a plurality of variable phase circuits for controlling phases of signals received at the antenna elements to desired phases, a signal combining circuit for combining output signals of the plurality of variable phase circuits; a demodulator having a first signal input terminal to which a combined reception signal from the signal combining circuit of the phased array antenna portion is input, a second signal input terminal to which the local signal is input, a first branch circuit having an input terminal, a first output terminal, a second output terminal, and a third output terminal, the input terminal being connected to the first signal input terminal, branching the reception signal input to the input terminal to first, second, and third reception signals, outputting the first reception signal from the first output terminal, outputting the second reception signal from the second output terminal, and outputting the third reception signal from the third output terminal, a second branch circuit having an input terminal, a first output terminal, and a second output terminal, the input terminal being connected to the second signal input terminal, branching the local signal input to the input terminal to first and second local signals, outputting the first local signal from the first output terminal, and outputting the second local signal from the second output terminal, a first phase shifter for shifting a phase of the first local signal output from the first output terminal of the second branch circuit by exactly a predetermined amount and outputting the result, a second phase shifter for shifting a phase of the second local signal output from the second output terminal of the second branch circuit by exactly a predetermined amount and outputting the result, a first coupler circuit for coupling the second reception signal output from the second output terminal of the first branch circuit and the first local signal shifted in phase by exactly a predetermined amount output from the first phase shifter and outputting the result, a second coupler circuit for coupling the third reception signal output from the third output terminal of the first branch circuit and the second local signal shifted in phase by exactly a predetermined amount output from the second phase shifter and outputting the result, a first signal level detection circuit for detecting the level of the signal output from the first output terminal of the first branch circuit, a second signal level detection circuit for detecting the level of the signal output from the first coupler circuit, a third signal level detection circuit for detecting the level of the signal output from the second coupler circuit, and a conversion circuit for converting the output signal of the first signal level detection circuit, the output signal of the second signal level detection circuit, and the output signal of the third signal level detection circuit to a plurality of signal components included in the reception signal; a gain control circuit for adjusting the level of the reception signal to a desired level and supplying the result to the first signal input terminal of the demodulator; and a local signal generation circuit for generating the local signal with a desired oscillation frequency and supplying the result to the second signal input terminal of the demodulator.

A receiver according to a 16th aspect of the present invention comprises a phased array antenna portion including a plurality of antenna elements for receiving radio signals, a plurality of variable phase circuits for controlling phases of signals received at the antenna elements to desired phases, a signal combining circuit for combining output signals of the plurality of variable phase circuits; a demodulator having a first signal input terminal to which a combined reception signal from the signal combining circuit of the phased array antenna portion is input, a second signal input terminal to which the local signal is input, a first branch circuit having an input terminal, a first output terminal, a second output terminal, and a third output terminal, the input terminal being connected to the first signal input terminal, branching the reception signal input to the input terminal to first, second, and third reception signals, outputting the first reception signal from the first output terminal, outputting the second reception signal from the second output terminal, and outputting the third reception signal from the third output terminal, a second branch circuit having an input terminal, a first output terminal, and a second output terminal, the input terminal being connected to the second signal input terminal, branching the local signal input to the input terminal to first and second local signals, outputting the first local signal from the first output terminal, and outputting the second local signal from the second output terminal, a first phase shifter for shifting a phase of the first local signal output from the first output terminal of the second branch circuit by exactly a predetermined amount and outputting the result, a second phase shifter for shifting a phase of the second local signal output from the second output terminal of the second branch circuit by exactly a predetermined amount and outputting the result, a first coupler circuit for coupling the second reception signal output from the second output terminal of the first branch circuit and the first local signal shifted in phase by exactly a predetermined amount output from the first phase shifter and outputting the result, a second coupler circuit for coupling the third reception signal output from the third output terminal of the first branch circuit and the second local signal shifted in phase by exactly a predetermined amount output from the second phase shifter and outputting the result, a first signal level detection circuit for detecting the level of the signal output from the first output terminal of the first branch circuit, a second signal level detection circuit for detecting the level of the signal output from the first coupler circuit, a third signal level detection circuit for detecting the level of the signal output from the second coupler circuit, a first analog/digital converter for converting the output signal of the first signal level detection circuit from an analog signal to a digital signal, a second analog/digital converter for converting the output signal of the second signal level detection circuit from an analog signal to a digital signal, a third analog/digital converter for converting the output signal of the third signal level detection circuit from an analog signal to a digital signal, and a conversion circuit for converting the output digital signal of the first analog/digital converter, the output digital signal of the second analog/digital converter, and the output digital signal of the third analog/digital converter to a plurality of signal components included in the reception signal; a gain control circuit for adjusting the level of the reception signal to a desired level and supplying the result to the first signal input terminal of the demodulator; and a local signal generation circuit for generating the local signal with a desired oscillation frequency and supplying the result to the second signal input terminal of the demodulator.

A receiver according to a 17th aspect of the present invention comprises a phased array antenna portion including a plurality of antenna elements for receiving radio signals, a plurality of variable phase circuits for controlling phases of signals received at the antenna elements to desired phases, a signal combining circuit for combining output signals of the plurality of variable phase circuits; a demodulator having a first signal input terminal to which a combined reception signal of the signal combining circuit of the phased array antenna portion is input, a second signal input terminal to which the local signal is input, a first branch circuit having an input terminal, a first output terminal, a second output terminal, and a third output terminal, the input terminal being connected to the first signal input terminal, branching the reception signal input to the input terminal to first, second, and third reception signals, outputting the first reception signal from the first output terminal, outputting the second reception signal from the second output terminal, and outputting the third reception signal from the third output terminal, a second branch circuit having an input terminal, a first output terminal, a second output terminal, and a third output terminal, the input terminal being connected to the second signal input terminal, branching the local signal input to the input terminal to first, second, and third local signals, outputting the first local signal from the first output terminal, outputting the second local signal from the second output terminal, and outputting the third local signal from the third output terminal, a first phase shifter for shifting a phase of the first local signal output from the first output terminal of the second branch circuit by exactly a predetermined amount and outputting the result, a second phase shifter for shifting a phase of the second local signal output from the second output terminal of the second branch circuit by exactly a predetermined amount and outputting the result, a first coupler circuit for coupling the second reception signal output from the second output terminal of the first branch circuit and the first local signal shifted in phase by exactly a predetermined amount output from the first phase shifter and outputting the result, a second coupler circuit for coupling the third reception signal output from the third output terminal of the first branch circuit and the second local signal shifted in phase by exactly a predetermined amount output from the second phase shifter and outputting the result, a third coupler circuit for coupling the first reception signal output from the first output terminal of the first branch circuit and the third local signal output from the third output terminal of the second branch circuit and outputting the result, a first signal level detection circuit for detecting the level of the signal output from the third coupler circuit, a second signal level detection circuit for detecting the level of the signal output from the first coupler circuit, and a third signal level detection circuit for detecting the level of the signal output from the second coupler circuit, and a conversion circuit for converting the output signal of the first signal level detection circuit, the output signal of the second signal level detection circuit, and the output signal of the third signal level detection circuit to a plurality of signal components included in the reception signal; a gain control circuit for adjusting the level of the reception signal to a desired level and supplying the result to the first signal input terminal of the demodulator; and a local signal generation circuit for generating the local signal with a desired oscillation frequency and supplying the result to the second signal input terminal of the demodulator.

A receiver according to an 18th aspect of the present invention comprises a phased array antenna portion including a plurality of antenna elements for receiving radio signals, a plurality of variable phase circuits for controlling phases of signals received at the antenna elements to desired phases, a signal combining circuit for combining output signals of the plurality of variable phase circuits; a demodulator having a first signal input terminal to which a combined reception signal of the signal combining circuit of the phased array antenna portion is input, a second signal input terminal to which the local signal is input, a first branch circuit having an input terminal, a first output terminal, and a second output terminal, the input terminal being connected to the first signal input terminal, branching the reception signal input to the input terminal to first and second reception signals, outputting the first reception signal from the first output terminal, and outputting the second reception signal from the second output terminal, a second branch circuit having an input terminal, a first output terminal, and a second output terminal, the input terminal being connected to the first output terminal of the first branch circuit, branching the reception signal input to the input terminal to third and fourth reception signals, outputting the third reception signal from the first output terminal, and outputting the fourth reception signal from the second output terminal, a third branch circuit having an input terminal, a first output terminal, and a second output terminal, the input terminal being connected to the second signal input terminal, branching the local signal input to the input terminal to first and second local signals, outputting the first local signal from the first output terminal, and outputting the second local signal from the second output terminal, a first phase shifter for shifting a phase of the first local signal output from the first output terminal of the third branch circuit by exactly a predetermined amount and outputting the result, a second phase shifter for shifting a phase of the second local signal output from the second output terminal of the third branch circuit by exactly a predetermined amount and outputting the result, a first coupler circuit for coupling the third reception signal output from the first output terminal of the second branch circuit and the first local signal shifted in phase by exactly a predetermined amount output from the first phase shifter and outputting the result, a second coupler circuit for coupling the fourth reception signal output from the second output terminal of the second branch circuit and the second local signal shifted in phase by exactly a predetermined amount output from the second phase shifter and outputting the result, a first signal level detection circuit for detecting the level of the signal output from the first coupler circuit, a second signal level detection circuit for detecting the level of the signal output from the second coupler circuit, a third signal level detection circuit for detecting the level of the signal output from the second output terminal of the first branch circuit, and a conversion circuit for converting the output signal of the first signal level detection circuit, the output signal of the second signal level detection circuit, and the output signal of the third signal level detection circuit to a plurality of signal components included in the reception signal; a gain control circuit for adjusting the level of the reception signal to a desired level and supplying the result to the first signal input terminal of the demodulator; and a local signal generation circuit for generating the local signal with a desired oscillation frequency and supplying the result to the second signal input terminal of the demodulator.

A receiver according to a 19th aspect of the present invention comprises a phased array antenna portion including a plurality of antenna elements for receiving radio signals, a plurality of variable phase circuits for controlling phases of signals received at the antenna elements to desired phases, a signal combining circuit for combining output signals of the plurality of variable phase circuits; a demodulator having a first signal input terminal to which a combined reception signal of the signal combining circuit of the phased array antenna portion is input, a second signal input terminal to which the local signal is input, a first branch circuit having an input terminal, a first output terminal, a second output terminal, and a third output terminal, the input terminal being connected to the first signal input terminal, branching the reception signal input to the input terminal to first, second, and third reception signals, outputting the first reception signal from the first output terminal, outputting the second reception signal from the second output terminal, and outputting the third reception signal from the third output terminal, a second branch circuit having an input terminal, a first output terminal, and a second output terminal, the input terminal being connected to the second signal input terminal, branching the local signal input to the input terminal to first and second local signals, outputting the first local signal from the first output terminal, and outputting the second local signal from the second output terminal, a first phase shifter for shifting a phase of the first local signal output from the first output terminal of the second branch circuit by exactly a predetermined amount and outputting the result, a second phase shifter for shifting a phase of the third reception signal output from the third output terminal of the first branch circuit by exactly a predetermined amount and outputting the result, a first coupler circuit for coupling the second reception signal output from the second output terminal of the first branch circuit and the first local signal shifted in phase by exactly a predetermined amount output from the first phase shifter and outputting the result, a second coupler circuit for coupling the third reception signal shifted in phase by exactly a predetermined amount output from the second phase shifter and the second local signal output from the second branch circuit and outputting the result, a first signal level detection circuit for detecting the level of the signal output from the first output terminal of the first branch circuit, a second signal level detection circuit for detecting the level of the signal output from the first coupler circuit, a third signal level detection circuit for detecting the level of the signal output from the second coupler circuit, and a conversion circuit for converting the output signal of the first signal level detection circuit, the output signal of the second signal level detection circuit, and the output signal of the third signal level detection circuit to a plurality of signal components included in the reception signal; a gain control circuit for adjusting the level of the reception signal to a desired level and supplying the result to the first signal input terminal of the demodulator; and a local signal generation circuit for generating the local signal with a desired oscillation frequency and supplying the result to the second signal input terminal of the demodulator.

A receiver according to a 20th aspect of the present invention comprises a phased array antenna portion including a plurality of antenna elements for receiving radio signals, a plurality of variable phase circuits for controlling phases of signals received at the antenna elements to desired phases, a signal combining circuit for combining output signals of the plurality of variable phase circuits; a demodulator having a first signal input terminal to which a combined reception signal of the signal combining.circuit of the phased array antenna portion is input, a second signal input terminal to which the local signal is input, a first branch circuit having an input terminal, a first output terminal, and a second output terminal, the input terminal being connected to the first signal input terminal, branching the reception signal input to the input terminal to first and second reception signals, outputting the first reception signal from the first output terminal, and outputting the second reception signal from the second output terminal, a second branch circuit having an input terminal, a first output terminal, and a second output terminal, the input terminal being connected to the first output terminal of the first branch circuit, branching the reception signal input to the input terminal to third and fourth reception signals, outputting the third reception signal from the first output terminal, and outputting the fourth reception signal from the second output terminal, a third branch circuit having an input terminal, a first output terminal, and a second output terminal, the input terminal being connected to the second signal input terminal, branching the local signal input to the input terminal to first and second local signals, outputting the first local signal from the first output terminal, and outputting the second local signal from the second output terminal, a fourth branch circuit having an input terminal, a first output terminal, and a second output terminal, the input terminal being connected to the first output terminal of the third branch circuit, branching the local signal input to the input terminal to third and fourth local signals, outputting the third local signal from the first output terminal, and outputting the fourth local signal from the second output terminal, a first phase shifter for shifting a phase of the third local signal output from the first output terminal of the fourth branch circuit by exactly a predetermined amount and outputting the result, a second phase shifter for shifting a phase of the fourth local signal output from the second output terminal of the fourth branch circuit by exactly a predetermined amount and outputting the result, a first coupler circuit for coupling the third reception signal output from the first output terminal of the second branch circuit and the third local signal shifted in phase by exactly a predetermined amount output from the first phase shifter and outputting the result, a second coupler circuit for coupling the fourth reception signal output from the second output terminal of the second branch circuit and the fourth local signal shifted in phase by exactly a predetermined amount output from the second phase shifter and outputting the result, a first signal level detection circuit for detecting the level of the signal output from the first coupler circuit, a second signal level detection circuit for detecting the level of the signal output from the second coupler circuit, a third signal level detection circuit for detecting the level of the signal output from the second output terminal of the first branch circuit, a fourth signal level detection circuit for detecting the level of the signal output from the second output terminal of the third branch circuit, and a conversion circuit for converting the output signal of the first signal level detection circuit, the output signal of the second signal level detection circuit, the output signal of the third signal level detection circuit, and the output signal of the fourth signal level detection circuit to a plurality of signal components included in the reception signal; a gain control circuit for adjusting the level of the reception signal to a desired level and supplying the result to the first signal input terminal of the demodulator; and a local signal generation circuit for generating the local signal with a desired oscillation frequency and supplying the result to the second signal input terminal of the demodulator.

A receiver according to a 21st aspect of the present invention comprises a phased array antenna portion including a plurality of antenna elements for receiving radio signals, a plurality of variable phase circuits for controlling phases of signals received at the antenna elements to desired phases, a signal combining circuit for combining output signals of the plurality of variable phase circuits; a demodulator having a first signal input terminal to which a combined reception signal of the signal combining circuit of the phased array antenna portion is input, a second signal input terminal to which the local signal is input, a branch circuit having an input terminal, a first output terminal, and a second output terminal, the input terminal being connected to the first signal input terminal, branching the reception signal input to the input terminal to first and second reception signals, outputting the first reception signal from the first output terminal, and outputting the second reception signal from the second output terminal, a first phase divider having an input terminal, a first output terminal, and a second output terminal, the input terminal being connected to the first output terminal of the branch circuit, branching the reception signal input to the input terminal to third and fourth reception signals having inverse phases to each other, outputting the third reception signal from the first output terminal, and outputting the fourth reception signal from the second output terminal, a second phase divider having an input terminal, a first output terminal, and a second output terminal, the input terminal being connected to the second signal input terminal, branching the local signal input to the input terminal to first and second local signals having inverse phases to each other, outputting the first local signal from the first output terminal, and outputting the second local signal from the second output terminal, a first phase shifter for shifting a phase of the first local signal output from the first output terminal of the second phase divider by exactly a predetermined amount and outputting the result, a second phase shifter for shifting a phase of the second local signal output from the second output terminal of the second phase divider by exactly a predetermined amount and outputting the result, a first coupler circuit for coupling the third reception signal output from the first output terminal of the first phase divider and the first local signal shifted in phase by exactly a predetermined amount output from the first phase shifter and outputting the result, a second coupler circuit for coupling the fourth reception signal output from the second output terminal of the first phase divider and the second local signal shifted in phase by exactly a predetermined amount output from the second phase shifter and outputting the result, a first signal level detection circuit for detecting the level of the signal output from the first coupler circuit, a second signal level detection circuit for detecting the level of the signal output from the second coupler circuit, a third signal level detection circuit for detecting the level of the signal output from the second output terminal of the branch circuit, and a conversion circuit for converting the output signal of the first signal level detection circuit, the output signal of the second signal level detection circuit, and the output signal of the third signal level detection circuit to a plurality of signal components included in the reception'signal; a gain control circuit for adjusting the level of the reception signal to a desired level and supplying the result to the first signal input terminal of the demodulator; and a local signal generation circuit for generating the local signal with a desired oscillation frequency and supplying the result to the second signal input terminal of the demodulator.

In the receivers according to the 15th to 21st aspects of the present invention, provision is further made of a mean signal power computation circuit receiving the output signal of the first signal level detection circuit of the demodulator and computing a mean signal power and a gain.control signal generation circuit for outputting the control signal to the variable gain circuit so that the reception signal levels input to the demodulator become constant based on the mean power found at the mean signal power computation circuit, and the variable gain circuit adjusts the input reception signal to the level in accordance with the control signal by the gain control signal generation circuit and supplies the result to the first signal input terminal of the demodulator.

Further, preferably, provision is further made of a frequency error detection circuit for detecting a frequency error based on a plurality of signal components obtained at the conversion circuit of the demodulator and supplying the result to the local signal generation circuit, and the local signal generation circuit sets an oscillation frequency of the local signal so as to become a frequency substantially equal to a carrier frequency of the reception signal based on the frequency error value detected at the frequency error detection circuit.

According to the present invention, at the demodulator, for example the reception signal is supplied to the input terminal of the first branch circuit and branched to three signals. The branched first reception signal is supplied from the first output terminal to the first power detector. The branched second reception signal is output from the second output terminal to the first coupler circuit. The branched third reception signal is output from the third output terminal to the second coupler circuit.

On the other hand, the local signal is supplied to the input terminal of the second branch circuit and branched to two signals. The branched first local signal is output from the first output terminal to the first phase shifter. The branched second local signal is output from the second output terminal to the second phase shifter.

The first phase shifter shifts the phase of the local signal output from the first output terminal of the second branch circuit by exactly a predetermined amount and outputs the result to the first coupler circuit. The second phase shifter shifts the phase of the local signal output from the second output terminal of the second branch circuit by exactly a predetermined amount and outputs the result to the second coupler circuit.

Then, the first coupler circuit couples the reception signal output from the second output terminal of the first branch circuit and the local signal shifted in phase by exactly a predetermined amount by the first phase shifter and outputs the result to the second power detector. The second coupler circuit couples the reception signal output from the third output terminal of the first branch circuit and the local signal shifted in phase by exactly a predetermined amount by the second phase shifter and outputs the result to the third power detector.

Accordingly, the first power detector is supplied with the reception signal. The first power detector outputs an amplitude component of the input reception signal as a detection signal P1 to the conversion circuit and the mean signal power generation circuit.

Similarly, the input of the second power detector is supplied with a vector sum signal of the reception signal and the local signal given the phase shift of the predetermined amount. The second power detector outputs the amplitude component of the vector sum signal of the input reception signal and the local signal given the phase shift of the predetermined amount as a detection signal P2 to the conversion circuit.

Similarly, the input of the third power detector is supplied with a vector sum signal of the reception signal and the local signal given the phase shift of the predetermined amount. The third power detector outputs the amplitude component of the vector sum signal of the input reception signal and the local signal given the phase shift of the predetermined amount as a detection signal P3 to the conversion circuit.

The baseband output signals P1, P2, and P3 output from the first to third power detectors are subjected to computation based on for example the above equation at the conversion circuit and converted to the In-phase signal I and the quadrature signal Q as the demodulated signals.

Further, the detection signals P1, P2, and P3 of the first to third power detectors are supplied to the mean signal power computation circuit, the mean signal power of the reception signals is computed here, and the result is output to the gain control signal generation circuit.

At the gain control signal generation circuit, based on the mean power found at the mean signal power computation circuit, a control signal is output to the variable gain circuit so that the reception signal levels input to the demodulator become constant. Then, the variable gain circuit adjusts the reception signal level to the level in accordance with the control signal by the gain control signal generation circuit and supplies the result to the demodulator.

Further, the In-phase signal I and the quadrature signal Q demodulated at the conversion circuit are output to the frequency error detection circuit. The frequency error detection circuit receiving the output demodulated signals I and Q detects the frequency error by the signals I and Q and supplies the result to the local signal generation circuit. The local signal generation circuit receives the frequency error value signal detected at the frequency error detection circuit, generates a local signal having an oscillation frequency substantially equal to the reception signal frequency, and supplies the result to the demodulator.

BRIEF DESCRIPTION OF THE DRAWINGS

FIG. 1 is a circuit diagram of the configuration of a principal part of a general demodulator.
FIG. 2A and 2B are block diagrams of a first example of the configuration of a six-port demodulator.
FIG. 3A and 3B are block diagrams of a second example of the configuration of a six-port demodulator.
FIG. 4 is a block diagram of a third example of the configuration of a six-port demodulator.
FIG. 5 is a block diagram of a fourth example of the configuration of a six-port demodulator.
FIG. 6 is a circuit diagram of a directional coupler using a Wheatstone bridge.
FIG. 7 is a block diagram of an embodiment of a receiver employing a demodulator of a direct conversion system according to the present invention.
FIG. 8 is a block diagram of a concrete example of the configuration of a multi-port demodulator according to the present invention.
FIG. 9 is a circuit diagram of a concrete example of the configuration of a one-input three-output branch circuit according to the present invention.
FIG. 10 is a circuit diagram of another concrete example of the configuration of a one-input three-output branch circuit according to the present invention.
FIG. 11 is a circuit diagram of another concrete example of the configuration of a one-input three-output branch circuit according to the present invention.
FIG. 12 is a circuit diagram of another concrete example of the configuration of a one-input three-output branch circuit according to the present invention.
FIG. 13 is a circuit diagram of another concrete example of the configuration of a one-input two-output branch circuit according to the present invention.
FIG. 14 is a circuit diagram of another concrete example of the configuration of a one-input two-output branch circuit according to the present invention.
FIG. 15 is a circuit diagram of another concrete example of the configuration of a one-input two-output branch circuit according to the present invention.
FIG. 16 is a circuit diagram of another concrete example of the configuration of a one-input two-output branch circuit according to the present invention.
FIG. 17 is a circuit diagram of a concrete example of the configuration of a phase shifter according to the present invention.
FIG. 18 is a circuit diagram of another concrete example of the configuration of a phase shifter according to the present invention.
FIG. 19 is a circuit diagram of another concrete example of the configuration of a phase shifter according to the present invention.
FIG. 20 is a circuit diagram of a concrete example of the configuration of a coupler circuit according to the present invention.
FIG. 21 is a circuit diagram of an example of a power detector according to the present invention.
FIG. 22 is a view of an example of detection characteristics of the power detector of FIG. 21.
FIG. 23 is a view of a high frequency input power Pin versus output detection voltage Vout when a gate bias voltage is used as a parameter in the circuit of FIG. 21.
FIG. 24 is a circuit diagram of a concrete example of the configuration of a multi-port signal-to-IQ signal conversion circuit of FIG. 7.

FIG. 25 is a block diagram of another embodiment of a multi-port demodulator according to the present invention.
FIG. 26 is a circuit diagram of an example of the configuration of a multi-port signal-to-IQ signal conversion circuit of FIG. 25.
FIG. 27 is a block diagram of another embodiment of a multi-port demodulator according to the present invention.
FIG. 28 is a block diagram of another embodiment of a multi-port demodulator according to the present invention.
FIG. 29 is a block diagram of another embodiment of a multi-port demodulator according to the present invention.
FIG. 30 is a block diagram of another embodiment of a multi-port demodulator according to the present invention.
FIG. 31 is a block diagram of another embodiment of a multi-port demodulator according to the present invention.
FIG. 32 is a block diagram of another embodiment of a multi-port demodulator according to the present invention.
FIG. 33 is a circuit diagram of a concrete example of the configuration of a 180-degree phase divider of FIG. 32 .
FIG. 34 is a view of the configuration of an embodiment of a receiver provided with a phased array antenna portion, employing the multi-port demodulator according to the present invention, and performing demodulation by a direct conversion system.

BEST MODE FOR WORKING THE INVENTION

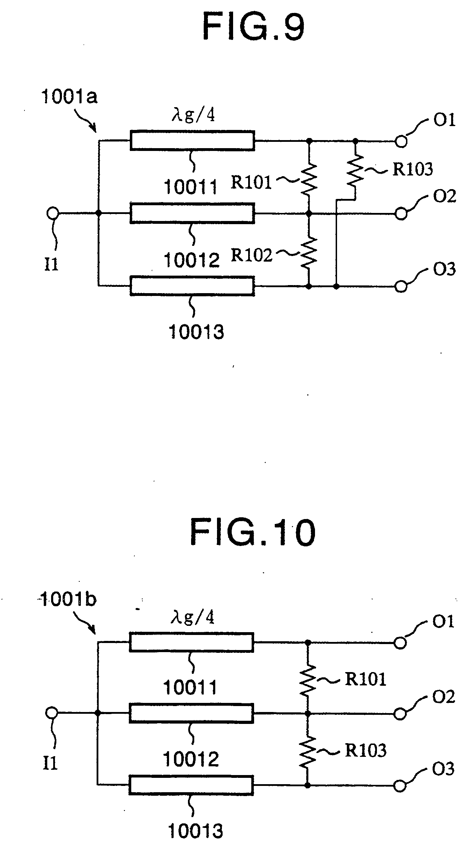

Below, an explanation will be given of embodiments of the present invention with reference to the attached drawings.

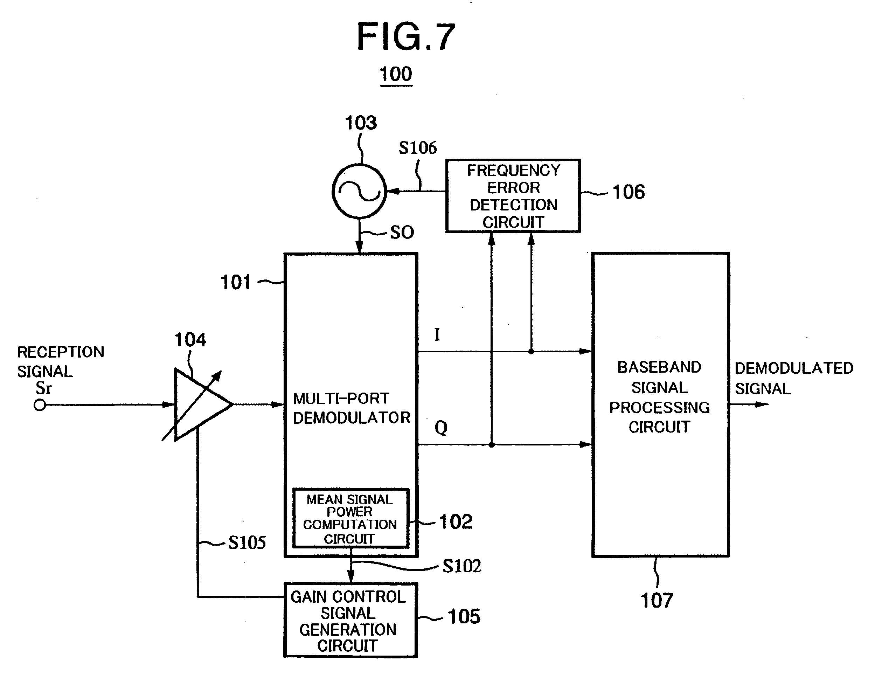

FIG. 7 is a block diagram of an embodiment of a receiver employing a demodulator of a direct conversion system according to the present invention.
A receiver 100 according to the present embodiment has, as shown in FIG. 7, a multi-port demodulator 101, a mean signal power computation circuit 102, a local signal generation circuit 103, a variable gain circuit 104, a gain control signal generation circuit 105, a frequency error detection circuit 106, and a baseband signal processing circuit 107 as principal components.
The multi-port demodulator 101 is configured by a five-port demodulator, receives the reception signal Sr adjusted in level at the variable gain circuit 104 and the local signal SO generated at the local signal generation circuit 103, generates three signals having phase differences, detects the signal levels (amplitude components) of these signals, converts them to In-phase signals (I) and quadrature signals (Q) included in the reception signals based on three power detection signals P1, P2, and P3, and supplies these In-phase signals (I) and quadrature signals (Q) to the frequency error detection circuit 106 and the baseband signal processing circuit 107.
Further, the multi-port demodulator 101 supplies the power detection signal (baseband signal) P1 to the mean power computation circuit 102 formed on the same chip.

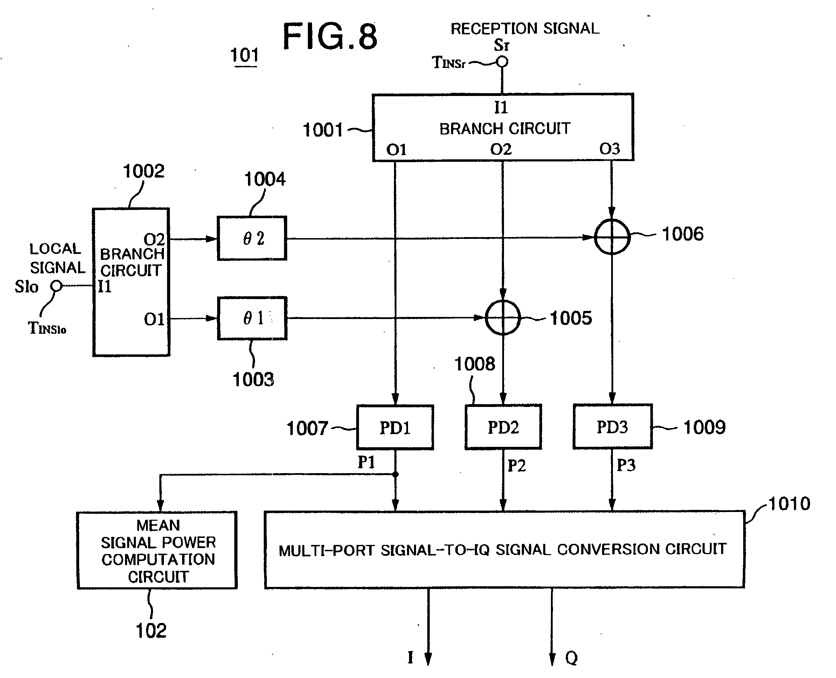

FIG. 8 is a block diagram of a concrete example of the configuration of the multi-port demodulator 101.
This multi-port demodulator 101 has, as shown in FIG. 8, a reception signal use first signal input terminal $T_{INSr}$, a local signal use second signal input terminal $T_{INSlo}$, a first branch circuit 1001, a second branch circuit 1002, a first phase shifter 1003, a second phase shifter 1004, a first coupler circuit 1005, a second coupler circuit 1006, a first power detector 1007 as a first signal level detection circuit, a second power detector 1008 as a second signal level detection circuit, a third power detector 1009 as a third signal level detection circuit, and a multi-port signal-to-IQ signal conversion circuit 1010.
Then, a multi-port junction circuit 1000 is configured by the reception signal use first signal input terminal $T_{INSr}$, the local signal use second signal input terminal $T_{INSlo}$, the first branch circuit 1001, the second branch circuit 1002, the first phase shifter 1003, the second phase shifter 1004, the first coupler circuit 1005, and the second coupler circuit 1006.
The first branch circuit 1001 has an input terminal I1, a first output terminal O1, a second output terminal O2, and a third output terminal O3, the input terminal I1 being connected to the first signal input terminal $T_{INSr}$, branches the reception signal Sr input to the input terminal I1 to three signals, outputs the branched first reception signal from the first output terminal O1 to the first power detector 1007, outputs the second reception signal from the second output terminal O2 to the first coupler circuit 1005, and outputs the third reception signal from the third output terminal O3 to the second coupler circuit 1006.
The one-input three-output first branch circuit 1001 is configured by for example the circuits as shown in FIG. 9 to FIG. 12.
A branch circuit 1001a of FIG. 9 is configured by $\lambda g/4$ transmission lines 10011, 10012, and 10013 having one end sides connected in parallel to the input terminal I1 and by resistance elements R101, R102, and R103. Here, $\lambda g$ represents the effective wavelength.
The other end of the $\lambda g/4$ transmission line 10011 is connected to the first output terminal O1, the other end of the $\lambda g/4$ transmission line 10012 is connected to the second output terminal O2, and the other end of the $\lambda g/4$ transmission line 10013 is connected to the third output terminal O3.
Further, the resistance element R101 is connected between the first output terminal O1 and the second output terminal O2, the resistance element R102 is connected between the second output terminal O2 and the third output terminal O3, and the resistance element R103 is connected between the first output terminal O1 and the third output terminal O3.

In this branch circuit 1001a, the reception signal Sr input to the input terminal I1 is substantially equally branched to three and output from the first output terminal O1, second output terminal O2, and third output terminal O3.

A branch circuit 1001b of FIG. 10 is a circuit in which the resistance element R103 is not connected between the first output terminal O1 and the third output terminal O3 of the circuit of FIG. 9. In this circuit as well, three branched signals of the reception signal can be obtained well.

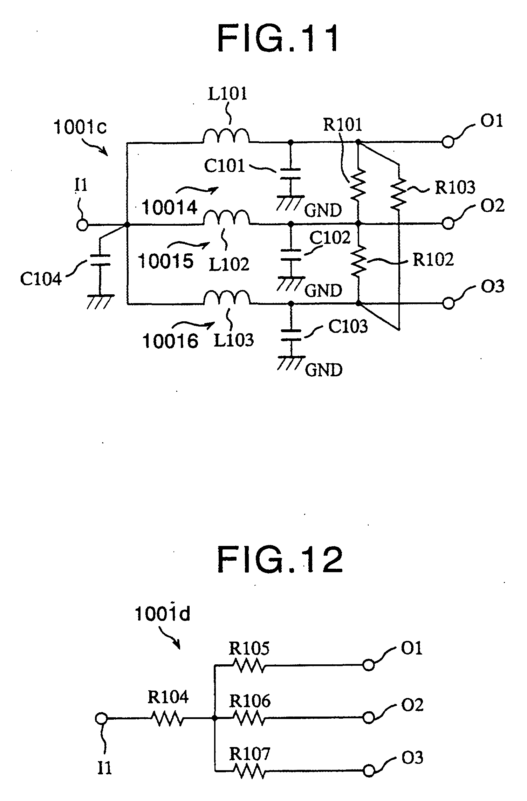

A branch circuit 1001c of FIG. 11 is comprised of delay lines 10014, 10015, and 10016 configured by an inductor L101 and a capacitor C101, an inductor L102 and a capacitor C102, and an inductor L103 and a capacitor C103, in place of the λg/4 transmission lines 10011, 10012, and 10013. Further, connection points of one ends of the inductors L101 to L103 and the input terminal I1 are connected to a second electrode of the capacitor C104 having a first electrode grounded.

In this circuit as well, three branched signals of the reception signal can be obtained well.

A branch circuit 1001d of FIG. 12 is configured by four resistance elements R104, R105, R106, and R107.

At the branch circuit 1001d, one end of the resistance element R104 is connected to the input terminal I1, and one ends of the resistance elements R105 to R107 are connected in parallel to the other end of the resistance element R104. The other end of the resistance element R105 is connected to the first output terminal O1, the other end of the resistance element R106 is connected to the second output terminal O2, and the other end of the resistance element R107 is connected to the third output terminal O3.

The second branch circuit 1002 has an input terminal I1, a first output terminal O1, and a second output terminal O2, the input terminal I1 being connected to the second signal input terminal $T_{INSlo}$, and branches the local signal SO input to the input terminal I1 to two signals, outputs the branched first local signal from the first output terminal O1 to the first phase shifter 1003, and outputs the second local signal from the second output terminal O2 to the second phase shifter 1004.

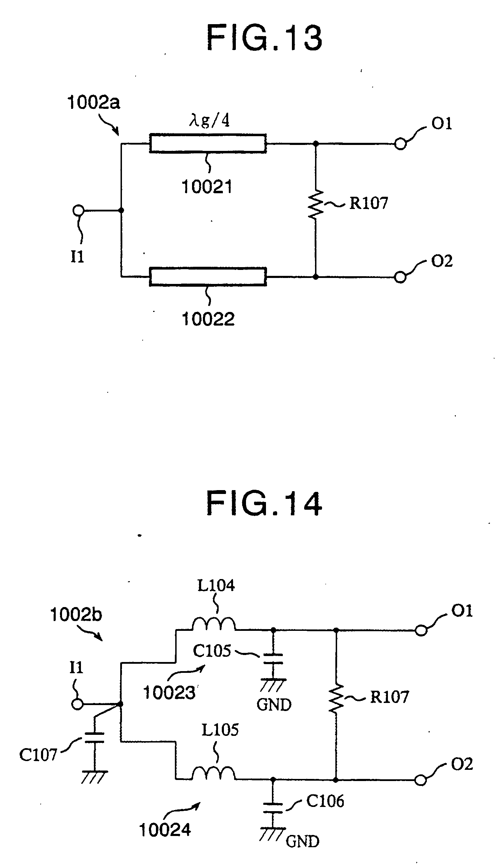

The one-input two-output second branch circuit 1002 is configured by for example the circuits as shown in FIG. 13 to FIG. 16.

A branch circuit 1002a of FIG. 13 is configured by λg/4 transmission lines 10021 and 10022 having one end sides connected to the input terminal I1 and by a resistance element R107. Here, λg represents the effective wavelength.

The other end of the λg/4 transmission line 10021 is connected to the first output terminal O1, while the other end of the λg/4 transmission line 10022 is connected to the second output terminal O2.

Then, the resistance element R107 is connected between the first output terminal O1 and the second output terminal O2.

In this branch circuit 1002a, the reception signal Sr input to the Input terminal I1 is substantially equally branched to two and output from the first output terminal O1 and the second output terminal O2.

A branch circuit 1002b of FIG. 14 is comprised of delay lines 10023 and 10024 configured by an inductor L104 and a capacitor C105 and an inductor L105 and a capacitor C106 in place of the λg/4 transmission lines 10021 and 10022. Further, connection points of one ends of the inductors L104 and L105 and the input terminal I1 are connected to the second electrode of the capacitor C107 having the first electrode grounded.

In this circuit as well, two branched signals of the reception signal can be obtained well.

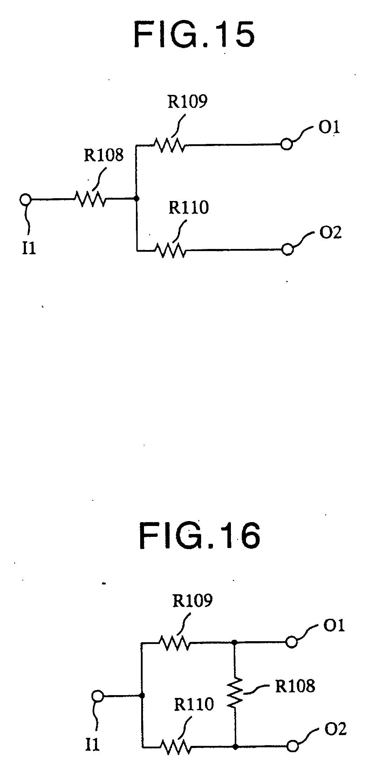

A branch circuit 1001c of FIG. 15 is configured by three resistance elements R108, R109, and R110.

At the branch circuit 1002c, one end of the resistance element R108 is connected to the input terminal I1, and one ends of the resistance elements R109 and R110 are connected in parallel to the other end of the resistance element R108. The other end of the resistance element R109 is connected to the first output terminal O1, and the other end of the resistance element R110 is connected to the second output terminal O2.

The branch circuit 1001d of FIG. 16 is configured by connecting the resistance element R108 between the first output terminal O1 and the second output terminal O2 in place of the connection between one ends of the resistance elements R109 and R110 and the input terminal I1.

The first phase shifter 1003 shifts the phase of the local signal output from the first output terminal O1 of the second coupler circuit 1002 by exactly θ1 degrees and outputs the result to the first coupler circuit 1005.

The second phase shifter 1004 shifts the phase of the local signal output from the second output terminal O2 of the second coupler circuit 1002 by exactly θ2 degrees and outputs the result to the second coupler circuit 1006.

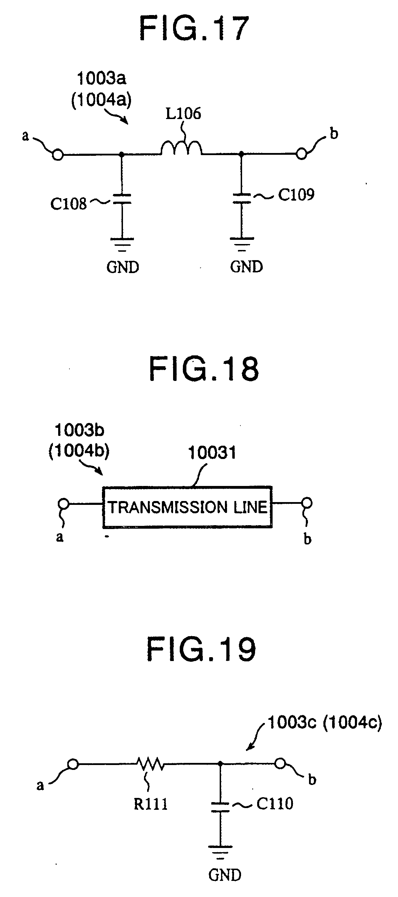

The first and second phase shifters 1003 and 1004 are configured by for example the circuits shown in FIG. 17 to FIG. 19.

The phase shifter 1003a (1004a) shown in FIG. 17 is configured by a π type LC phase shifter constituted by an inductor L106 and capacitors C108 and C109. In the phase shifter 1003a, the inductor L106 is connected between a first terminal <u>a</u> and a second terminal <u>b</u>, the capacitor C108 is connected between the first terminal <u>a</u> and a ground

potential GND, and the capacitor C109 is connected between the second terminal b and the ground potential GND .

The phase shifter 1003b (1004b) shown in FIG. 18 is configured by a transmission line 10031 connected between the first terminal a and the second terminal.

The phase shifter 1003c (1004c) shown in FIG. 19 is configured by a filter constituted by a resistance element R111 connected between the first terminal a and the second terminal b and a capacitor C110 connected between the second terminal b and the ground GND.

The first coupler circuit 1005 couples the reception signal output from the second output terminal O2 of the first branch circuit 1001 and the local signal shifted in phase by exactly θ1 degrees by the first phase shifter 1003 and outputs the result to the second power detector 1008.

The second coupler circuit 1006 couples the reception signal output from the third output terminal O3 of the first branch circuit 1001 and the local signal shifted in phase by exactly θ2 degrees by the second phase shifter 1004 and outputs the result to the third power detector 1009.

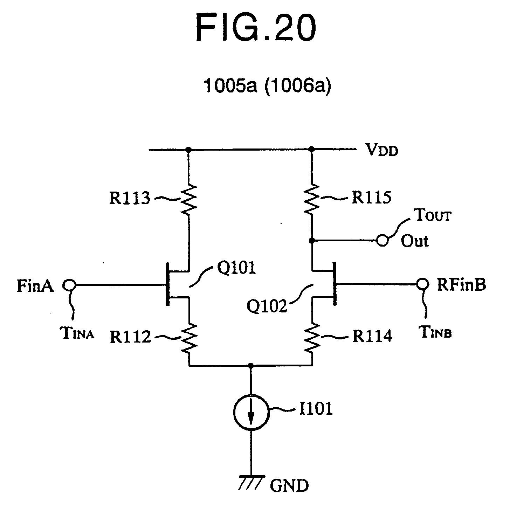

The first and second coupler circuits 1005 and 1006 are configured by for example the circuits as shown in FIG. 20.

The coupler circuit 1005a (1006a) shown in FIG. 20 is configured by field effect transistors (hereinafter, simply referred to as transistors) Q101 and Q102, a current source I101, and resistance elements R112, R113, R114, and R115.

The gate of the transistor Q101 is connected to an input terminal $T_{INA}$ of a signal FinA (output signal of the first phase shifter 1003 or the second phase shifter 1004), the source is connected to a current source I101 via the resistance element R112, and the drain is connected to a supply line of the power supply voltage $V_{DD}$ via the resistance element R113.

Further, the gate of the transistor Q102 is connected to an input terminal $T_{INB}$ of an RFinB (reception signal branched at the first branch circuit 1001), the source is connected to the current source I101 via the resistance element R114, and the drain is connected to the supply line of the power supply voltage $V_{DD}$ via the resistance element R115. Then, the drain of the transistor Q102 is connected to an output $T_{OUT}$.

At this coupler circuit 1005a (1006a), the reception signal is supplied via the input terminal $T_{INB}$ to the gate of the transistor Q102, the local signal received the phase shifter function is supplied via the input terminal $T_{INA}$ to the gate of the transistor Q101, the two signal components are coupled, and the coupled signal is output from the drain of the transistor Q102.

Note that, here, "five-port" means five ports obtained by adding the three ports of the output terminal to the first power detector 1007 of the first branch circuit 1001 (first output terminal O1), the output terminal to the second power detector 1008 of the second coupler circuit 1005, and the output terminal to the third power detector 1009 of the second coupler circuit 1006 to the two ports of the reception signal use input terminal $T_{INSr}$ and the local signal use input terminal $T_{INSlo}$.

Under such a configuration, the reception signal Sr(t) is input to the first signal input terminal $T_{INSr}$. Note that, Sr(t) is the voltage of the input terminal $T_{INSr}$ at a time t. The reception signal Sr(t) is supplied to the input terminal I1 of the first branch circuit 1001 and branched to three signals. The branched first reception signal is supplied from the first output terminal O1 to the first power detector 1007. The branched second reception signal is output from the second output terminal O2 to the first coupler circuit 1005. The branched third reception signal is output from the third output terminal O3 to the second coupler circuit 1006.

On the other hand, a local signal SO(t) is input to the second signal input terminal $T_{INSlo}$. SO(t) is the voltage of the input terminal $T_{INSlo}$ at the time t. The local signal SO(t) is supplied to the input terminal I1 of the second branch circuit 1002 and branched to two signals. The branched first local signal is output from the first output terminal O1 to the first phase shifter 1003. The branched second local signal is output from the second output terminal O2 to the second phase shifter 1004.

At the first phase shifter 1003, the local signal output from the first output terminal O1 of the second branch circuit 1002 is shifted in phase by exactly θ1 degrees and output to the first coupler circuit 1005. At the second phase shifter 1004, the local signal output from the second output terminal O2 of the second branch circuit 1002 is shifted in phase by exactly θ2 degrees and output to the second coupler circuit 1006.

Then, the first coupler circuit 1005 couples the reception signal output from the second output terminal O2 of the first branch circuit 1001 and the local signal shifted in phase by exactly θ1 degrees by the first phase shifter 1003 and outputs the result to the second power detector 1008. The second coupler circuit 1006 couples the reception signal output from the third output terminal O3 of the first branch circuit 1001 and the local signal shifted in phase by exactly θ2 degrees by the second phase shifter 1004 and outputs the result to the third power detector 1009.

Accordingly, the input of the first power detector 1007 is supplied with the reception signal Sr(t). The first power detector 1007 outputs the amplitude component of the input reception signal Sr(t) as the detection signal P1 to the multi-port signal-to-IQ signal conversion circuit 1010 and the mean signal power generation circuit 102.

Similarly, the input of the second power detector 1008 is supplied with a vector sum signal of the reception signal Sr(t) and the local signal SO(t) given the phase shift θ1. The second power detector 1008 outputs the amplitude component of the input vector sum signal of the reception signal Sr(t) and the local signal SO(t) given the phase shift θ1 as the detection signal P2 to the multi-port signal-to-IQ signal conversion circuit 1010.

Similarly, the input of the third power detector 1009 is supplied with a vector sum signal of the reception signal Sr(t) and the local signal SO(t) given the phase shift θ2. The third power detector 1009 outputs the amplitude component of the input vector sum signal of the reception signal Sr(t) and the local signal SO(t) given the phase shift θ2 as the detection signal P3 to the multi-port signal-to-IQ signal conversion circuit 1010.

Here, an explanation will be given of a concrete configuration of the power detector usable for the multi-port demodulator.

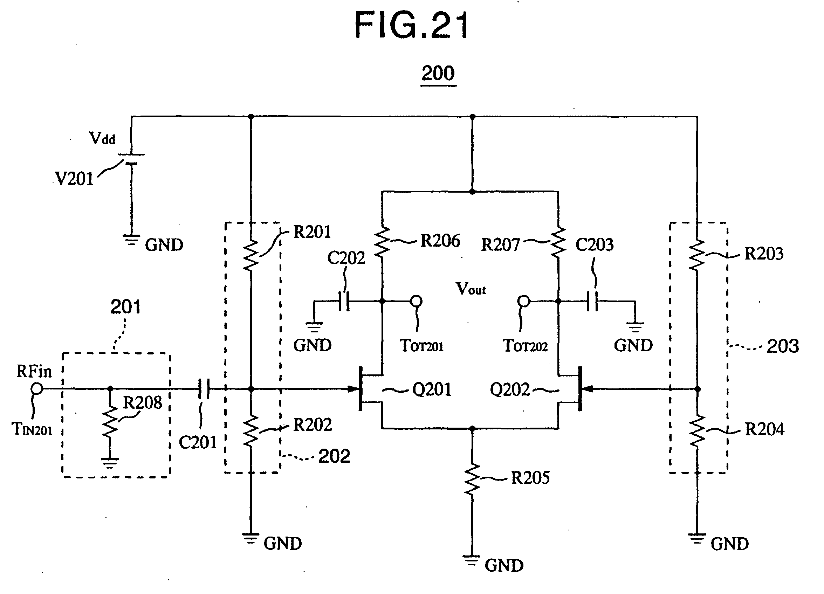

FIG. 21 is a circuit diagram of an example of the power detector according to the present invention.

A power detector 200 (PD1, PD2, PD3) is configured by two first and second transistors (field effect transistors) Q201 and Q202 as active elements, capacitors C201, C202, and C203, resistance elements R201, R202, R203, R204, R205, R206, R207, and R208, a voltage source V201, a matching circuit (MTR) 201, and gate bias supply circuits 202 and 203.

The matching circuit 201 is configured by the resistance element R208. The resistance element R208 is connected between the connection point of the input terminal $T_{IN201}$ and one electrode of a direct current (DC) cut-off use capacitor C201 and the ground potential GND.

The gate bias supply circuit 202 is configured by resistance elements R201 and R202 connected in series between the voltage source V201 and the ground potential GND. The connection point of the resistance elements R201 and R202 is connected to the other electrode of the capacitor C201 and the gate of the transistor Q201.

The gate bias supply circuit 202 having such a configuration generates the bias voltage of the transistor Q201 by dividing the resistance of the voltage Vdd of the voltage source V201 by the resistance elements R201 and R202.

The gate bias supply circuit 203 is configured by resistance elements R203 and R204 connected in series between the voltage source V201 and the ground potential GND. The connection point of the resistance elements R203 and R204 is connected to the gate of the transistor Q202.

The gate bias supply circuit 203 having such a configuration generates the bias voltage of the transistor Q202 by dividing the resistance of the voltage Vdd of the voltage source V201 by the resistance elements R203 and R204.

Note that, it is also possible to configure the gate bias supply circuit by not resistance division, but for example a choke coil (inductor having a sufficiently large inductance value) and a shunt coupling capacitance or a distribution constant line.

The source of the transistor Q201 and the source of the transistor Q202 are connected, and the connection point thereof is connected via the resistance element R205 as the current source to the ground potential GND.

The drain of the transistor Q201 is connected to one end of the resistance element R206, one electrode of the capacitor C202, and the first output terminal $T_{OT201}$. The other end of the resistance element R206 is connected to the voltage source V201 of a voltage Vdd, and the other electrode of the capacitor C202 is connected to the ground potential GND.

The drain of the transistor Q202 is connected to one end of the resistance element R207, one electrode of the capacitor C203, and the second output terminal $T_{OT202}$. The other end of the resistance element R207 is connected to the voltage source V201 of the voltage Vdd, and the other electrode of the capacitor C203 is connected to the ground potential GND.

The drain bias voltage is supplied to the drain of the transistor Q201 via the resistance element R206, and the drain bias voltage is supplied to the drain of the transistor Q202 via the resistance element R207.

In the power detector 200 configured with such a connection configuration, the transistors Q201 and Q202 serving as the active elements have the same device structure so as to have for example substantially almost the same characteristics.

Further, in the circuit according to the present embodiment, the resistance values Rga1 and Rgb1 of the resistance elements R201 and R202 and resistance values Rga2 and Rgb2 of the resistance elements R203 and R204 configuring the gate bias supply circuits 202 and 203 must satisfy the conditions Rga1 = Rga2 and Rgb1 = Rgb2 to make the gate bias voltages of the transistors Q201 and Q202 equal as much as possible.

Further, the resistance value Rda of the resistance element R206 and the resistance value Rdb of the resistance element R207 connected to the drains of the transistors Q201 and Q202 satisfy the condition Rda = Rdb.

Similarly, a capacitance value Couta of the capacitor C202 and a capacitance value Coutb of the capacitor C203 desirably satisfy a condition Couta = Coutb, the capacitance values Couta and Coutb are set at a sufficiently large value so that the impedance becomes almost 0 Ohm at a higher frequency including an input high frequency signal of the input frequency fin.

Alternatively, in the power detector 200, when the ratio of the gate width Wga of the transistor Q201 and the gate width Wgb of the transistor Q202 (Wga/Wgb) is N, the detector is configured so as to satisfy conditions Rda/Rdb = 1/N and Couta = Coutb.

Specifically, by setting the gate width Wgb of the transistor Q202 smaller than the gate width Wga of the transistor Q201 and setting the resistance value Rdb of the drain bias use resistance element R207 larger than the resistance value Rda of the resistance element R206, the current consumption can be improved.

For example, by setting the ratio Wga/Wgb between the gate width Wga of the transistor Q201 and the gate width Wgb of the transistor Q202 at N and further setting the resistance value Rdb of the resistance element R207 at N times the resistance value Rda of the resistance element R206, the current consumption can be reduced to (N+1)/(2N) times the case where transistors having same characteristics are used as the transistors Q201 and 202.

Next, an explanation will be given of the operation of the power detector having the above configuration.

A high frequency signal RFin input to the input terminal $T_{IN201}$ is supplied via the matching circuit 201 and the DC cut-off use capacitor C201 to the gate of the transistor Q201.

At this time, the gate of the transistor Q201 is supplied with the gate bias voltage generated by the gate bias supply circuit 202. Similarly, the gate of the transistor Q202 is supplied with the gate bias voltage generated by the gate bias supply circuit 203.

Further, the drains of the transistors Q201 and Q202 are supplied with drain bias voltages via the resistance elements R206 and R207.

Then, coupling capacitors C202 and C203 having sufficiently large capacitance values are connected between the drains of the transistors Q201 and Q202 and the ground potential GND, so the drains of the transistors Q201 and Q202 become a stable state in terms of high frequency.

As a result, a voltage difference between the voltage of the drain of the transistor Q201, that is, the voltage of the first output terminal $T_{OT201}$, and the voltage of the drain of the transistor Q202, that is, the second output terminal $T_{OT202}$, is supplied as the detected output signal Vout to a not illustrated processing circuit of the following stage.

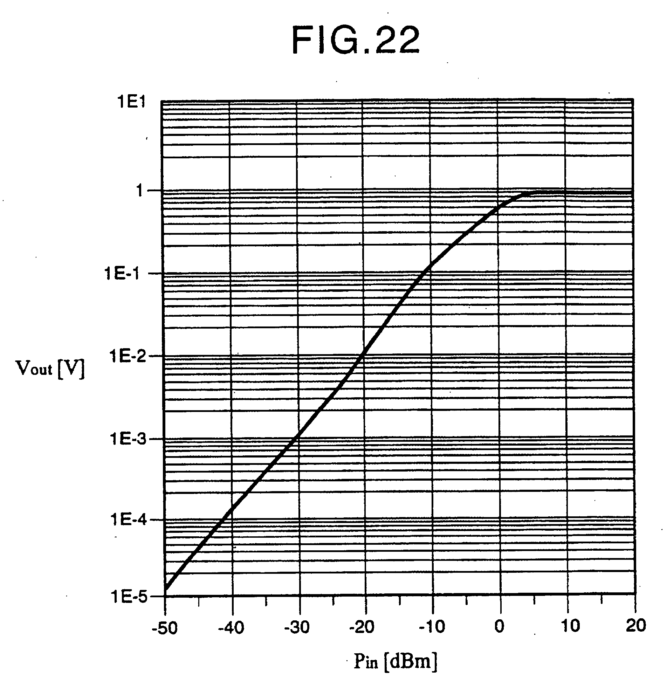

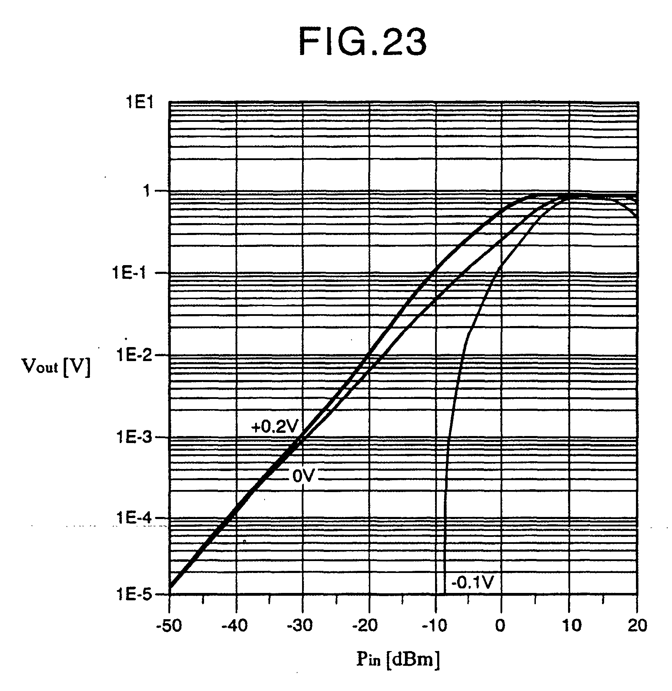

Below, detection characteristics of the power detector of FIG. 21 will be considered in relation to FIG. 22 and FIG. 23.

FIG. 22 is a view of an example of the detection characteristics of the power detector of FIG. 21.

In FIG. 22, the abscissa represents the input high frequency power Pin, and the ordinate represents the output detected voltage Vout. The frequency of the input high frequency signal is 5.5 GHz.

As seen from FIG. 22, the power detector of FIG. 21 has a good linearity.

FIG. 23 is a view of detection characteristics of the power detector of FIG. 21 when using the gate bias voltage as a parameter.

In FIG. 23 as well, the abscissa represents the input high frequency power Pin, and the ordinate represents the output detected voltage Vout.

It is seen from FIG. 23 that the fluctuation of the Pin versus Vout characteristic is small with respect to gate bias fluctuation in the characteristics of the power detector of FIG. 21.

Namely, the power detector of FIG. 21 does not cause a DC offset.

The multi-port signal-to-IQ signal conversion circuit 1010 receives the output signals P1, P2, and P3 of three power detectors 1007 to 1009, performs computation based on the following equations (1) and (2) by the computation circuit, converts the result to the In-phase signal I(t) and the quadrature signal Q(t) as the demodulated signals, and outputs the result to the frequency error detection circuit 106 and the baseband signal processing circuit 107.

$$I(t) = h_{i0}+h_{i1}P_1+h_{i2}P_2+h_{i3}P_3 \tag{1}$$

$$Q(t) = h_{q0}+h_{q1}P_1+h_{q2}P_2+h_{q3}P_3 \tag{2}$$

Here , $h_{io}$, $h_{i1}$, $h_{i2}$, $h_{i3}$, $h_{q0}$, $h_{q1}$, $h_{q2}$, and $h_{q3}$ are found from circuit constants provided in the branch circuits 1001 and 1002, phase shifters 1003 and 1004, coupler circuits 1005 and 1006, and power detectors 1007 to 1009 configuring the multi-port demodulator.

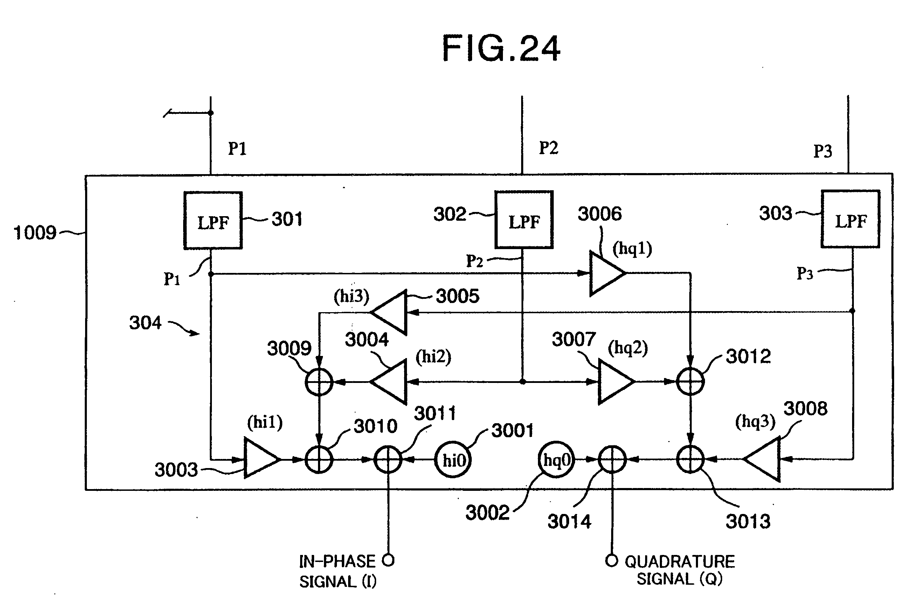

The multi-port signal-to-IQ signal conversion circuit 1009 specifically has, as shown in FIG. 24, for example channel selection use low pass filters (LPF) 301, 302, and 303 and a computation circuit 304.

The computation circuit 304 is configured by, as shown in FIG. 24, a coefficient $h_{i0}$ generator 3001, a coefficient $h_{q0}$ generator 3002, a coefficient $h_{i1}$ use multiplier 3003, a coefficient $h_{i2}$ use multiplier 3004, a coefficient $h_{i3}$ use multiplier 3005, a coefficient $h_{q1}$ use multiplier 3006, a coefficient $h_{q2}$ use multiplier 3007, a coefficient $h_{q3}$ use multiplier 3008, and adders 3009 to 3014.

In this computation circuit 304, the output signal P1 of the power detector 1007 having the channel selected at the LPF 301 is multiplied by the coefficient $h_{i1}$ at the multiplier 3003, and the multiplication result $h_{i1}P_1$ is supplied to the adder 3010. Further, the output signal P1 of the power detector 1007 having the channel selected at the LPF 301 is multiplied by the coefficient $h_{q1}$ at the multiplier 3006, and the multiplication result $h_{q1}P_1$ is supplied to the adder 3012.

The output signal P2 of the power detector 1008 having the channel selected at the LPF 302 is multiplied by the coefficient $h_{i2}$ at the multiplier 3004, and the multiplication result $h_{i2}P_2$ is supplied to the adder 3009. Further, the output signal P2 of the power detector 1008 having the channel selected at the LPF 302 is multiplied by the coefficient $h_{q2}$ at the multiplier 3007, and the multiplication result $h_{q2}P_2$ is supplied to the adder 3012.

The output signal P3 of the power detector 1009 having the channel selected at the LPF 303 is multiplied by the coefficient $h_{i3}$ at the multiplier 3005, and the multiplication result $h_{i3}P_3$ is supplied to the adder 3009. Further, the output signal P3 of the power detector 1009 having the channel selected at the LPF 303 is multiplied by the coefficient $h_{q3}$ at the multiplier 3008, and the multiplication result $h_{q3}P_3$ is supplied to the adder 3013.

The adder 3009 adds the output $h_{i2}P_2$ of the multiplier 3004 and the output $h_{i3}P_3$ of the multiplier 3005 and supplies the result $(h_{i2}P_2+h_{i3}P_3)$ to the adder 3010. The adder 3010 adds the output $h_{i1}P_1$ of the adder 3003 and the output $(h_{i2}P_2+h_{i3}P_3)$ of the adder 3009 and supplies the result $(h_{i1}P_1+h_{i2}P_2+h_{i3}P_3)$ to the adder 3011. Then, the adder 3011 adds the coefficient $h_{i0}$ by the coefficient $h_{i0}$ generator 3001 and the output $(h_{i1}P_1+h_{i2}P_2+h_{i3}P_3)$ of the adder 3010 to obtain an In-phase signal $I(t) = h_{i0}+h_{i1}P_1+h_{i2}P_2+h_{i3}P_3$ shown in the above equation (1).

On the other hand, the adder 3012 adds the output $h_{q1}P_1$ of the multiplier 3006 and the output $h_{q2}P_2$ of the multiplier 3007 and supplies the result $(h_{q1}P_1+h_{q2}P_2)$ to the adder 3013. The adder 3013 adds the output $h_{q3}P_3$ of the adder 3008 and the output $(h_{q1}P_1+h_{q2}P_2)$ of the adder 3012 and supplies the result $(h_{q1}P_1+h_{q2}P_2+h_{q3}P_3)$ to the adder 3014. Then, the adder 3014 adds the coefficient $h_{q0}$ by the coefficient $h_{q0}$ generator 3002 and the output $(h_{q1}P_1+h_{q2}P_2+h_{q3}P_3)$ of the adder 3013 to obtain a quadrature signal $Q(t) = h_{q0}+h_{q1}P_1+h_{q2}P_2+h_{q3}P_3$ shown in the above equation (2).

The mean signal power computation circuit 102 receives the output signal P1 of the first power detector 1007, finds the mean power of the reception signals based on the following equation (3), and outputs the same as a signal S102 to the gain control signal generation circuit 105.

$$\overline{d^2} = \overline{h_{d1}P_1} \tag{3}$$

Here, $d^2$ is the reception signal power, and $h_{d1}$ is found from the circuit constants provided in the branch circuit 1001 and the first power detector 1007 configuring the multi-port demodulator.

The local signal generation circuit 103 receives the frequency error value detected at the frequency error detection circuit 106 as a signal S106, generates the local signal SO having the oscillation frequency substantially equal to the reception signal frequency, and supplies the result to the multi-port demodulator 101.

The variable gain circuit 104 adjusts the level of the reception signal received at a not illustrated antenna element and via a pre-select RF filter and a low noise amplifier to the level in accordance with the control signal S105 by the gain control signal generation circuit 105 and supplies the result to the multi-port demodulator 101.

The gain control signal generation circuit 105 outputs the control signal S105 to the variable gain circuit 104 so that the levels of the reception signals input to the multi-port demodulator 101 become constant based on the mean power signal S102 found at the mean signal power computation circuit 102.

The frequency error detection circuit 106 detects the frequency error by the output signals I and Q of the multi-port demodulator 101 and supplies it as a signal S106 to the local signal generation circuit 103.

The baseband signal processing circuit 107 performs predetermined baseband signal processing based on the output signals I and Q of the multi-port demodulator 101 to obtain demodulation information and outputs the result to a not illustrated processing circuit of the next stage.

Next, a detailed explanation will be given of the operation by the above configuration.

The reception signal Sr(t) adjusted to the predetermined level at the variable gain circuit 104 is input to the input terminal $T_{INSr}$. As mentioned above, Sr (t) is the voltage of the input terminal $T_{INSr}$ at the time $\underline{t}$ and represented as in the following equation (4). Note that, here, the reception signal Sr(t) is defined as a modulated signal given information in its phase and amplitude. The frequency is a ratio of the change of the phase, so frequency modulation can also be the to be a modulation system giving information to the phase. Accordingly, Sr(t) may also be a frequency modulated signal.

$$\mathtt{Sr(t)} = \mathtt{Ad\varepsilon}^{\mathtt{j(\omega ct+\psi)}}$$

$$= \mathtt{A(dcos\psi + jdsin\psi)\,\varepsilon}^{\mathtt{j\omega ct}}$$

$$= \mathtt{A(I(t)+jQ(t))\,\varepsilon}^{\mathtt{j\omega ct}}$$

Here, A represents a mean voltage amplitude, d represents an amplitude modulation component, $\psi$ represents a phase modulation component, and $\omega c$ represents a carrier frequency, and I(t) = dcos$\psi$ and Q(t) = dsin$\psi$ stand.

Further, the local signal SO(t) generated at the local signal generation circuit 103 is input to the input terminal $T_{INSlo}$. As mentioned above, SO(t) is the voltage of the input terminal $T_{INSlo}$ at the time $\underline{t}$ and represented as in the following equation (5) :

$$S_o(t) = A_o \varepsilon^{j\omega ct} \tag{5}$$

Further, as mentioned above, the variable gain circuit 104 operates in accordance with the control signal S105 so that the reception signal levels input to the multi-port demodulator 101 become constant, so the ratio $A/A_o$ becomes constant. Here, for simplification, an explanation will be given by a case where $A = A_o$.

The reception signal Sr(t) is supplied to the input terminal I1 of the first branch circuit 1001 and branched to three signals. The branched first reception signal is output from the first output terminal O1 to the first power detector 1007, the second reception signal is output from the second output terminal O2 to the first coupler circuit 1005, and the third reception signal is output from the third output terminal O3 to the second coupler circuit 1006.

On the other hand, the local signal SO(t) is supplied to the input terminal I1 of the second branch circuit 1002 and branched to two signals. The branched first local signal is output from the first output terminal O1 to the first phase shifter 1003, and the second local signal is output from the second output terminal O2 to the second phase shifter 1004.

The first phase shifter 1003 shifts the phase of the local signal output from the first output terminal O1 of the second coupler circuit 1002 by exactly 61 degrees and outputs the result to the first coupler circuit 1005. The second phase shifter 1004 shifts the phase of the local signal output from the second output terminal O2 of the second coupler circuit 1002 by exactly $\theta 2$ degrees and outputs the result to the second coupler circuit 1006.

Then, the first coupler circuit 1005 couples the reception signal output from the second output terminal O2 of the first branch circuit 1001 and the local signal shifted in phase by exactly $\theta 1$ degrees by the first phase shifter 1003 and outputs the result to the second power detector 1008. The second coupler circuit 1006 couples the reception signal output from the third output terminal O3 of the first branch circuit 1001 and the local signal shifted in phase by exactly $\theta 2$ degrees by the second phase shifter 1004 and outputs the result to the third power detector 1009.

Input voltages v1, v2, and v3 of the first power detector 1007, second power detector 1008, and third power detector 1009 of signals output from the first branch circuit 1001, first coupler circuit 1005, and second coupler circuit 1006 are represented by the following equations:

$$V_1(t) = k_{11}Sr(t) \tag{6}$$

$$V_2(t) = k_{21}Sr(t) + k_{22}S_0(t)\varepsilon^{-j\theta 1} \tag{7}$$

$$V_3(t) = k_{31}Sr(t) + k_{32}S_0(t)\,\varepsilon^{-j\theta 2} \tag{8}$$

Here, kij indicates a voltage transfer coefficient (scalar amount) where a terminal j is the input and i is the output. j = 1 corresponds to the input terminal $T_{INSr}$, and j = 2 corresponds to the input terminal $T_{INSlo}$. i = 1, 2, and 3 correspond to input terminals of the power detectors 1007, 1008, and 1009.

The baseband output signal voltage of the power detector is represented by the following equation:

$$P_1 = Ci|v_1|^2 \tag{9}$$

Here, Ci is the coefficient of the power detector.

Accordingly, the baseband output signal voltages of the power detectors 1007, 1008, and 1009 are represented by the following equations:

$$P_1 = C_1|k_{11}S_r(t)|^2 \tag{10}$$

$$P_2 = C_2|k_{21}S_r(t)+k_{22}S_0(t)\varepsilon^{-j\theta 1}|^2 \tag{11}$$

$$P_3 = C_3|k_{31}S_r(t)+k_{32}S_0(t)\varepsilon^{-j\theta 2}|^2 \tag{12}$$

The three power detectors 1007, 1008, and 1009 have equivalent circuit configurations, so C = C1 = C2 = C3 can be set.

From the above, the above equations (10), (11), and (12) can be modified in the following way:

$$P_1/C = k_{11}{}^2A_0{}^2d^2 \tag{13}$$

$$P_2/C = k_{21}{}^2A_0{}^2d^2+k_{22}{}^2A_0{}^2+2k_{21}k_{22}A_0{}^2(I\cos\theta_1+Q\sin\theta_1) \tag{14}$$

$$P_3/C = k_{31}{}^2A_0{}^2d^2+k_{32}{}^2A_0{}^2+2k_{31}k_{32}A_0{}^2(I\cos\theta_2+Q\sin\theta_2) \tag{15}$$

For the baseband output signals P1, P2, and P3 obtained from these equations (13), (14), and (15), the computation based on the above equation (16) and equation (17) is carried out in the computation circuit 304 in the multi-port signal-to-IQ signal conversion circuit 1010, converted to the In-phase signal I(t) and the quadrature signal Q(t) as the demodulated signals, and output to the frequency error detection circuit 106 and the baseband signal processing circuit 107.

$$I(t) = h_{i0}+h_{i1}P_1+h_{i2}P_2+h_{i3}P_3 \tag{16}$$

$$Q(t) = h_{q0}+h_{q1}P_1+h_{q2}P_2+h_{q3}P_3 \tag{17}$$

$$h_{i0} = \frac{1}{2\sin(\theta_1 - \theta_2)}\left(-\frac{k_{22}}{k_{21}}\sin\theta_2 + \frac{k_{32}}{k_{31}}\cos\theta_2\right)$$

$$(18)$$

Here,

$$h_{i1} = \frac{1}{2A_0{}^2Ck_{11}{}^2\sin(\theta_1 - \theta_2)}\left(-\frac{k_{21}}{k_{22}}\sin\theta_2 + \frac{k_{31}}{k_{32}}\cos\theta_2\right)$$

$$(19)$$

$$h_{i2} = \frac{\sin \theta_2}{2A_0{}^2 Ck_{21}k_{22} \sin|\theta_1 - \theta_2|} \tag{20}$$

$$h_{i3} = - \frac{\cos \theta_2}{2A_0{}^2 Ck_{31}k_{32} \sin|\theta_1 - \theta_2|} \tag{21}$$

$$h_{q0} = \frac{1}{2 \sin(\theta_1 - \theta_2)} \left( \frac{k_{22}}{k_{21}} \sin \theta_1 - \frac{k_{32}}{k_{31}} \cos \theta_1 \right)$$

$$\tag{22}$$

$$h_{q1} = \frac{1}{2A_0{}^2 Ck_{11}{}^2 \sin(\theta_1 - \theta_2)} \left( \frac{k_{21}}{k_{22}} \sin \theta_1 - \frac{k_{31}}{k_{32}} \cos \theta_1 \right)$$

$$\tag{23}$$

$$h_{q2} = - \frac{\sin \theta_1}{2A_0{}^2 Ck_{21}k_{22} \sin|\theta_1 - \theta_2|} \tag{24}$$

$$h_{q3} = - \frac{\cos \theta_1}{2A_0{}^2 Ck_{31}k_{32} \sin|\theta_1 - \theta_2|} \tag{25}$$

As in the above explanation, using the circuit of the present invention, the demodulated signals I and Q can be obtained from the reception signal.

Further, the mean signal power computation circuit 102 receiving the output detection signal P1 of the power detector 1007 computes the mean signal power based on the following equation (26) and outputs the result to the gain control signal generation circuit 105 as a signal S102.

$$\overline{d^2} = \overline{h_{d1}P_1} \tag{26}$$

The gain control signal generation circuit 105 outputs the control signal S105 to the variable gain circuit 104 so that the reception signal levels input to the multi-port demodulator 101 become constant based on the mean power signal S102 found at the mean signal power computation circuit 102.

Then, the variable gain circuit 104 adjusts the level of the reception signal received at a not illustrated antenna element via the pre-select RF filter and the low noise amplifier to the level in accordance with the control signal S105 by the gain control signal generation circuit 105 and supplies the result to the multi-port demodulator 101.

Further, the frequency error detection circuit 106 receiving the output demodulated signals I and Q of the multi-port demodulator 101 detects the frequency error by the signals I and Q and supplies the result as a signal S106 to the local signal generation circuit 103.

The local signal generation circuit 103 receives the frequency error value signal S106 detected at the frequency error detection circuit 106, generates the local signal SO having the oscillation frequency substantially equal to the reception signal frequency, and supplies the result to the multi-port demodulator 101.

As explained above, according to the present embodiment, the multi-port demodulator 101 is configured by the first branch circuit 1001 for branching the reception signal to first to third three signals, the second branch circuit 1002 for branching the local signal to first and second two signals, the first phase shifter 1003 for shifting the first local signal from the second branch circuit 1002 by the shift amount $\theta1$, the second phase shifter 1004 for shifting the phase of the local signal from the second branch circuit 1002 by the shift amount $\theta2$, the first coupler circuit 1005 for coupling the second reception signal from the first branch circuit 1001 and the local signal shifted in phase with the shift amount $\theta1$ by the first phase shifter 1003, the second coupler circuit 1006 for coupling the third reception signal from the first branch circuit 1001 and the local signal shifted in phase with the shift amount $\theta2$ by the second phase shifter 1004, the first power detector 1007 for detecting the amplitude component of the first reception signal from the first branch circuit 1001, the second power detector 1008 for detecting the amplitude component of the vector sum signal from the first coupler circuit 1005, the third power detector 1009 for detecting the amplitude component of the vector sum signal from the second coupler circuit 1006, and the multi-port signal-to-IQ signal conversion circuit 1010 for receiving the output signals P1, P2, and P3 of the first to third power detectors 1007 to 1009 and converting the result to the In-phase signal I(t) and the quadrature signal Q(t) as the demodulated signals, so not is the characteristic feature of the multi-port system demodulator, that is, the wide band property, and the reduction of the local signal power contributed to, but also there is the following characteristic in comparison with the conventional multi-port demodulator.

Namely, in comparison with the conventional multi-port demodulator, it is possible to realize a further wide band property, low distortion characteristics, and low power consumption and to realize a high performance receiver having small fluctuations in characteristics with respect to fluctuations in temperature and aging.

Further, the circuit can be configured by three power detectors, one one-input three-output coupler circuit, one one-input two-output coupler circuit, and two phase shifters, so there are the advantages that the circuit configuration can be simplified more than the conventional circuit and an increase of the circuit size can be prevented.

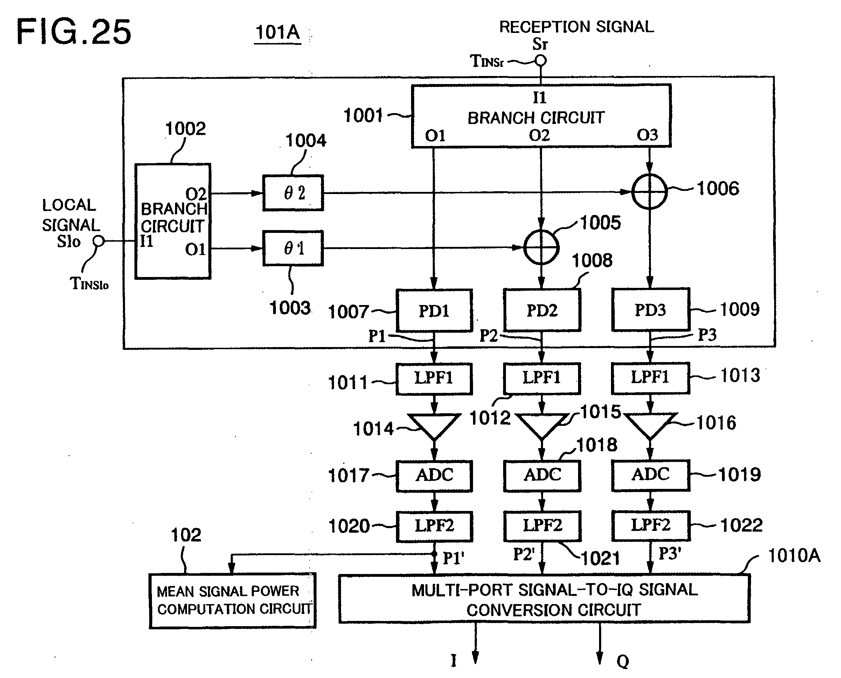

FIG. 25 is a block diagram of another embodiment of a multi-port demodulator according to the present invention.

In FIG. 25, the same components as those of the multi-port demodulator of FIG. 8 are represented by the same reference numerals.

The difference between a multi-port demodulator 101A of FIG. 25 and the multi-port demodulator 101 of FIG. 8 resides in that the processing of a multi-port signal-to-IQ signal conversion circuit 1010A is carried out not by analog processing, but by digital signal processing.

Specifically, as shown in FIG. 25, the outputs of the first power detector 1007, second power detector 1008, and third power detector 1009 have connected to them a first LPF 1011, a second LPF 1012, and a third LPF 1013 for removing high frequency signals from the baseband signals P1, P2, and P3 and the outputs of these LPFs 1011, 1012, and 1013 have connected to them amplifiers 1014, 1015, and 1016 for adjusting the signal amplitudes.

The outputs of the amplifiers 1014 to 1016 have connected to them a first analog/digital converter (ADC) 1017, a second ADC 1018, and a third ADC 1019 for converting analog signals to digital signals under suitable sampling frequencies.

The configuration is made so that the outputs of the first to third ADCs 1017, 1018, and 1019 are connected to the first to third digital LPFs 1020, 1021, and 1022 serving as channel selecting means for taking out only the desired channel signal from the digital baseband signals from the ADCs 1017, 1018, and 1019 and removing the other channel signals and so that the output signals P1', P2', and P3' of the digital LPFs 1020, 1021, and 1022 are input to the multi-port signal-to-IQ signal conversion circuit 1010A.

Note that, the LPFs 1011, 1012, and 1013 are provided in order to prevent aliasing occurring at the ADCs 1017, 1018, and 1019.

The multi-port signal-to-IQ signal conversion circuit 1010A performs computation based on the above equation (1) and equation (2) upon receipt of the output signals P1', P2', and P3' of the digital LPFs 1020, 1021, and 1022 and converts the result to the In-phase signal I(t) and the quadrature signal Q(t) as the demodulated signals.

Note that this digital multi-port signal-to-IQ signal conversion circuit 1010A can be realized by a DSP, an FPGA, a logic circuit, or the like.

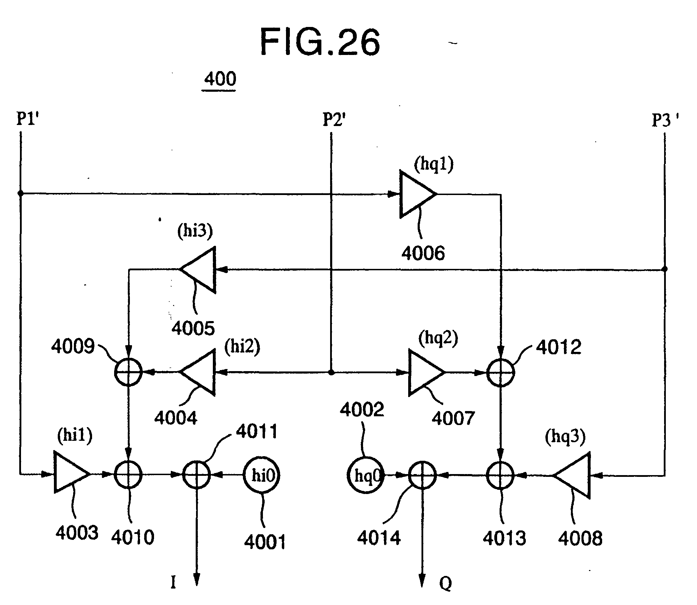

FIG. 26 is a circuit diagram of a concrete example of the configuration of the multi-port signal-to-IQ signal conversion circuit of FIG. 25.

A conversion circuit 400 is configured by, as shown in FIG. 26, a coefficient $h_{i0}$ generator 4001, a coefficient $h_{q0}$ generator 4002, a coefficient $h_{i1}$ use multiplier 4003, a coefficient $h_{i2}$ use multiplier 4004, a coefficient $h_{i3}$ use multiplier 4005, a coefficient $h_{q1}$ use multiplier 4006, a coefficient $h_{q2}$ use multiplier 4007, a coefficient $h_{q3}$ use multiplier 4008, and adders 4009 to 4014.

This computation circuit 404 multiplies the digital signal P1' having the channel selected at the LPF 1020 by the coefficient $h_{i1}$ at the multiplier 4003 and supplies the multiplication result $h_{i1}P_1$ to the adder 4010. Further, the digital signal P1' having the channel selected at the LPF 1020 is multiplied by the coefficient $h_{q1}$ at the multiplier 4006, and the multiplication result $h_{q1}P_1$ is supplied to the adder 4012.

The digital signal P2' having the channel selected at the LPF 1021 is multiplied by the coefficient $h_{i2}$ at the multiplier 4004, and the multiplication result $h_{i2}P_2$ is supplied to the adder 4009. Further, the digital signal P2' having the channel selected at the LPF 1021 is multiplied by the coefficient $h_{q2}$ at the multiplier 4007, and the multiplication result $h_{q2}P_2$ is supplied to the adder 4012.

Further, the digital signal P3' having the channel selected at the LPF 1023 is multiplied by the coefficient $h_{i3}$ at the multiplier 4005, and the multiplication result $h_{i3}P_3$ is supplied to the adder 4009. Further, the digital signal P3' having the channel selected at the LPF 1023 is multiplied by the coefficient $h_{q3}$ at the multiplier 4008, and the multiplication result $h_{q3}P_3$ is supplied to the adder 4013.

The adder 4009 adds the output $h_{i2}P_2$ of the multiplier 4004 and the output $h_{i3}P_3$ of the multiplier 4005 and supplies the result $(h_{i2}P_2+h_{i3}P_3)$ to the adder 4010. The adder 4010 adds the output $h_{i1}P_1$ of the adder 4003 and the output $(h_{i2}P_2+h_{i3}P_3)$ of the adder 4009 and supplies the result $(h_{i1}P_1+h_{i2}P_2+h_{i3}P_3)$ to the adder 4011. Then, the adder 4011 adds the coefficient $h_{i0}$ by the coefficient $h_{i0}$ generator 4001 and the output $(h_{i1}P_1+h_{i2}P_2+h_{i3}P_3)$ of the adder 4010 and obtains the In-phase signal $I(t) = h_{i0}+h_{i1}P_1+h_{i2}P_2+h_{i3}P_3$ shown in the above equation (1).

On the other hand, the adder 4012 adds the output $h_{q1}P_1$ of the multiplier 4006 and the output $h_{q2}P_2$ of the multiplier 4007 and supplies the result $(h_{q1}P_1+h_{q2}P_2)$ to the adder 4013. The adder 4013 adds the output $h_{q3}P_3$ of the adder 4008 and the output $(h_{q1}P_1+h_{q2}P_2)$ of the adder 4012 and supplies the result $(h_{q1}P_1+h_{q2}P_2+h_{q3}P_3)$ to the adder 4014. Then, the adder 4014 adds the coefficient $h_{q0}$ by the coefficient $h_{q0}$ generator 4002 and the output $(h_{q1}P_1+h_{q2}P_2+h_{q3}P_3)$ of the adder 4013 and obtains the quadrature signal $Q(t) = h_{q0}+h_{q1}P_1+h_{q2}P_2+h_{q3}P_3$ shown in the above equation (2).

According to this multi-port demodulator 100A, there are the advantages that a low power consumption, a low distortion, a wide band characteristic, and a high demodulation performance can be realized.

Note that in the embodiment of FIG. 25, the example where the two low pass filters of the LPF 1 and the digital LPF 2 were used was shown, but it is also possible if the LPF 1 in the previous stage of the ADC performs the channel select filtering in the analog region. In this case, LPF 2 becomes unnecessary.

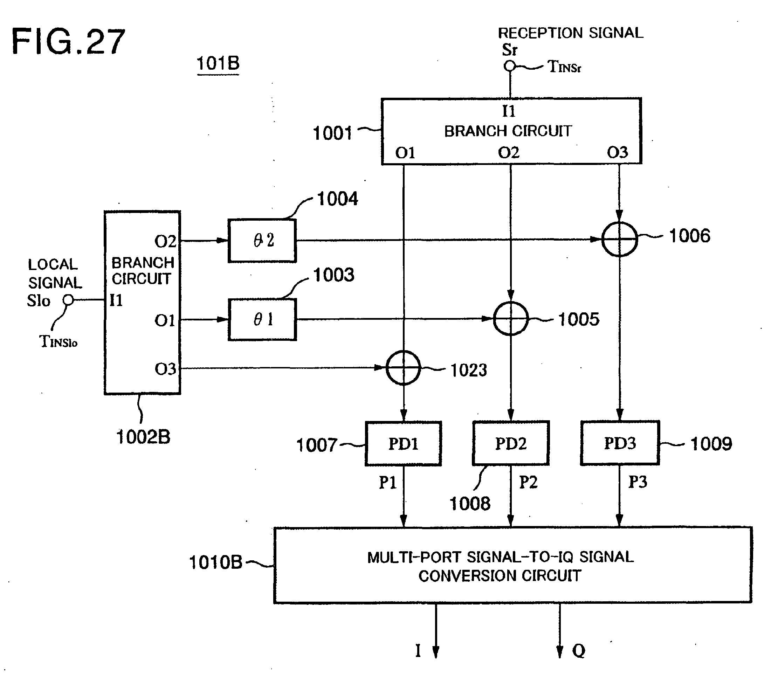

FIG. 27 is a block diagram of another embodiment of the multi-port demodulator according to the present invention.

In FIG. 27, the same components as those of the multi-port demodulator of FIG. 8 are represented by same reference numerals.

The difference between a multi-port demodulator 101B of FIG. 27 and the multi-port demodulator 101 of FIG. 8 resides in the configuration wherein a one-input three-output circuit is employed as the second branch circuit 1002B in place of the one-input two-output circuit and the third local signal and the first reception signal output from the first output terminal O1 of the first branch circuit 1001 are coupled at the third coupler circuit 1023 and supplied to the first power detector 1007.

Note that in the multi-port demodulator 101B of FIG. 27, a multi-port junction circuit 1000B is configured by a reception signal use first signal input terminal $T_{INSr}$, a local signal use second signal input terminal $T_{INSlo}$, a first branch circuit 1001, a second branch circuit 1002B, a first phase shifter 1003, a second phase shifter 1004, a first coupler circuit 1005, a second coupler circuit 1006, and a third coupler circuit 1023.

In the multi-port demodulator 101B having such a configuration, the reception signal Sr(t) is input to the first signal input terminal $T_{INSr}$. The reception signal Sr(t) is supplied to the input terminal I1 of the first branch circuit 1001 and branched to three signals. The branched first reception signal is output from the first output terminal O1 to the third coupler circuit 1023. The branched second reception signal is output from the second output terminal O2 to the first coupler circuit 1005. Then, the branched third reception signal is output from the third output terminal O3 to the second coupler circuit 1006.

On the other hand, the local signal SO(t) is input to the second signal input terminal $T_{INSlo}$. The local signal SO(t) is supplied to the input terminal I1 of the second branch circuit 1002B and branched to three signals. The branched first local signal is output from the first output terminal O1 to the first phase shifter 1003. The branched second local signal is output from the second output terminal O2 to the second phase shifter 1004. The branched third local signal is output from the third output terminal O3 to the third coupler circuit 1023.

The first phase shifter 1003 shifts the phase of the local signal output from the first output terminal O1 of the second branch circuit 1002B by exactly θ1 degrees and outputs the result to the first coupler circuit 1005. The second phase shifter 1004 shifts the phase of the local signal output from the second output terminal O2 of the second branch circuit 1002B by exactly θ2 degrees and outputs the result to the second coupler circuit 1006.

Then, the first coupler circuit 1005 couples the reception signal output from the second output terminal O2 of the first branch circuit 1001 and the local signal shifted in phase by exactly θ1 degrees by the first phase shifter 1003 and outputs the result to the second power detector 1008. The second coupler circuit 1006 couples the reception signal output from the third output terminal O3 of the first branch circuit 1001 and the local signal shifted in phase by exactly θ2 degrees by the second phase shifter 1004 and outputs the result to the third power detector 1009. The third coupler circuit 1023 couples the reception signal output from the first output terminal O1 of the first branch circuit 1001 and the local signal output from the third output terminal O3 of the second branch circuit 1002B and outputs the result to the first power detector 1007.

Accordingly, the input of the first power detector 1007 is supplied with the vector sum signal of the reception signal Sr(t) and the local signal SO(t). The first power detector 1007 outputs the amplitude component of the vector sum signal of the input reception signal Sr(t) and local signal SO(t) to the multi-port signal-to-IQ signal conversion circuit 1010B and the mean signal power generation circuit 102 as the detection signal P1.

Similarly, the input of the second power detector 1008 is supplied with the vector sum signal of the reception signal Sr(t) and the local signal SO(t) given the shift θ1. The second power detector 1008 outputs the amplitude component of the input vector sum signal of the reception signal Sr(t) and local signal SO(t) given the shift θ1 to the multi-port signal-to-IQ signal conversion circuit 1010B as the detection signal P2.

Similarly, the input of the third power detector 1009 is supplied with the vector sum signal of the reception signal Sr(t) and the local signal SO(t) given the shift θ2. The third power detector 1009 outputs the amplitude component of the input vector sum signal of the reception signal Sr(t) and local signal SO(t) given the shift θ2 to the multi-port signal-to-IQ signal conversion circuit 1010B as the detection signal P3.

Note that, the multi-port signal-to-IQ signal conversion circuit 1010B performs the computation based on the above equation (1) and equation (2) upon receipt of the output signals P1, P2, and P3 of the first power detectors 1007 to 1009 and converts the result to the In-phase signal I(t) and the quadrature signal Q(t) as the demodulated signals.

According to the multi-port demodulator of FIG. 27, there can be obtained similar effects to those of the demodulator of FIG. 8, that is, it is possible to realize a further wide band property, low distortion characteristic, and low power consumption in comparison with the conventional multi-port demodulator and to realize a high performance receiver having a small fluctuation of characteristics with respect to fluctuations in temperature and aging.

Further, the circuit can be configured by three power detectors, one one-input three-output coupler circuit, one one-input two-output coupler circuit, and two phase shifters, so there are the advantages that the circuit configuration can be simplified more than the conventional circuit and an increase of the circuit size can be prevented.

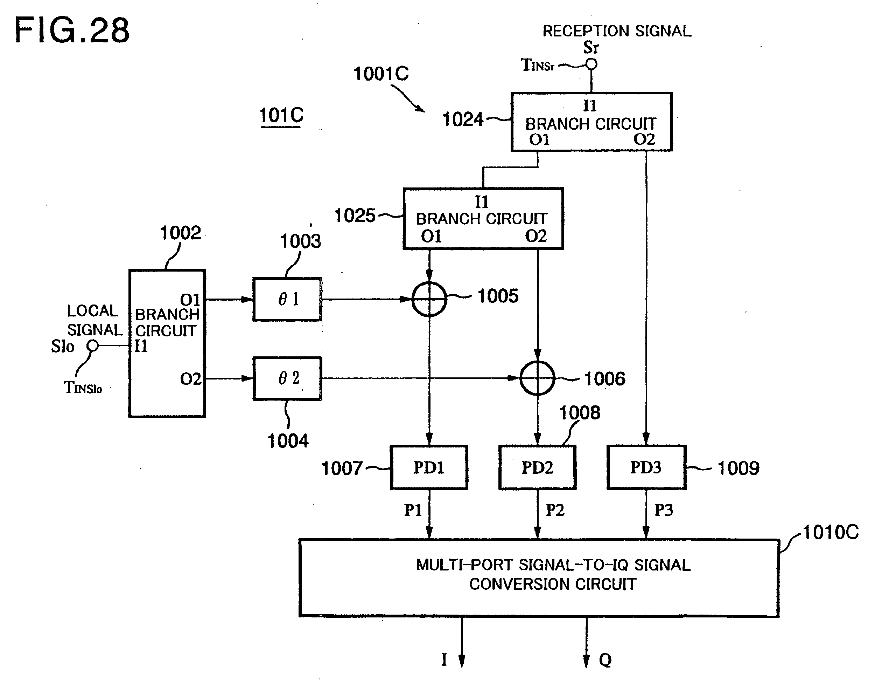

FIG. 28 is a block diagram of another embodiment of a multi-port demodulator according to the present invention.

In FIG. 28, the same components as those of the multi-port demodulator of FIG. 8 are represented by the same reference numerals.

A difference between a multi-port demodulator 101C of FIG. 28 and the multi-port demodulator 101 of FIG. 8 resides in that a configuration of one-input two-output branch circuits 1024 and 1025 connected in cascade is employed as the first branch circuit 1001C in place of a one-input three-output circuit.

Specifically, the input terminal I1 of the branch circuit (first branch circuit) 1024 is connected to the reception signal use signal input terminal $T_{INSr}$, the branch circuit 1024 branches the reception signal input via the input terminal I1 to two signals and outputs the branched first reception signal from the first output terminal O1 to the branch circuit 1025. The branch circuit 1024 supplies the branched second reception signal from the second output terminal O2 to the third power detector 1009.

The branch circuit (second branch circuit) 1025 branches the first reception signal input through the input terminal I1 to two signals. The branch circuit 1025 outputs the branched third reception signal from the first output terminal O1 to the first coupler circuit 1005. The branch circuit 1025 outputs the branched fourth reception signal from the second output terminal O2 to the second coupler circuit 1006.

Note that, in the multi-port demodulator 101C of FIG. 28, a multi-port junction circuit 1000C is configured by a reception signal use first signal input terminal $T_{INSr}$, a local signal use second signal input terminal $T_{INSlo}$, a branch circuit 1024, and a branch circuit 1025 configuring a first branch circuit 1001C, a second branch circuit 1002, a first phase shifter 1003, a second phase shifter 1004, a first coupler circuit 1005, and a second coupler circuit 1006.

In the multi-port demodulator 101C having such a configuration, the reception signal Sr(t) is input to the first signal input terminal $T_{INSr}$. The reception signal Sr(t) is supplied to the input terminal I1 of the branch circuit 1024 configuring the first branch circuit 1001C and branched to two signals. The branched first reception signal is output from the first output terminal O1 to the input terminal I1 of the branch circuit 1025. The branched second reception signal is supplied from the second output terminal O2 to the third power detector 1009.

The branch circuit 1025 branches the branched reception signal input through the input terminal I1 to two signals. The branched third reception signal is output from the first output terminal O1 to the first coupler circuit 1005. The branched fourth reception signal is output from the second output terminal O2 to the second coupler circuit 1006.

On the other hand, the local signal SO(t) is input to the second signal input terminal $T_{INSlo}$. The local signal So(t) is supplied to the input terminal I1 of the second branch circuit 1002 and branched to two signals. The branched first local signal is output from the first output terminal O1 to the first phase shifter 1003. The branched second local signal is output from the second output terminal O2 to the second phase shifter 1004.

The first phase shifter 1003 shifts the phase of the local signal output from the first output terminal O1 of the second branch circuit 1002 by exactly θ1 degrees and outputs the result to the first coupler circuit 1005. The second phase shifter 1004 shifts the phase of the local signal output from the second output terminal O2 of the second branch circuit 1002 by exactly θ2 degrees and outputs the result to the second coupler circuit 1006.

Then, the first coupler circuit 1005 couples the reception signal output from the first output terminal O1 of the branch circuit 1025 and the local signal shifted in phase by exactly θ1 degrees by the first phase shifter 1003 and outputs the result to the first power detector 1007. The second coupler circuit 1006 couples the reception signal output from the second output terminal O2 of the branch circuit 1025 and the local signal shifted in phase by exactly θ2 degrees by the second phase shifter 1004 and outputs the result to the second power detector 1008.

Accordingly, the input of the first power detector 1007 is supplied with the vector sum signal of the reception signal Sr(t) and the local signal SO(t) given the phase shift θ1. The first power detector 1007 outputs the amplitude component of the input vector sum signal of the reception signal Sr(t) and the local signal SO(t) given the phase shift θ1 to the multi-port signal-to-IQ signal conversion circuit 1010C as the detection signal P1.

Similarly, the input of the second power detector 1008 is supplied with the vector sum signal of the reception signal Sr(t) and the local signal SO(t) given the phase shift θ2. The first power detector 1008 outputs the amplitude component of the input vector sum signal of the reception signal Sr(t) and the local signal SO(t) given the phase shift θ2 to the multi-port signal-to-IQ signal conversion circuit 1010C as the detection signal P2.

Similarly, the input of the third power detector 1009 is supplied with the reception signal Sr(t). The third power detector 1009 outputs the amplitude component of the input reception signal Sr(t) as the detection signal P3 to the multi-port signal-to-IQ signal conversion circuit 1010C.

Note that the multi-port signal-to-IQ signal conversion circuit 1010C performs the computation based on the above equation (1) and equation (2) upon receipt of the output signals P1, P2, and P3 of the first power detectors 1007 to 1009 and converts the result to the In-phase signal I(t) and the quadrature signal Q(t) as the demodulated signals.

According to the multi-port demodulator of FIG. 28, there can be obtained similar effects to those of the demodulator of FIG. 8, that is, it is possible to realize a further wide band property, low distortion characteristic, and low power consumption in comparison with the conventional multi-port demodulator and to realize a high performance receiver having a small fluctuation of characteristics with respect to fluctuations in temperature and aging.

Further, the circuit can be configured by three power detectors, one one-input three-output coupler circuit, one one-input two-output coupler circuit, and two phase shifters, so there are the advantages that the circuit configuration can be simplified more than the conventional circuit and an increase of the circuit size can be prevented.

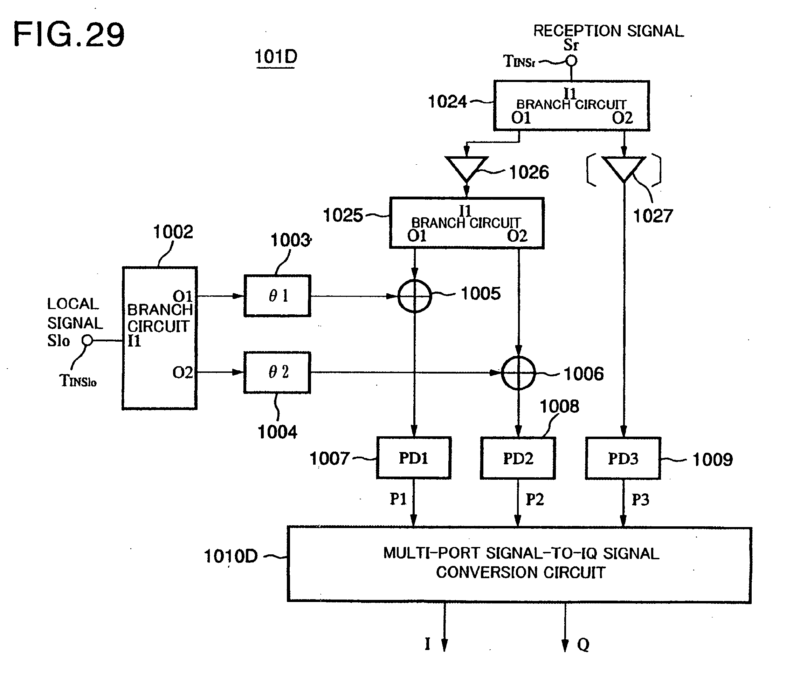

FIG. 29 is a block diagram of another embodiment of a multi-port demodulator according to the present invention.

In FIG. 29, the same components as those of the multi-port demodulator of FIG. 28 are represented by the same reference numerals.

A difference between a multi-port demodulator 101D of FIG. 29 and the multi-port demodulator 101C of FIG. 28 resides in that an amplifier 1026 is arranged between the first output terminal O1 of the branch circuit 1024 and the input terminal I1 of the branch circuit 1025 in order to obtain a larger isolation between the reception signal use signal input terminal $T_{INSr}$ and the local signal use signal input terminal $T_{INSlo}$.

Further, when the amplifier 1026 is used, the input signal level of the third power detector 1009 becomes low in comparison with the input signal level of the first power detectors 1007 and 1008. When considering the nonlinear characteristics of the power detectors, desirably the input signal levels of the three power detectors 1007 to 1009 are equal. From this, as shown in FIG. 29, the amplifier 1027 can be arranged on the output side of the branch circuit 1024 too.

Note that, in the multi-port demodulator 101D of FIG. 29, a multi-port junction circuit 1000D is configured by a reception signal use first signal input terminal $T_{INSr}$, a local signal use second signal input terminal $T_{INSlo}$, a branch circuit 1024, and a branch circuit 1025 configuring the first branch circuit 1001C, a second branch circuit 1002, a first phase shifter 1003, a second phase shifter 1004, a first coupler circuit 1005, a second coupler circuit 1006, and amplifiers 1026 and 1027.

The multi-port signal-to-IQ signal conversion circuit 1010D of the multi-port demodulator 101D having such a configuration performs the computation based on the above equation (1) and equation (2) upon receipt of the output signals P1, P2, and P3 of the first power detectors 1007 to 1009 and converts the result to the In-phase signal I(t) and the quadrature signal Q(t) as the demodulated signals.

According to the multi-port demodulator of FIG. 29, there can be obtained similar effects to those of the demodulator of FIG. 28, that is, it is possible to realize a further wide band property, low distortion characteristic, and low power consumption in comparison with the conventional multi-port demodulator and to realize a high performance receiver having a small fluctuation of characteristics with respect to fluctuations in temperature and aging.

Further, the circuit can be configured by three power detectors, one one-input three-output coupler circuit, one one-input two-output coupler circuit, and two phase shifters, so there are the advantages that the circuit configuration can be simplified more than the conventional circuit and an increase of the circuit size can be prevented.

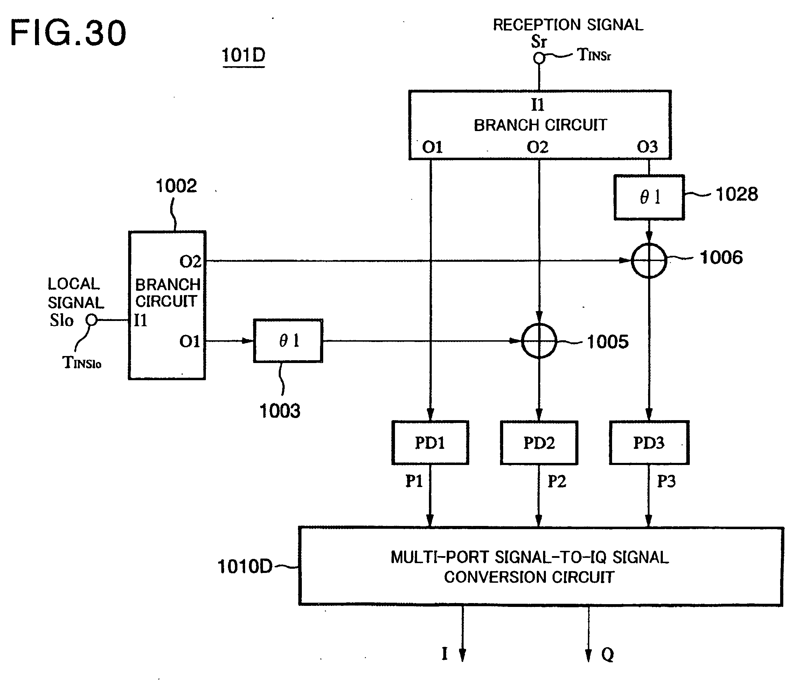

FIG. 30 is a block diagram of another embodiment of a multi-port demodulator according to the present invention.

In FIG. 30, the same components as those of the multi-port demodulator of FIG. 8 are represented by the same reference numerals.

A difference between a multi-port demodulator 101E of FIG. 30 and the multi-port demodulator 101C of FIG. 28 resides in a configuration wherein the second coupler circuit 1006 couple the second local signal branched at the second branch circuit 1002 and the reception signal shifted in phase by exactly θ1 instead of coupling the local signal shifted in phase by exactly θ2 and the reception signal and outputs the result to the third power detector 1009.

Specifically, the second phase shifter 1028 having the phase shift amount θ1 is arranged between the third output terminal O3 of the first branch circuit 1001 and one input terminal of the second coupler circuit 1006.

Note that, in the multi-port demodulator 101E of FIG. 30, a multi-port junction circuit 1000E is configured by a reception signal use first signal input terminal $T_{INSr}$, a local signal use second signal input terminal $T_{INSlo}$, a first branch circuit 1001, a second branch circuit 1002, a first phase shifter 1003, a first coupler circuit 1005, and a second phase shifter 1028.

In the multi-port demodulator 101E having such a configuration, the reception signal Sr(t) is input to the first signal input terminal $T_{INSr}$. The reception signal Sr(t) is supplied to the input terminal I1 of the first branch circuit 1001 and branched to three signals. The branched first reception signal is output from the first output terminal O1 to the first power detector 1007. The branched second reception signal is output from the second output terminal O2 to the first coupler circuit 1005. Then, the branched third reception signal is output from the third output terminal O3 to the second phase shifter 1028.

On the other hand, the local signal SO(t) is input to the second signal input terminal $T_{INSlo}$. The local signal So(t) is supplied to the input terminal I1 of the second branch circuit 1002 and branched to two signals. The branched first local signal is output from the first output terminal O1 to the first phase shifter 1003. The branched second local signal is output from the second output terminal O2 to the second coupler 1006.

The first phase shifter 1003 shifts the phase of the local signal output from the first output terminal O1 of the second branch circuit 1002 by exactly θ1 degrees and outputs the result to the first coupler circuit 1005. The second phase shifter 1028 shifts the phase of the reception signal output from the third output terminal O3 of the first branch circuit 1001 by exactly θ1 degrees and outputs the result to the second coupler circuit 1006.

Then, the first coupler circuit 1005 couples the reception signal output from the second output terminal O2 of the first branch circuit 1001 and the local signal shifted in phase by exactly θ1 degrees by the first phase shifter 1003 and outputs the result to the second power detector 1008. The second coupler circuit 1006 couples the local signal output from the second output terminal O2 of the second branch circuit 1002 and the reception signal shifted in phase by exactly θ1 degrees by the second phase shifter 1028 and outputs the result to the third power detector 1009.

Accordingly, the input of the first power detector 1007 is supplied with the reception signal Sr(t). The first power detector 1007 outputs the amplitude component of the input reception signal Sr(t) to the multi-port signal-to-IQ signal conversion circuit 1010E and the mean signal power generation circuit 102 as the detection signal P1.

Similarly, the input of the second power detector 1008 is supplied with the vector sum signal of the reception signal Sr(t) and the local signal SO(t) given the phase shift θ1. The second power detector 1008 outputs the amplitude component of the input vector sum signal of the reception signal Sr(t) and the local signal SO(t) given the phase shift θ1 to the multi-port signal-to-IQ signal conversion circuit 1010E as the detection signal P2.

Similarly, the input of the third power detector 1009 is supplied with the vector sum signal of the reception signal Sr(t) given the phase shift θ1 and the local signal SO(t). The third power detector 1009 outputs the amplitude component of the input vector sum signal of the reception signal Sr(t) given the phase shift θ1 and the local signal SO(t) as the detection signal P3 to the multi-port signal-to-IQ signal conversion circuit 1010E.

Note that, the multi-port signal-to-IQ signal conversion circuit 1010E performs the computation based on the above equation (1) and equation (2) upon receipt of the output signals P1, P2, and P3 of the first power detectors 1007 to 1009 and converts the result to the In-phase signal I(t) and the quadrature signal Q(t) as the demodulated signals.

According to the multi-port demodulator of FIG. 30, there can be obtained similar effects to those of the demodulator of FIG. 8, that is, it is possible to realize a further wide band property, low distortion characteristic, and low power consumption in comparison with the conventional multi-port demodulator and to realize a high performance receiver having a small fluctuation of characteristics with respect to fluctuations in temperature and aging.

Further, the circuit can be configured by three power detectors, one one-input three-output coupler circuit, one one-input two-output coupler circuit, and two phase shifters, so there are the advantages that the circuit configuration can be simplified more than the conventional circuit and an increase of the circuit size can be prevented.

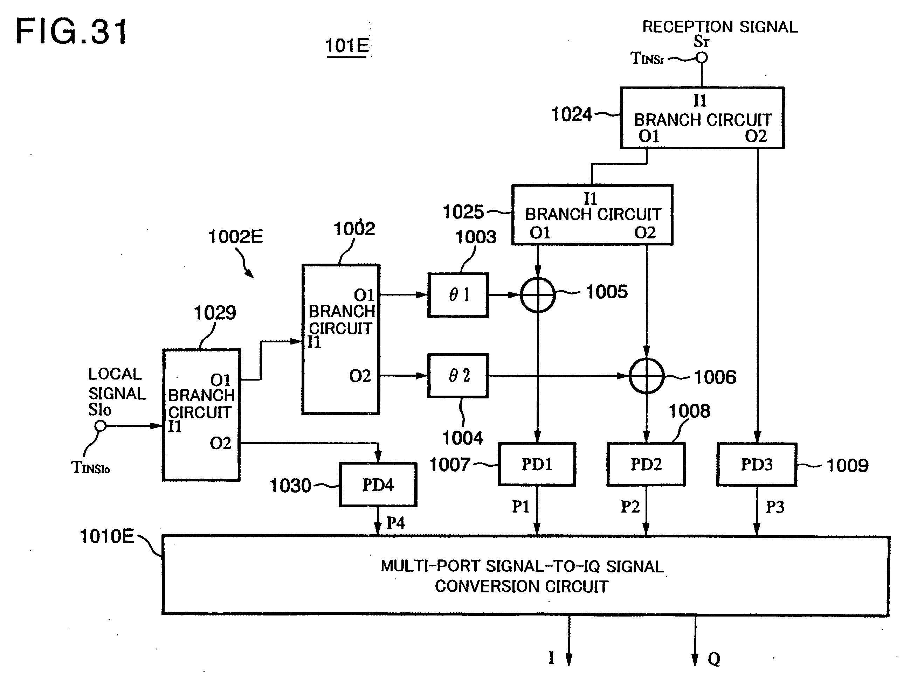

FIG. 31 is a block diagram of another embodiment of the multi-port demodulator according to the present invention.

In FIG. 31, the same components as those of the multi-port demodulator of FIG. 28 are represented by the same reference numerals.

A difference between a multi-port demodulator 101F of FIG. 31 and the multi-port demodulator 101C of FIG. 28 resides in that a configuration of one-input two-output branch circuit 1029 connected in cascade to the previous stage of the one-input two-output branch circuit 1002 in place of configuring the second branch circuit 1002F by one one-input two-output branch circuit was employed and further that the configuration was made so that a fourth power detector 1030 was provided and the amplitude component of the local signal branched by the branch circuit 1029 was output to the multi-port signal-to-IQ signal conversion circuit 1010F as the detection signal P4 .

Specifically, the input terminal I1 of the branch circuit (third branch circuit) 1029 is connected to the local signal use signal input terminal $T_{INSlo}$, and the branch circuit 1029 branches the local signal input via the input terminal I1 to two signals and outputs the branched first local signal from the first output terminal O1 to the branch circuit (fourth branch circuit) 1002. The branch circuit 1029 supplies the branched second local signal from the second output terminal O2 to the fourth power detector 1030.

Note that, in the multi-port demodulator 101F of FIG. 30, a multi-port junction circuit 1000F is configured by a reception signal use first signal input terminal $T_{INSr}$, a local signal use second signal input terminal $T_{INSlo}$, branch circuits 1024 and 1025 configuring the first branch circuit 1001, branch circuits 1002 and 1029 configuring the second branch circuit, a first phase shifter 1003, a second phase shifter 1004, a first coupler circuit 1005, and a second coupler circuit 1006.

In the multi-port demodulator 101F having such a configuration, the reception signal Sr(t) is input to the first signal input terminal $T_{INSr}$. The reception signal Sr(t) is supplied to the input terminal I1 of the branch circuit 1024 configuring the first branch circuit 1001E and branched to two signals. The branched first reception signal is output from the first output terminal O1 to the input terminal I1 of the branch circuit 1025. The branched second reception signal is supplied from the second output terminal O2 to the third power detector 1009.

The branch circuit 1025 branches the branched reception signal input through the input terminal I1 to two signals. The branched third reception signal is output from the first output terminal to the first coupler circuit 1005. The branched fourth reception signal is output from the second output terminal O2 to the second coupler circuit 1006.

On the other hand, the local signal SO(t) is input to the second signal input terminal $T_{INSlo}$. The local signal So(t) is supplied to the input terminal of the branch circuit 1029 and branched to two signals. The branched first local signal is output from the first output terminal O1 to the input terminal I1 of the branch circuit 1002. The branched second local signal is output from the second output terminal O2 to the fourth power detector 1030.

The branch circuit 1002 branches the branched local signal input through the input terminal I1 to two signals. The branched third local signal is output from the first output terminal O1 to the first phase shifter 1003. The branched fourth local signal is output from the second output terminal O2 to the second phase shifter 1004.

The first phase shifter 1003 shifts the phase of the local signal output from the first output terminal O1 of the branch circuit 1002 by exactly θ1 degrees and outputs the result to the first coupler circuit 1005. The second phase shifter 1004 shifts the phase of the local signal output from the second output terminal O2 of the branch circuit 1002 by exactly θ2 degrees and outputs the result to the second coupler circuit 1006.

Then, the first coupler circuit 1005 couples the reception signal output from the first output terminal O1 of the branch circuit 1025 and the local signal shifted in phase by exactly θ1 degrees by the first phase shifter 1003 and outputs the result to the first power detector 1007. The second coupler circuit 1006 couples the reception signal output from the second output terminal O2 of the branch circuit 1025 and the local signal shifted in phase by exactly θ2 degrees by the second phase shifter 1004 and outputs the result to the second power detector 1008.

Accordingly, the input of the first power detector 1007 is supplied with the vector sum signal of the reception signal Sr(t) and the local signal SO(t) given the phase shift θ1. The first power detector 1007 outputs the amplitude component of the input vector sum signal of the reception signal Sr(t) and the local signal SO(t) given the phase shift θ1 to the multi-port signal-to-IQ signal conversion circuit 1010F as the detection signal P1.

Similarly, the input of the second power detector 1008 is supplied with the vector sum signal of the reception signal Sr(t) and the local signal SO(t) given the phase shift θ2. The first power detector 1008 outputs the amplitude component of the input vector sum signal of the reception signal Sr(t) and the local signal SO(t) given the phase shift θ2 to the multi-port signal-to-IQ signal conversion circuit 1010F as the detection signal P2 .

Similarly, the input of the third power detector 1009 is supplied with the reception signal Sr(t). The third power detector 1009 outputs the amplitude component of the input reception signal Sr(t) as the detection signal P3 to the multi-port signal-to-IQ signal conversion circuit 1010F.

Similarly, the input of the fourth power detector 1030 is supplied with the local signal SO(t). The fourth power detector 1030 outputs the amplitude component of the input local signal SO(t) as the detection signal P4 to the multi-port signal-to-IQ signal conversion circuit 1010F.

Note that the multi-port signal-to-IQ signal conversion circuit 1010F performs the computation based on the following equation (27) upon receipt of the output signals P1, P2, P3, and P4 of the first power detectors 1007 to 1009 and converts the result to the In-phase signal I(t) and the quadrature signal Q(t) as the demodulated signals:

$$I = h_{i0} + h_{i1}(P_1/P_4) + h_{i2}(P_1/P_4) + h_{i3}(P_1/P_4) \qquad (27)$$

According to the multi-port demodulator of FIG. 31, there can be obtained similar effects to those of the demodulator of FIG. 8, that is, it is possible to realize a further wide band property, low distortion characteristic, and low power consumption in comparison with the conventional multi-port demodulator and to realize a high performance receiver having a small fluctuation of characteristics with respect to fluctuations in temperature and aging.

Further, according to the multi-port demodulator of FIG. 31, though there is a sacrifice in terms of the complexity of the circuit and the power consumption, there are the advantages that a high precision demodulation performance can be maintained even if fluctuation at a local power level due to for example aging or a fluctuation in temperature occurs.

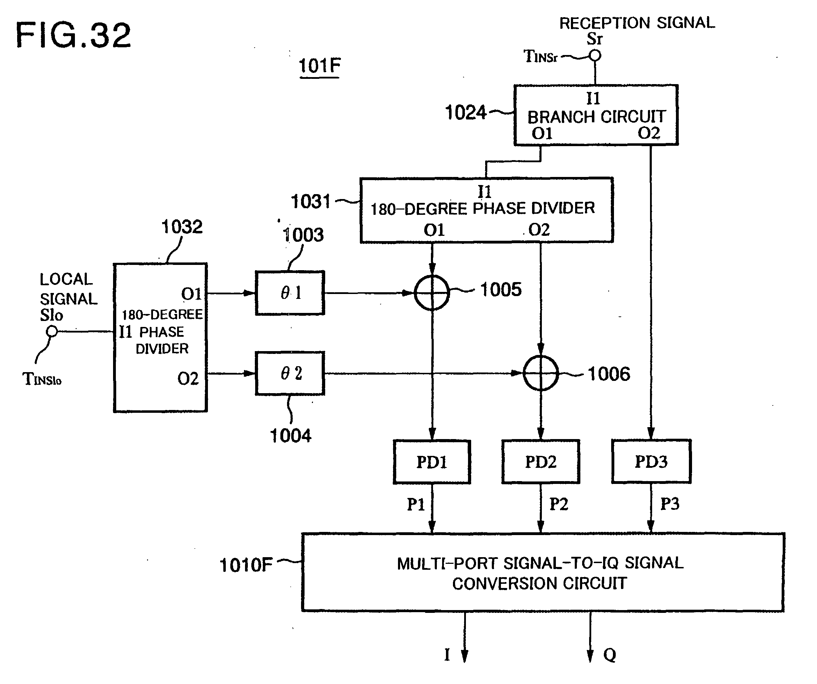

FIG. 32 is a block diagram of another embodiment of the multi-port demodulator according to the present invention.

In FIG. 32, the same components as those of the multi-port demodulator of FIG. 28 are represented by the same reference numerals.

A difference between a multi-port demodulator 101G of FIG. 32 and the multi-port demodulator 101C of FIG. 28 resides in that 180-degree phase dividers 1031 and 1032 are used in place of the one-input two-output branch circuit 1025 and second branch circuit 1002 configuring the first branch circuit 1001G.

The 180-degree phase dividers 1031 and 1032 have a function of transmitting output signals so that two output signals have relationships of equal amplitude and inverse phases.

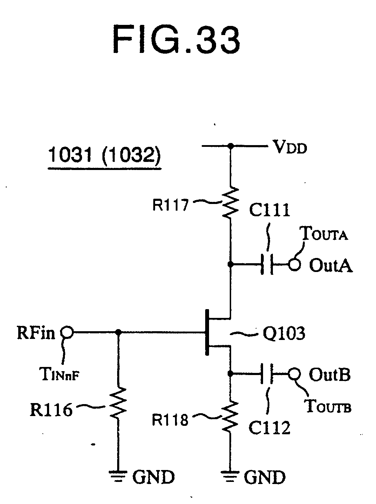

FIG. 33 is a circuit diagram of a concrete example of the configuration of the 180-degree phase dividers 1031 and 1032.

This 180-degree phase divider has, as shown in FIG. 33, a transistor Q103, resistance elements R116, R117, and R118, and capacitors C111 and C112.

The gate of the transistor Q103 is connected to an input terminal $T_{INRF}$ of the signal RFin and is connected via the resistance element R116 to the ground line GND. The drain of the transistor Q103 is connected via the resistance element R117 to the power supply voltage $V_{DD}$ supply line and connected to the first electrode of the capacitor C111. The second electrode of the capacitor C111 is connected to the first output terminal O1. The source of the transistor is connected via the resistance element R118 to the ground line GND and connected to the first electrode of the capacitor C112. The second electrode of the capacitor C112 is connected to the second output terminal O2.

In the 180-degree phase divider, the reception signal or local signal RFin input to the input terminal $T_{INRF}$ is supplied to the gate of the transistor Q103. Then, two signals having relationships of equal amplitude and inverse phases are generated by capacitors set to large capacitance values connected to the drain and source sides of the transistor, a signal OutA is output from the first output terminal O1, and a signal OutB is output from the second output terminal O2.

Note that in the multi-port demodulator 101G of FIG. 32, a multi-port junction circuit 1000G is configured by a reception signal use first signal input terminal $T_{INSr}$, a local signal use second signal input terminal $T_{INSlo}$, a first phase shifter 1003, a second phase shifter 1004, a first coupler circuit 1005, a second coupler circuit 1006, a branch circuit 1024, and 180-degree phase dividers 1031 and 1032.

In the multi-port demodulator 101G having such a configuration, the reception signal Sr(t) is input to the first signal input terminal $T_{INSr}$. The reception signal Sr(t) is supplied to the input terminal I1 of the branch circuit 1024 configuring the first branch circuit 1001G and branched to two signals. The branched first reception signal is output from the first output terminal O1 to the input terminal I1 of the 180-degree phase divider 1031. The branched second reception signal is supplied from the second output terminal O2 to the third power detector 1009.

The 180-degree phase divider 1031 generates two signals having relationships of equal amplitude and inverse phases from the branched reception signal input through the input terminal I1. The generated third reception signal is output from the first output terminal O1 to the first coupler circuit 1005. The fourth reception signal differing in phase from the generated third reception signal by 180 degrees is output from the second output terminal O2 to the second coupler circuit 1006.

On the other hand, the local signal SO(t) is input to the second signal input terminal $T_{INSlo}$. The local signal SO(t) is supplied to the input terminal I1 of the 180-degree phase divider 1032. The 180-degree phase divider 1032 generates two signals having relationships of equal amplitude and inverse phases from the local signal input through the input terminal I1. The generated first local signal is output from the first output terminal O1 to the first phase shifter 1003. The second local signal differing in phase from the first local signal by 180 degrees is output from the second output terminal O2 to the second phase shifter 1004.

The first phase shifter 1003 shifts the phase of the local signal output from the first output terminal O1 of the 180-degree phase divider 1032 by exactly θ1 degrees and outputs the result to the first coupler circuit 1005. The second phase shifter 1004 shifts the phase of the local signal output from the second output terminal O2 of the 180-degree phase divider 1032 by exactly θ2 degrees and outputs the result to the second coupler circuit 1006.

Then, the first coupler circuit 1005 couples the reception signal output from the first output terminal O1 of the branch circuit 1025 and the local signal shifted in phase by exactly θ1 degrees by the first phase shifter 1003 and outputs the result to the first power detector 1007. The second coupler circuit 1006 couples the reception signal output from the second output terminal O2 of the branch circuit 1025 and the local signal shifted in phase by exactly θ2 degrees by the second phase shifter 1004 and outputs the result to the second power detector 1008.

Accordingly, the input of the first power detector 1007 is supplied with the vector sum signal of the reception signal Sr(t) and the local signal SO(t) given the phase shift θ1. The first power detector 1007 outputs the amplitude component of the input vector sum signal of the reception signal Sr(t) and the local signal SO(t) given the phase shift θ1 to the multi-port signal-to-IQ signal conversion circuit 1010G as the detection signal P1.

Similarly, the input of the second power detector 1008 is supplied with the vector sum signal of the reception signal Sr(t) and the local signal SO(t) given the phase shift θ2. The first power detector 1008 outputs the amplitude component of the input vector sum signal of the reception signal Sr(t) and the local signal SO(t) given the phase shift θ2 to the multi-port signal-to-IQ signal conversion circuit 1010G as the detection signal P2.

Similarly, the input of the third power detector 1009 is supplied with the reception signal Sr(t). The third power detector 1009 outputs the amplitude component of the input reception signal Sr(t) as the detection signal P3 to the multi-port signal-to-IQ signal conversion circuit 1010G.

Note that the multi-port signal-to-IQ signal conversion circuit 1010G performs the computation based on the above equation (1) and equation (2) upon receipt of the output signals P1, P2, and P3 of the first power detectors 1007 to 1009 and converts the result to the In-phase signal I(t) and the quadrature signal Q(t) as the demodulated signals.

According to the multi-port demodulator of FIG. 32, there can be obtained similar effects to those of the demodulator of FIG. 8, that is, it is possible to realize a further wide band property, low distortion characteristic, and low power consumption in comparison with the conventional multi-port demodulator and to realize a high performance receiver having a small fluctuation of characteristics with respect to fluctuations in temperature and aging.

Further, the circuit can be configured by three power detectors, one one-input three-output coupler circuit, one one-input two-output coupler circuit, and two phase shifters, so there are the advantages that the circuit configuration can be simplified more than the conventional circuit and an increase of the circuit size can be prevented.

Next, an explanation will be given of a receiver provided with a phased array antenna portion and performing demodulation by a direct conversion system employing the demodulator according to the present invention.

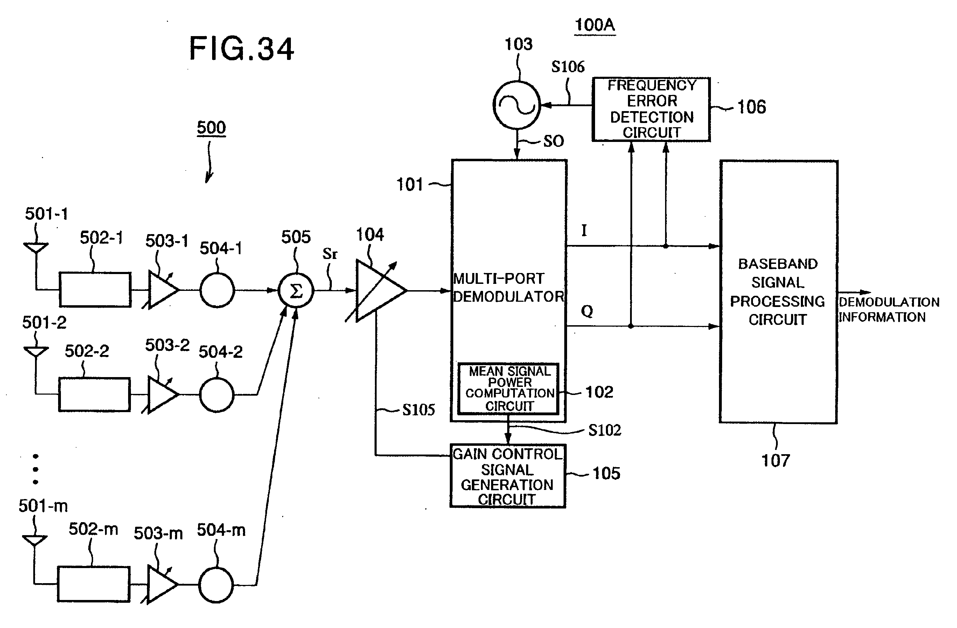

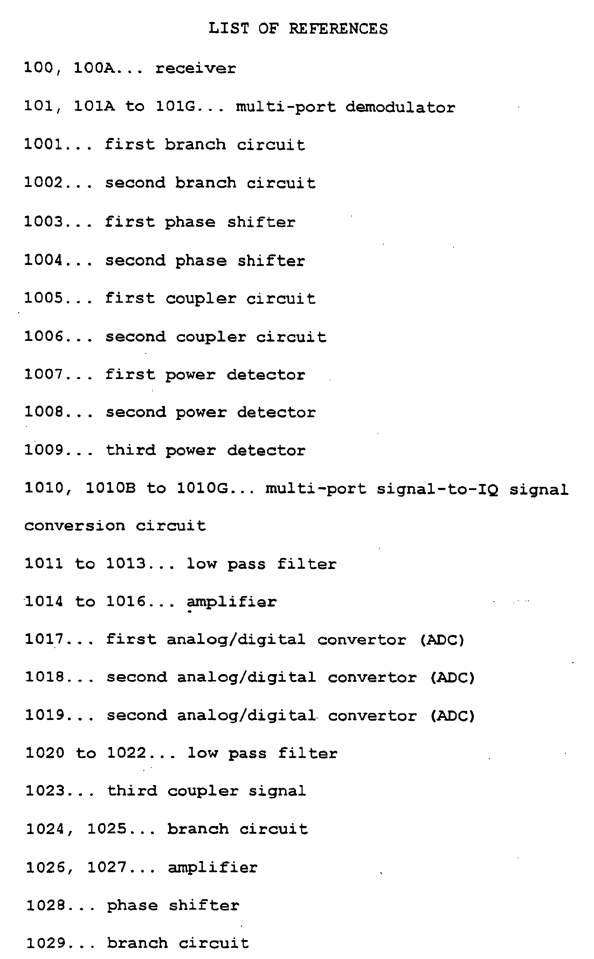

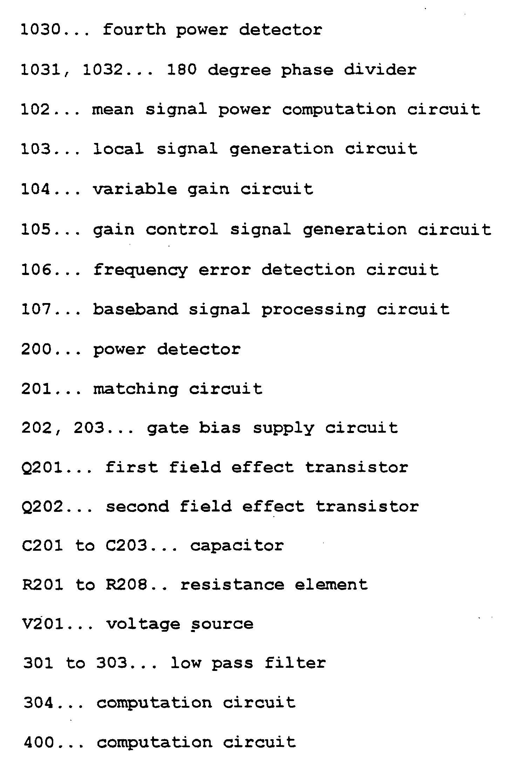

FIG. 34 is a view of the configuration of an embodiment of a receiver provided with the phased array antenna portion according to the present invention and performing the demodulation by the direct conversion system.

In this receiver 100A, a phased array antenna portion 500 is arranged at a previous stage of the variable gain circuit 104 of the receiver shown in FIG. 7.

The phased array antenna portion 500 is configured by m (m is an integer of 2 or more) number of antenna elements 501-1 to 501-m, m number of pre-select filters 502-1 to 502-m, m number of RF amplifiers 503-1 to 503-m, m number of variable phase circuits 504-1 to 504-m, and a signal combining circuit 505.

Then, in the phased array antenna portion 500, basically (in the reception mode) the configuration is made so that the pre-select filters 502-1 to 502-m, RF amplifiers 503-1 to 503-m, and variable phase circuits 504-1 to 504-m are cascade connected with the antenna elements 501-1 to 501-m and so that the output signals of the variable phase circuits 504-1 to 504-m are directly supplied to m number of input terminals of the signal combining circuit 505.

The m number of variable phase circuits 504-1 to 504-m are configured so as to change the phases of the reception signals with different values in the reception mode.

Note that, for the variable phase circuits 504-1 to 504-m, use is made of ones using for example PIN diodes or FETs (refer to for example Reference [5]: S. K Koul et al., Microwave and Millimeter Wave Phase Shifters; Volume II Semiconductor and Delay Line Phase Shifters, Artech House, 1991).

In such a configuration, in for example the reception mode, signals received by the antenna elements 501-1 to 501-m of the phased array antenna portion 2 pass through the pre-select filters 502-1 to 502-m, RF amplifiers 503-1 to 503-m, and variable phase circuits 504-1 to 504-m cascade connected with the antenna elements 501-1 to 501-m and are combined at the signal combining circuit 505.

The variable phase circuits 504-1 to 504-m of the phased array antenna portion 2 are controlled so as to change the phases of the reception signals with different values by a not illustrated phase control circuit.

The combined reception signal Sr combined at the signal combining circuit 25 and output is input to the multi-port junction circuit 1000 (or either of 1000A to 1000G) of the multi-port demodulator 101 (or either of 101A to 101G) through the reception signal use signal input terminal $T_{INSr}$.

Further, the multi-port junction circuit 1000 (or either of 1000A to 1000G) receives as input the local signal SO of the predetermined frequency generated at the local signal generation circuit 106 through the local signal use signal input terminal $T_{INSlo}$.

For example, at the multi-port demodulator 101, the reception signal Sr(t) is supplied to the input terminal I1 of the first branch circuit 1001 and branched to three signals. The branched first reception signal is supplied from the first output terminal O1 to the first power detector 1007. The branched second reception signal is output from the second output terminal O2 to the first coupler circuit 1005. Then, the branched third reception signal is output from the third output terminal O3 to the second coupler circuit 1006.

On the other hand, the local signal SO(t) is input to the second signal input terminal $T_{INSlo}$. So(t) is the voltage of the input terminal $T_{INSlo}$ at the time $\underline{t}$. The local So(t) is supplied to the input terminal I1 of the second branch circuit 1002 and branched to two signals. The branched first local signal is output from the first output terminal O1 to the first phase shifter 1003. The branched second local signal is output from the second output terminal O2 to the second phase shifter 1004.

The first phase shifter 1003 shifts the phase of the local signal output from the first output terminal O1 of the second branch circuit 1002 by exactly θ1 degrees and outputs the result to the first coupler circuit 1005. The second phase shifter 1004 shifts the phase of the local signal output from the second output terminal O2 of the second branch circuit 1002 by exactly θ2 degrees and outputs the result to the second coupler circuit 1006.

Then, the first coupler circuit 1005 couples the reception signal output from the second output terminal O2 of the first branch circuit 1001 and the local signal shifted in phase by exactly θ1 degrees by the first phase shifter 1003 and outputs the result to the second power detector 1008. The second coupler circuit 1006 couples the reception signal output from the third output terminal O3 of the first branch circuit 1001 and the local signal shifted in phase by exactly θ2 degrees by the second phase shifter 1004 and outputs the result to the third power detector 1009.

Accordingly, the input of the first power detector 1007 is supplied with the reception signal Sr(t). The first power detector 1007 outputs the amplitude component of the input reception signal Sr(t) to the multi-port signal-to-IQ signal conversion circuit 1010 and the mean signal power generation circuit 102 as the detection signal P1.

Similarly, the input of the second power detector 1008 is supplied with the vector sum signal of the reception signal Sr(t) and the local signal SO(t) given the phase shift θ1. The second power detector 1008 outputs the amplitude component of the input vector sum signal of the reception signal Sr(t) and the local signal SO(t) given the phase shift θ1 to the multi-port signal-to-IQ signal conversion circuit 1010 as the detection signal P2.

Similarly, the input of the third power detector 1009 is supplied with the vector sum signal of the reception signal Sr(t) and the local signal SO(t) given the phase shift θ2. The third power detector 1009 outputs the amplitude component of the input vector sum signal of the reception signal Sr(t) and the local signal SO(t) given the phase shift θ1 as the detection signal P3 to the multi-port signal-to-IQ signal conversion circuit 1010.

In the multi-port signal-to-IQ signal conversion circuit 1010, the computation circuit 304 performs computation based on equation (16) and equation (17) for the baseband output signals P1, P2, and P3, converts the result to the In-phase signal I(t) and the quadrature signal Q(t) as the demodulated signals, and outputs the result to the frequency error detection circuit 106 and the baseband signal processing circuit 107.

Further, the mean signal power computation circuit 102 receiving the output detection signal P1 of the power detector 1007 computes the mean signal power based on the above equation (26) and outputs the result as a signal S102 to the gain control signal generation circuit 105.

The gain control signal generation circuit 105 outputs the control signal S105 to the variable gain circuit 104 so that the reception signal levels input to the multi-port demodulator 101 become constant based on the mean power signal S102 found at the mean signal power computation circuit 102.

The variable gain circuit 104 adjusts the level of the reception signal received at the antenna element via the pre-select RF filter and the low noise amplifier to the level in accordance with the control signal S105 by the gain control signal generation circuit 105 and supplies the result to the multi-port demodulator 101.

Further, the frequency error detection circuit 106 receiving the output demodulated signals I and Q of the multi-port demodulator 101 detects the frequency error by the signals I and Q and supplies the result as a signal S106 to the local signal generation circuit 103.

The local signal generation circuit 103 generates the local signal SO having an oscillation frequency substantially equal to the reception signal frequency upon receipt of the frequency error value signal S106 detected at the frequency error detection circuit 106 and supplies it to the multi-port demodulator 101.

As explained above, in the receiver provided with the phased array antenna portion and performing demodulation by the direct conversion system employing the demodulator according to the present invention as well, there can be obtained the effect that it is possible to realize a further wide band property, low distortion characteristic, and low power consumption in comparison with the conventional multi-port demodulator and to realize a high performance receiver having a small fluctuation of characteristics with respect to fluctuations in temperature and aging.

Further, the circuit can be configured by three power detectors, one one-input three-output coupler circuit, one one-input two-output coupler circuit, and two phase shifters, so there are the advantages that the circuit configuration can be simplified more than the conventional circuit and an increase of the circuit size can be prevented.

INDUSTRIAL APPLICABILITY

As described above, according to the demodulator according to the present invention and the receiver using the same, not only can the characteristic features of the multi-port method demodulator, that is, the wide band property and reduction of the local signal power, be contributed to, but also it is possible to realize a further wide band property, low distortion characteristic, and low power consumption in comparison with the conventional multi-port demodulator and to realize a high performance demodulator and receiver having a small fluctuation of characteristics with respect to fluctuations in temperature and aging.

Further, according to the demodulator according to the present invention and the receiver using the same, the circuit configuration can be simplified more than the conventional circuit and an increase of the circuit size can be prevented.

**Claims**

1. A demodulator comprising:

     a first signal input terminal receiving as input a reception signal;
     a second signal input terminal receiving as input a local signal;
     a first branch circuit having an input terminal, a first output terminal, a second output terminal, and a third output terminal, the input terminal being connected to the first signal input terminal, branching the reception signal input to the input terminal to first, second, and third reception signals, outputting the first reception signal from the first output terminal, outputting the second reception signal from the second output terminal, and outputting the third reception signal from the third output terminal;
     a second branch circuit having an input terminal, a first output terminal, and a second output terminal, the input terminal being connected to the second signal input terminal, branching the local signal input to the input terminal to first and second local signals, outputting the first local signal from the first output terminal, and outputting the second local signal from the second output terminal;
     a first phase shifter for shifting a phase of the first local signal output from the first output terminal of the second branch circuit by exactly a predetermined amount and outputting the result;
     a second phase shifter for shifting a phase of the second local signal output from the second output terminal of the second branch circuit by exactly a predetermined amount and outputting the result;
     a first coupler circuit for coupling the second reception signal output from the second output terminal of the first branch circuit and the first local signal shifted in phase by exactly a predetermined amount output from the first phase shifter and outputting the result;
     a second coupler circuit for coupling the third reception signal output from the third output terminal of the first branch circuit and the second local signal shifted in phase by exactly a predetermined amount output from the second phase shifter and outputting the result;
     a first signal level detection circuit for detecting the level of the signal output from the first output terminal of the first branch circuit;
     a second signal level detection circuit for detecting the level of the signal output from the first coupler circuit; and
     a third signal level detection circuit for detecting the level of the signal output from the second coupler circuit.

2. A demodulator as set forth in claim 1, further comprising a conversion circuit for converting the output signal of the first signal level detection circuit, the output signal of the second signal level detection circuit, and the output signal of the third signal level detection circuit to a plurality of signal components included in the reception signal.

3. A demodulator as set forth in claim 2, wherein the conversion circuit includes:

     a first channel selecting means for selecting a desired channel from the output signal of the first signal level detection circuit,
     a second channel selecting means for selecting a desired channel from the output signal of the second signal level detection circuit,
     a third channel selecting means for selecting a desired channel from the output signal of the third signal level detection circuit, and
     a computation circuit for demodulating the In-phase component signal I and the quadrature component signal Q based on the output signal of the first channel selecting means, the output signal of the second channel selecting means, the output signal of the third channel selecting means, and predetermined circuit parameter constants.

4. A demodulator as set forth in claim 3, wherein the computation circuit obtains the In-phase component signal I and the quadrature component signal Q by computation based on the following equations:

$$I(t) = h_{i0} + h_{i1}P_1 + h_{i2}P_2 + h_{i3}P_3$$

$$Q(t) = h_{q0} + h_{q1}P_1 + h_{q2}P_2 + h_{q3}P_3$$

where, $P_1$ is the output signal of the first channel selecting means, $P_2$ is the output signal of the second channel selecting means, $P_3$ is the output signal of the third channel selecting means, and hik, hqk, k = 0, 1, 2, 3 are circuit parameter constants found from the circuit elements of the present demodulator.

5. A demodulator as set forth in claim 3, wherein at least one of the first channel selecting means, second channel selecting means, and third channel selecting means includes a low pass filter.

6. A demodulator as set forth in claim 4, wherein at least one of the first channel selecting means, second channel selecting means, and third channel selecting means includes a low pass filter.

7. A demodulator as set forth in claim 1, wherein at least one of the first signal level detection circuit, second signal level detection circuit, and third signal level detection circuit has:

a first field effect transistor having a gate supplied with the input signal,
a second field effect transistor having a source connected to a source of the first field effect transistor,
a first gate bias supply circuit for supplying a gate bias voltage to the gate of the first field effect transistor,
a second gate bias supply circuit for supplying a gate bias voltage to a gate of the second field effect transistor,
a current source connected to a connection point of sources of the first field effect transistor and second field effect transistor,
a drain bias supply circuit for supplying a drain bias voltage to drains of the first field effect transistor and second field effect transistor,
a first capacitor connected between the drain of the first field effect transistor and a reference potential, and
a second capacitor connected between the drain of the second field effect transistor and a reference potential, and
a voltage difference between the drain voltage of the first field effect transistor and the drain voltage of the second field effect transistor is defined as a detected output.

8. A demodulator as set forth in claim 7, wherein:

the first field effect transistor and second field effect transistor have substantially same characteristics,
the drain bias supply circuit includes a first drain bias use resistance element connected between the drain of the first field effect transistor and a voltage source and a second drain bias use resistance element connected between the drain of the second field effect transistor and a voltage source,
a resistance value of the first drain bias use resistance element and a resistance value of the second drain bias use resistance element being set at substantially equal values, and
a capacitance value of the first capacitor and a capacitance value of the second capacitor being set at substantially equal values.

9. A demodulator as set forth in claim 7, wherein:

a ratio Wga/Wgb of a gate width Wga of the first field effect transistor and a gate width Wgb of the second field effect transistor is set at N,
the drain bias supply circuit includes a first drain bias use resistance element connected between the drain of the first field effect transistor and a voltage source and a second drain bias use resistance element connected between the drain of the second field effect transistor and a voltage source,
a resistance value Ra of the first drain bias use resistance element and a resistance value Rb of the second drain bias use resistance element being set so as to satisfy a condition of Ra/Rb = 1/N, and

a capacitance value of the first capacitor and a capacitance value of the second capacitor being set at substantially equal values.

**10.** A demodulator comprising:

a first signal input terminal receiving as input a reception signal;

a second signal input terminal receiving as input a local signal;

a first branch circuit having an input terminal, a first output terminal, a second output terminal, and a third output terminal, the input terminal being connected to the first signal input terminal, branching the reception signal input to the input terminal to first, second, and third reception signals, outputting the first reception signal from the first output terminal, outputting the second reception signal from the second output terminal, and outputting the third reception signal from the third output terminal;

a second branch circuit having an input terminal, a first output terminal, and a second output terminal, the input terminal being connected to the second signal input terminal, branching the local signal input to the input terminal to first and second local signals, outputting the first local signal from the first output terminal, and outputting the second local signal from the second output terminal;

a first phase shifter for shifting a phase of the first local signal output from the first output terminal of the second branch circuit by exactly a predetermined amount and outputting the result;

a second phase shifter for shifting a phase of the second local signal output from the second output terminal of the second branch circuit by exactly a predetermined amount and outputting the result;

a first coupler circuit for coupling the second reception signal output from the second output terminal of the first branch circuit and the first local signal shifted in phase by exactly a predetermined amount output from the first phase shifter and outputting the result;

a second coupler circuit for coupling the third reception signal output from the third output terminal of the first branch circuit and the second local signal shifted in phase by exactly a predetermined amount output from the second phase shifter and outputting the result;

a first signal level detection circuit for detecting the level of the signal output from the first output terminal of the first branch circuit;

a second signal level detection circuit for detecting the level of the signal output from the first coupler circuit;

a third signal level detection circuit for detecting the level of the signal output from the second coupler circuit;

a first analog/digital converter for converting the output signal of the first signal level detection circuit from an analog signal to a digital signal;

a second analog/digital converter for converting the output signal of the second signal level detection circuit from an analog signal to a digital signal;

a third analog/digital converter for converting the output signal of the.third signal level detection circuit from an analog signal to a digital signal; and

a conversion circuit for converting the output digital signal of the first analog/digital converter, the output digital signal of the second analog/digital converter, and the output digital signal of the third analog/digital converter to a plurality of signal components included in the reception signal.

**11.** A demodulator as set forth in claim 10, further comprising:

a first filter for removing a high frequency component of the output signal of the first signal level detection circuit and inputting the result to the first analog/digital converter;

a second filter for removing the high frequency component of the output signal of the second signal level detection circuit and inputting the result to the second analog/digital converter; and

a third filter for removing the high frequency component of the output signal of the third signal level detection circuit and inputting the result to the third analog/digital converter, wherein

the conversion circuit includes:

a first channel selecting means for selecting a desired channel from the output signal of the first analog/digital converter,

a second channel selecting means for selecting a desired channel from the output signal of the second analog/digital converter,

a third channel selecting means for selecting a desired channel from the output signal of the third analog/digital converter, and

a computation circuit for demodulating the In-phase component signal I and the quadrature component signal Q based on the output signal of the first channel selecting means, the output signal of the second channel selecting means, the output signal of the third channel selecting means, and predetermined circuit parameter constants.

12. A demodulator as set forth in claim 11, wherein the computation circuit obtains the In-phase component signal I and the quadrature component signal Q by computation based on the following equations:

$$I(t) = h_{i0}+h_{i1}P_1+h_{i2}P_2+h_{i3}P_3$$

$$Q(t) = h_{q0}+h_{q1}P_1+h_{q2}P_2+h_{q3}P_3$$

where, $P_1$ is the output signal of the first channel selecting means, $P_2$ is the output signal of the second channel selecting means, $P_3$ is the output signal of the third channel selecting means, and hik, hqk, k = 0, 1, 2, 3 are circuit parameter constants found from the circuit elements of the present demodulator.

13. A demodulator as set forth in claim 11, wherein at least one of the first channel selecting means, second channel selecting means, and third channel selecting means includes a low pass filter.

14. A demodulator as set forth in claim 12, wherein at least one of the first channel selecting means, second channel selecting means, and third channel selecting means includes a low pass filter.

15. A demodulator as set forth in claim 10, further comprising:

a first channel selecting means for selecting a desired channel from the output signal of the first signal level detection circuit and inputting the result to the first analog/digital converter,
a second channel selecting means for selecting a desired channel from the output signal of the second signal level detection circuit and inputting the result to the second analog/digital converter, and
a third channel selecting means for selecting a desired channel from the output signal of the third signal level detection circuit and inputting the result to the third analog/digital converter, wherein
the conversion circuit includes a computation circuit for demodulating the In-phase component signal I and the quadrature component signal Q based on the output digital signal of the first analog/digital converter, the output digital signal of the second analog/digital converter, the output digital signal of the third analog/digital converter, and the predetermined circuit parameter constants.

16. A demodulator as set forth in claim 15, wherein the computation circuit obtains the In-phase component signal I and the quadrature component signal Q by computation based on the following equations:

$$I(t) = h_{i0}+h_{i1}P_1+h_{i2}P_2+h_{i3}P_3$$

$$Q(t) = h_{q0}+h_{q1}P_1+h_{q2}P_2+h_{q3}P_3$$

wherein, $P_1$ is the output signal of the first channel selecting means, $P_2$ is the output signal of the second channel selecting means, $P_3$ is the output signal of the third channel selecting means, and hik, hqk, k = 0, 1, 2, 3 are circuit parameter constants found from the circuit elements of the present demodulator.

17. A demodulator as set forth in claim 15, wherein at least one of the first channel selecting means, second channel selecting means, and third channel selecting means includes a-low pass filter.

18. A demodulator as set forth in claim 16, wherein at least one of the first channel selecting means, second channel selecting means, and third channel selecting means includes a low pass filter.

19. A demodulator as set forth in claim 10, wherein at least one of the first signal level detection circuit, second signal level detection circuit, and third signal level detection circuit has:

a first field effect transistor having a gate supplied with the input signal,

a second field effect transistor having a source connected to the source of the first field effect transistor,

a first gate bias supply circuit for supplying a gate bias voltage to a gate of the first field effect transistor,

a second gate bias supply circuit for supplying a gate bias voltage to a gate of the second field effect transistor,

a current source connected to a connection point of sources of the first field effect transistor and second field effect transistor,

a drain bias supply circuit for supplying a drain bias voltage to drains of the first field effect transistor and second field effect transistor,

a first capacitor connected between the drain of the first field effect transistor and a reference potential, and

a second capacitor connected between the drain of the second field effect transistor and a reference potential, and

a voltage difference between the drain voltage of the first field effect transistor and the drain voltage of the second field effect transistor is defined as a detected output.

20. A demodulator as set forth in claim 19, wherein:

the first field effect transistor and second field effect transistor have substantially same characteristics,

the drain bias supply circuit includes a first drain bias use resistance element connected between the drain of the first field effect transistor and a voltage source and a second drain bias use resistance element connected between the drain of the second field effect transistor and a voltage source,

a resistance value of the first drain bias use resistance element and a resistance value of the second drain bias use resistance element being set at substantially equal values, and

a capacitance value of the first capacitor and a capacitance value of the second capacitor being set at substantially equal values.

21. A demodulator as set forth in claim 19, wherein:

a ratio Wga/Wgb of a gate width Wga of the first field effect transistor and a gate width Wgb of the second field effect transistor is set at N,

the drain bias supply circuit includes a first drain bias use resistance element connected between the drain of the first field effect transistor and a voltage source and a second drain bias use resistance element connected between the drain of the second field effect transistor and a voltage source,

a resistance value Ra of the first drain bias use resistance element and a resistance value Rb of the second drain bias use resistance element being set so as to satisfy a condition of Ra/Rb = 1/N, and

a capacitance value of the first capacitor and a capacitance value of the second capacitor being set at substantially equal values.

22. A demodulator comprising:

a first signal input terminal receiving as input a reception signal;

a second signal input terminal receiving as input a local signal;

a first branch circuit having an input terminal, a first output terminal, a second output terminal, and a third output terminal, the input terminal being connected to the first signal input terminal, branching the reception signal input to the input terminal to first, second, and third reception signals, outputting the first reception signal from the first output terminal, outputting the second reception signal from the second output terminal, and outputting the third reception signal from the third output terminal;

a second branch circuit having an input terminal, a first output terminal, a second output terminal, and a third output terminal, the input terminal being connected to the second signal input terminal, branching the local signal input to the input terminal to first, second, and third local signals, outputting the first local signal from the first output terminal, outputting the second local signal from the second output terminal, and outputting the third local signal from the third output terminal;

a first phase shifter for shifting a phase of the first local signal output from the first output terminal of the second branch circuit by exactly a predetermined amount and outputting the result;

a second phase shifter for shifting a phase of the second local signal output from the second output terminal of the second branch circuit by exactly a predetermined amount and outputting the result;

a first coupler circuit for coupling the second reception signal output from the second output terminal of the first branch circuit and the first local signal shifted in phase by exactly a predetermined amount output from the first phase shifter and outputting the result;

a second coupler circuit for coupling the third reception signal output from the third output terminal of the first branch circuit and the second local signal shifted in phase by exactly a predetermined amount output from the second phase shifter and outputting the result;

a third coupler circuit for coupling the first reception signal output from the first output terminal of the first branch circuit and the third local signal output from the third output terminal of the second branch circuit and outputting the result;

a first signal level detection circuit for detecting the level of the signal output from the third coupler circuit;

a second signal level detection circuit for detecting the level of the signal output from the first coupler circuit; and

a third signal level detection circuit for detecting the level of the signal output from the second coupler circuit.

23. A demodulator as set forth in claim 22, further comprising a conversion circuit for converting the output signal of the first signal level detection circuit, the output signal of the second signal level detection circuit, and the output signal of the third signal level detection circuit to a plurality of signal components included in the reception signal.

24. A demodulator as set forth in claim 23, wherein the conversion circuit includes:

a first channel selecting means for selecting a desired channel from the output signal of the first signal level detection circuit,

a second channel selecting means for selecting a desired channel from the output signal of the second signal level detection circuit,

a third channel selecting means for selecting a desired channel from the output signal of the third signal level detection circuit, and

a computation circuit for demodulating the In-phase component signal I and the quadrature component signal Q based on the output signal of the first channel selecting means, the output signal of the second channel selecting means, the output signal of the third channel selecting means, and predetermined circuit parameter constants.

25. A demodulator as set forth in claim 24 wherein the computation circuit obtains the In-phase component signal I and the quadrature component signal Q by computation based on the following equations:

$$I(t) = h_{i0}+h_{i1}P_1+h_{i2}P_2+h_{i3}P_3$$

$$Q(t) = h_{q0}+h_{q1}P_1+h_{q2}P_2+h_{q3}P_3$$

wherein $P_1$ is the output signal of the first channel selecting means, $P_2$ is the output signal of the second channel selecting means, $P_3$ is the output signal of the third channel selecting means, and hik, hqk, k = 0, 1, 2, 3 are circuit parameter constants found from the circuit elements of the present demodulator.

26. A demodulator as set forth in claim 24, wherein at least one of the first channel selecting means, second channel selecting means, and third channel selecting means includes a low pass filter.

27. A demodulator as set forth in claim 25, wherein at least one of the first channel selecting means, second channel selecting means, and third channel selecting means includes a low pass filter.

28. A demodulator as set forth in claim 22, wherein at least one of the first signal level detection circuit, second signal level detection circuit, and third signal level detection circuit has:

a first field effect transistor having a gate supplied with the input signal,

a second field effect transistor having a source connected to a source of the first field effect transistor,

a first gate bias supply circuit for supplying a gate bias voltage to the gate of the first field effect transistor,

a second gate bias supply circuit for supplying a gate bias voltage to a gate of the second field effect transistor,

a current source connected to a connection point of sources of the first field effect transistor and second field effect transistor,

a drain bias supply circuit for supplying a drain bias voltage to drains of the first field effect transistor and second field effect transistor,

a first capacitor connected between the drain of the first field effect transistor and a reference potential, and

a second capacitor connected between the drain of the second field effect transistor and a reference potential, and
a voltage difference between the drain voltage of the first field effect transistor and the drain voltage of the second field effect transistor is defined as a detected output.

**29.** A demodulator as set forth in claim 28, wherein:

the first field effect transistor and second field effect transistor have substantially same characteristics,
the drain bias supply circuit includes a first drain bias use resistance element connected between the drain of the first field effect transistor and a voltage source and a second drain bias use resistance element connected between the drain of the second field effect transistor and a voltage source,
a resistance value of the first drain bias use resistance element and a resistance value of the second drain bias use resistance element being set at substantially equal values, and
a capacitance value of the first capacitor and a capacitance value of the second capacitor being set at substantially equal values.

**30.** A demodulator as set forth in claim 28, wherein:

a ratio Wga/Wgb of a gate width Wga of the first field effect transistor and a gate width Wgb of the second field effect transistor is set at N,
the drain bias supply circuit includes a first drain bias use resistance element connected between the drain of the first field effect transistor and a voltage source and a second drain bias use resistance element connected between the drain of the second field effect transistor and a voltage source,
a resistance value Ra of the first drain bias use resistance element and a resistance value Rb of the second drain bias use resistance element being set so as to satisfy a condition of Ra/Rb = 1/N, and
a capacitance value of the first capacitor and a capacitance value of the second capacitor being set at substantially equal values.

**31.** A demodulator comprising:

a first signal input terminal receiving as input a reception signal;
a second signal input terminal receiving as input a local signal;
a first branch circuit having an input terminal, a first output terminal, and a second output terminal, the input terminal being connected to the first signal input terminal, branching the reception signal input to the input terminal to first and second reception signals, outputting the first reception signal from the first output terminal, and outputting the second reception signal from the second output terminal;
a second branch circuit having an input terminal, a first output terminal, and a second output terminal, the input terminal being connected to the first output terminal of the first branch circuit, branching the reception signal input to the input terminal to third and fourth reception signals, outputting the third reception signal from the first output terminal, and outputting the fourth reception signal from the second output terminal;
a third branch circuit having an input terminal, a first output terminal, and a second output terminal, the input terminal being connected to the second signal input terminal, branching the local signal input to the input terminal to first and second local signals, outputting the first local signal from the first output terminal, and outputting the second local signal from the second output terminal;
a first phase shifter for shifting a phase of the first local signal output from the first output terminal of the third branch circuit by exactly a predetermined amount and outputting the result;
a second phase shifter for shifting a phase of the second local signal output from the second output terminal of the third branch circuit by exactly a predetermined amount and outputting the result;
a first coupler circuit for coupling the third reception signal output from the first output terminal of the second branch circuit and the first local signal shifted in phase by exactly a predetermined amount output from the first phase shifter and outputting the result;
a second coupler circuit for coupling the fourth reception signal output from the second output terminal of the second branch circuit and the second local signal shifted in phase by exactly a predetermined amount output from the second phase shifter and outputting the result;
a first signal level detection circuit for detecting the level of the signal output from the first coupler circuit;
a second signal level detection circuit for detecting the level of the signal output from the second coupler circuit; and
a third signal level detection circuit for detecting the level of the signal output from the second output terminal of the first branch circuit.

**32.** A demodulator as set forth in claim 31, further comprising a conversion circuit for converting the output signal of the first signal level detection circuit, the output signal of the second signal level detection circuit, and the output signal of the third signal level detection circuit to a plurality of signal components included in the reception signal.

**33.** A demodulator as set forth in claim 32, wherein the conversion circuit includes:

a first channel selecting means for selecting a desired channel from the output signal of the first signal level detection circuit,
a second channel selecting means for selecting a desired channel from the output signal of the second signal level detection circuit,
a third channel selecting means for selecting a desired channel from the output signal of the third signal level detection circuit, and
a computation circuit for demodulating the In-phase component signal I and the quadrature component signal Q based on the output signal of the first channel selecting means, the output signal of the second channel selecting means, the output signal of the third channel selecting means, and predetermined circuit parameter constants.

**34.** A demodulator as set forth in claim 33, wherein the computation circuit obtains the In-phase component signal I and the quadrature component signal Q by computation based on the following equations:

$$I(t) = h_{i0} + h_{i1}P_1 + h_{i2}P_2 + h_{i3}P_3$$

$$Q(t) = h_{q0} + h_{q1}P_1 + h_{q2}P_2 + h_{q3}P_3$$

wherein, $P_1$ is the output signal of the first channel selecting means, $P_2$ is the output signal of the second channel selecting means, $P_3$ is the output signal of the third channel selecting means, and hik, hqk, k = 0, 1, 2, 3 are circuit parameter constants found from the circuit elements of the present demodulator.

**35.** A demodulator as set forth in claim 33, wherein at least one of the first channel selecting means, second channel selecting means, and third channel selecting means includes a low pass filter.

**36.** A demodulator as set forth in claim 34, wherein at least one of the first channel selecting means, second channel selecting means, and third channel selecting means includes a low pass filter.

**37.** A demodulator as set forth in claim 31, wherein at least one of the first signal level detection circuit, second signal level detection circuit, and third signal level detection circuit has:

a first field effect transistor having a gate supplied with the input signal,
a second field effect transistor having a source connected to a source of the first field effect transistor,
a first gate bias supply circuit for supplying a gate bias voltage to the gate of the first field effect transistor,
a second gate bias supply circuit for supplying a gate bias voltage to a gate of the second field effect transistor,
a current source connected to a connection point of sources of the first field effect transistor and second field effect transistor,
a drain bias supply circuit for supplying a drain bias voltage to drains of the first field effect transistor and second field effect transistor,
a first capacitor connected between the drain of the first field effect transistor and a reference potential, and
a second capacitor connected between the drain of the second field effect transistor and a reference potential, and
a voltage difference between the drain voltage of the first field effect transistor and the drain voltage of the second field effect transistor is defined as a detected output.

**38.** A demodulator as set forth in claim 37, wherein:

the first field effect transistor and second field effect transistor have substantially same characteristics,
the drain bias supply circuit includes a first drain bias use resistance element connected between the drain of the first field effect transistor and a voltage source and a second drain bias use resistance element connected between the drain of the second field effect transistor and a voltage source,
a resistance value of the first drain bias use resistance element and a resistance value of the second drain bias use resistance element being set at substantially equal values, and
a capacitance value of the first capacitor and a capacitance value of the second capacitor being set at substantially equal values.

**39.** A demodulator as set forth in claim 37, wherein:

a ratio Wga/Wgb of a gate width Wga of the first field effect transistor and a gate width Wgb of the second field effect transistor is set at N,
the drain bias supply circuit includes a first drain bias use resistance element connected between the drain of the first field effect transistor and a voltage source and a second drain bias use resistance element connected between the drain of the second field effect transistor and a voltage source,
a resistance value Ra of the first drain bias use resistance element and a resistance value Rb of the second drain bias use resistance element being set so as to satisfy a condition of Ra/Rb = 1/N, and
a capacitance value of the first capacitor and a capacitance value of the second capacitor being set at substantially equal values.

**40.** A demodulator as set forth in claim 31, wherein an amplifier for amplifying the output signal from the first output terminal is connected to at least the first output terminal between the first output terminal and the second output terminal of the first branch circuit.

**41.** A demodulator comprising:

a first signal input terminal receiving as input a reception signal;
a second signal input terminal receiving as input a local signal;
a first branch circuit having an input terminal, a first output terminal, a second output terminal, and a third output terminal, the input terminal being connected to the first signal input terminal, branching the reception signal input to the input terminal to first, second, and third reception signals, outputting the first reception signal from the first output terminal, outputting the second reception signal from the second output terminal, and outputting the third reception signal from the third output terminal;
a second branch circuit having an input terminal, a first output terminal, and a second output terminal, the input terminal being connected to the second signal input terminal, branching the local signal input to the input terminal to first and second local signals, outputting the first local signal from the first output terminal, and outputting the second local signal from the second output terminal;
a first phase shifter for shifting a phase of the first local signal output from the first output terminal of the second branch circuit by exactly a predetermined amount and outputting the result;
a second phase shifter for shifting a phase of the third reception signal output from the third output terminal of the first branch circuit by exactly a predetermined amount and outputting the result;
a first coupler circuit for coupling the second reception signal output from the second output terminal of the first branch circuit and the first local signal shifted in phase by exactly a predetermined amount output from the first phase shifter and outputting the result;
a second coupler circuit for coupling the third reception signal shifted in phase by exactly a predetermined amount output from the second phase shifter and the second local signal output from the second branch circuit and outputting the result;
a first signal level detection circuit for detecting the level of the signal output from the first output terminal of the first branch circuit;
a second signal level detection circuit for detecting the level of the signal output from the first coupler circuit; and
a third signal level detection circuit for detecting the level of the signal output from the second coupler circuit.

**42.** A demodulator as set forth in claim 41, further comprising a conversion circuit for converting the output signal of the first signal level detection circuit, the output signal of the second signal level detection circuit, and the output signal of the third signal level detection circuit to a plurality of signal components included in the reception signal.

**43.** A demodulator as set forth in claim 42, wherein the conversion circuit includes:

a first channel selecting means for selecting a desired channel from the output signal of the first signal level detection circuit,

a second channel selecting means for selecting a desired channel from the output signal of the second signal level detection circuit,

a third channel selecting means for selecting a desired channel from the output signal of the third signal level detection circuit, and

a computation circuit for demodulating the In-phase component signal I and the quadrature component signal Q based on the output signal of the first channel selecting means, the output signal of the second channel selecting means, the output signal of the third channel selecting means, and predetermined circuit parameter constants.

44. A demodulator as set forth in claim 43, wherein the computation circuit obtains the In-phase component signal I and the quadrature component signal Q by computation based on the following equations:

$$I(t) = h_{i0} + h_{i1}P_1 + h_{i2}P_2 + h_{i3}P_3$$

$$Q(t) = h_{q0} + h_{q1}P_1 + h_{q2}P_2 + h_{q3}P_3$$

wherein, $P_1$ is the output signal of the first channel selecting means, $P_2$ is the output signal of the second channel selecting means, $P_3$ is the output signal of the third channel selecting means, and hik, hqk, k = 0, 1, 2, 3 are circuit parameter constants found from the circuit elements of the present demodulator.

45. A demodulator as set forth in claim 43, wherein at least one of the first channel selecting means, second channel selecting means, and third channel selecting means includes a low pass filter.

46. A demodulator as set forth in claim 44, wherein at least one of the first channel selecting means, second channel selecting means, and third channel selecting means includes a low pass filter.

47. A demodulator as set forth in claim 41, wherein at least one of the first signal level detection circuit, second signal level detection circuit, and third signal level detection circuit has:

a first field effect transistor having a gate supplied with the input signal,

a second field effect transistor having a source connected to a source of the first field effect transistor,

a first gate bias supply circuit for supplying a gate bias voltage to the gate of the first field effect transistor,

a second gate bias supply circuit for supplying a gate bias voltage to a gate of the second field effect transistor,

a current source connected to a connection point of sources of the first field effect transistor and second field effect transistor,

a drain bias supply circuit for supplying a drain bias voltage to drains of the first field effect transistor and second field effect transistor,

a first capacitor connected between the drain of the first field effect transistor and a reference potential, and

a second capacitor connected between the drain of the second field effect transistor and a reference potential, and

a voltage difference between the drain voltage of the first field effect transistor and the drain voltage of the second field effect transistor is defined as a detected output.

48. A demodulator as set forth in claim 47, wherein:

the first field effect transistor and second field effect transistor have substantially same characteristics,

the drain bias supply circuit includes a first drain bias use resistance element connected between the drain of the first field effect transistor and a voltage source and a second drain bias use resistance element connected between the drain of the second field effect transistor and a voltage source,

a resistance value of the first drain bias use resistance element and a resistance value of the second drain bias use resistance element being set at substantially equal values, and

a capacitance value of the first capacitor and a capacitance value of the second capacitor being set at substantially equal values.

49. A demodulator as set forth in claim 47, wherein:

a ratio Wga/Wgb of a gate width Wga of the first field effect transistor and a gate width Wgb of the second field effect transistor is set at N,

the drain bias supply circuit includes a first drain bias use resistance element connected between the drain of the first field effect transistor and a voltage source and a second drain bias use resistance element connected between the drain of the second field effect transistor and a voltage source,

a resistance value Ra of the first drain bias use resistance element and a resistance value Rb of the second drain bias use resistance element being set so as to satisfy a condition of Ra/Rb = 1/N, and

a capacitance value of the first capacitor and a capacitance value of the second capacitor being set at substantially equal values.

**50.** A demodulator comprising:

a first signal input terminal receiving as input a reception signal;

a second signal input terminal receiving as input a local signal;

a first branch circuit having an input terminal, a first output terminal, and a second output terminal, the input terminal being connected to the first signal input terminal, branching the reception signal input to the input terminal to first and second reception signals, outputting the first reception signal from the first output terminal, and outputting the second reception signal from the second output terminal;

a second branch circuit having an input terminal, a first output terminal, and a second output terminal, the input terminal being connected to the first output terminal of the first branch circuit, branching the reception signal input to the input terminal to third and fourth reception signals, outputting the third reception signal from the first output terminal, and outputting the fourth reception signal from the second output terminal;

a third branch circuit having an input terminal, a first output terminal, and a second output terminal, the input terminal being connected to the second signal input terminal, branching the local signal input to the input terminal to first and second local signals, outputting the first local signal from the first output terminal, and outputting the second local signal from the second output terminal;

a fourth branch circuit having an input terminal, a first output terminal, and a second output terminal, the input terminal being connected to the first output terminal of the third branch circuit, branching the local signal input to the input terminal to third and fourth local signals, outputting the third local signal from the first output terminal, and outputting the fourth local signal from the second output terminal;

a first phase shifter for shifting a phase of the third local signal output from the first output terminal of the fourth branch circuit by exactly predetermined amount and outputting the result;

a second phase shifter for shifting a phase of the fourth local signal output from the second output terminal of the fourth branch circuit by exactly a predetermined amount and outputting the result;

a first coupler circuit for coupling the third reception signal output from the first output terminal of the second branch circuit and the third local signal shifted in phase by exactly a predetermined amount output from the first phase shifter and outputting the result;

a second coupler circuit for coupling the fourth reception signal output from the second output terminal of the second branch circuit and the fourth local signal shifted in phase by exactly a predetermined amount output from the second phase shifter and outputting the result;

a first signal level detection circuit for detecting the level of the signal output from the first coupler circuit;

a second signal level detection circuit for detecting the level of the signal output from the second coupler circuit;

a third signal level detection circuit for detecting the level of the signal output from the second output terminal of the first branch circuit; and

a fourth signal level detection circuit for detecting the level of the signal output from the second output terminal of the third branch circuit.

**51.** A demodulator as set forth in claim 50, further comprising a conversion circuit for converting the output signal of the first signal level detection circuit, the output signal of the second signal level detection circuit, the output signal of the third signal level detection circuit, and the output signal of the fourth signal level detection circuit to a plurality of signal components included in the reception signal.

**52.** A demodulator as set forth in claim 51, wherein the conversion circuit obtains the In-phase component signal I and the quadrature component signal Q by computation based on the following equations:

$$I(t) = h_{i0} + h_{i1}P_1/P_4 + h_{i2}P_1/P_4 + h_{i3}P_1/P_4$$

$$Q(t) = h_{q0} + h_{q1}P_1/P_4 + h_{q2}P_1/P_4 + h_{q3}P_1/P_4$$

wherein, $P_1$ is the output signal of the first signal level detection circuit, and $P_4$ is the output signal of the fourth signal level detection circuit, and hik, hqk, k = 0, 1, 2, 3 are circuit parameter constants found from the circuit elements of the present demodulator.

53. A demodulator as set forth in claim 50, wherein at least one of the first signal level detection circuit, second signal level detection circuit, third signal level detection circuit, and fourth signal level detection circuit has:

a first field effect transistor having a gate supplied with the input signal,
a second field effect transistor having a source connected to a source of the first field effect transistor,
a first gate bias supply circuit for supplying a gate bias voltage to the gate of the first field effect transistor,
a second gate bias supply circuit for supplying a gate bias voltage to a gate of the second field effect transistor,
a current source connected to a connection point of sources of the first field effect transistor and second field effect transistor,
a drain bias supply circuit for supplying a drain bias voltage to drains of the first field effect transistor and second field effect transistor,
a first capacitor connected between the drain of the first field effect transistor and a reference potential, and
a second capacitor connected between the drain of the second field effect transistor and a reference potential, and
a voltage difference between the drain voltage of the first field effect transistor and the drain voltage of the second field effect transistor is defined as a detected output.

54. A demodulator as set forth in claim 53, wherein:

the first field effect transistor and second field effect transistor have substantially same characteristics,
the drain bias supply circuit includes a first drain bias use resistance element connected between the drain of the first field effect transistor and a voltage source and a second drain bias use resistance element connected between the drain of the second field effect transistor and a voltage source,
a resistance value of the first drain bias use resistance element and a resistance value of the second drain bias use resistance element being set at substantially equal values, and
a capacitance value of the first capacitor and a capacitance value of the second capacitor being set at substantially equal values.

55. A demodulator as set forth in claim 50, wherein:

a ratio Wga/Wgb of a gate width Wga of the first field effect transistor and a gate width Wgb of the second field effect transistor is set at N;
the drain bias supply circuit includes a first drain bias use resistance element connected between the drain of the first field effect transistor and a voltage source and a second drain bias use resistance element connected between the drain of the second field effect transistor and a voltage source,
a resistance value Ra of the first drain bias use resistance element and a resistance value Rb of the second drain bias use resistance element being set so as to satisfy a condition of Ra/Rb = 1/N, and
a capacitance value of the first capacitor and a capacitance value of the second capacitor being set at substantially equal values.

56. A demodulator as set forth in claim 50, wherein an amplifier for amplifying the output signal from the first output terminal is connected to at least the first output terminal between the first output terminal and the second output terminal of the first branch circuit.

57. A demodulator comprising:

a first signal input terminal receiving as input a reception signal;
a second signal input terminal receiving as input a local signal;
a branch circuit having an input terminal, a first output terminal, and a second output terminal, the input terminal being connected to the first signal input terminal, branching the reception signal input to the input terminal to first and second reception signals, outputting the first reception signal from the first output terminal, and outputting the second reception signal from the second output terminal;

a first phase divider having an input terminal, a first output terminal, and a second output terminal, the input terminal being connected to the first output terminal of the branch circuit, branching the reception signal input to the input terminal to third and fourth reception signals having inverse phases to each other, outputting the third reception signal from the first output terminal, and outputting the fourth reception signal from the second output terminal;

a second phase divider having an input terminal, a first output terminal, and a second output terminal, the input terminal being connected to the second signal input terminal, branching the local signal input to the input terminal to first and second local signals having inverse phases to each other, outputting the first local signal from the first output terminal, and outputting the second local signal from the second output terminal;

a first phase shifter for shifting a phase of the first local signal output from the first output terminal of the second phase divider by exactly a predetermined amount and outputting the result;

a second phase shifter for shifting a phase of the second local signal output from the second output terminal of the second phase divider by exactly a predetermined amount and outputting the result;

a first coupler circuit for coupling the third reception signal output from the first output terminal of the first phase divider and the first local signal shifted in phase by exactly a predetermined amount output from the first phase shifter and outputting the result;

a second coupler circuit for coupling the fourth reception signal output from the second output terminal of the first phase divider and the second local signal shifted in phase by exactly a predetermined amount output from the second phase shifter and outputting the result;

a first signal level detection circuit for detecting the level of the signal output from the first coupler circuit;

a second signal level detection circuit for detecting the level of the signal output from the second coupler circuit; and

a third signal level detection circuit for detecting the level of the signal output from the second output terminal of the branch circuit.

58. A demodulator as set forth in claim 57, further comprising a conversion circuit for converting the output signal of the first signal level detection circuit, the output signal of the second signal level detection circuit, and the output signal of the third signal level detection circuit to a plurality of signal components included in the reception signal.

59. A demodulator as set forth in claim 58, wherein the conversion circuit includes:

a first channel selecting means for selecting a desired channel from the output signal of the first signal level detection circuit,

a second channel selecting means for selecting a desired channel from the output signal of the second signal level detection circuit,

a third channel selecting means for selecting a desired channel from the output signal of the third signal level detection circuit, and

a computation circuit for demodulating the In-phase component signal I and the quadrature component signal Q based on the output signal of the first channel selecting means, the output signal of the second channel selecting means, the output signal of the third channel selecting means, and predetermined circuit parameter constants.

60. A demodulator as set forth in claim 59, wherein the computation circuit obtains the In-phase component signal I and the quadrature component signal Q by computation based on the following equations:

$$I(t) = h_{i0} + h_{i1}P_1 + h_{i2}P_2 + h_{i3}P_3$$

$$Q(t) = h_{q0} + h_{q1}P_1 + h_{q2}P_2 + h_{q3}P_3$$

wherein, $P_1$ is the output signal of the first channel selecting means, $P_2$ is the output signal of the second channel selecting means, $P_3$ is the output signal of the third channel selecting means, and hik, hqk, k = 0, 1, 2, 3 are circuit parameter constants found from the circuit elements of the present demodulator.

61. A demodulator as set forth in claim 59, wherein at least one of the first channel selecting means, second channel selecting means, and third channel selecting means includes a low pass filter.

**62.** A demodulator as set forth in claim 60, wherein at least one of the first channel selecting means, second channel selecting means, and third channel selecting means includes a low pass filter.

**63.** A demodulator as set forth in claim 57, wherein at least one of the first signal level detection circuit, second signal level detection circuit, and third signal level detection circuit has:

a first field effect transistor having a gate supplied with the input signal,
a second field effect transistor having a source connected to a source of the first field effect transistor,
a first gate bias supply circuit for supplying a gate bias voltage to the gate of the first field effect transistor,
a second gate bias supply circuit for supplying a gate bias voltage to a gate of the second field effect transistor,
a current source connected to a connection point of sources of the first field effect transistor and second field effect transistor,
a drain bias supply circuit for supplying a drain bias voltage to drains of the first field effect transistor and second field effect transistor,
a first capacitor connected between the drain of the first field effect transistor and a reference potential, and
a second capacitor connected between the drain of the second field effect transistor and a reference potential, and
a voltage difference between the drain voltage of the first field effect transistor and the drain voltage of the second field effect transistor is defined as a detected output.

**64.** A demodulator as set forth in claim 63, wherein:

the first field effect transistor and second field effect transistor have substantially same characteristics,
the drain bias supply circuit includes a first drain bias use resistance element connected between the drain of the first field effect transistor and a voltage source and a second drain bias use resistance element connected between the drain of the second field effect transistor and a voltage source,
a resistance value of the first drain bias use resistance element and a resistance value of the second drain bias use resistance element being set at substantially equal values, and
a capacitance value of the first capacitor and a capacitance value of the second capacitor being set at substantially equal values.

**65.** A demodulator as set forth in claim 63, wherein:

a ratio Wga/Wgb of a gate width Wga of the first field effect transistor and a gate width Wgb of the second field effect transistor is set at N,
the drain bias supply circuit includes a first drain bias use resistance element connected between the drain of the first field effect transistor and a voltage source and a second drain bias use resistance element connected between the drain of the second field effect transistor and a voltage source,
a resistance value Ra of the first drain bias use resistance element and a resistance value Rb of the second drain bias use resistance element being set so as to satisfy a condition of Ra/Rb = 1/N, and
a capacitance value of the first capacitor and a capacitance value of the second capacitor being set at substantially equal values.

**66.** A demodulator as set forth in claim 57, wherein an amplifier for amplifying the output signal from the first output terminal is connected to at least the first output terminal between the first output terminal and the second output terminal of the first branch circuit.

**67.** A receiver comprising:

a demodulator having a first signal input terminal receiving as input a reception signal, a second signal input terminal receiving as input a local signal, a first branch circuit having an input terminal, a first output terminal, a second output terminal, and a third output terminal, the input terminal being connected to the first signal input terminal, branching the reception signal input to the input terminal to first, second, and third reception signals, outputting the first reception signal from the first output terminal, outputting the second reception signal from the second output terminal, and outputting the third reception signal from the third output terminal, a second branch circuit having an input terminal, a first output terminal, and a second output terminal, the input terminal being connected to the second signal input terminal, branching the local signal input to the input terminal to first and second local signals, outputting the first local signal from the first output terminal, and outputting the second local signal from the second output terminal, a first phase shifter for shifting a phase of the first local signal output from the first output terminal of the second branch circuit by exactly a predetermined amount and outputting the result, a second phase shifter for shifting a phase of the second local signal output from the second output terminal of the second branch circuit by exactly a predetermined amount and outputting the result, a first coupler circuit for coupling the second reception signal output from the second output terminal of the first branch circuit and the first local signal shifted in phase by exactly a predetermined amount output from the first phase shifter and outputting the result, a second coupler circuit for coupling the third reception signal output from the third output terminal of the first branch circuit and the second local signal shifted in phase by exactly a predetermined amount output from the second phase shifter and outputting the result, a first signal level detection circuit for detecting the level of the signal output from the first output terminal of the first branch circuit, a second signal level detection circuit for detecting the level of the signal output from the first coupler circuit, a third signal level detection circuit for detecting the level of the signal output from the second coupler circuit, and a conversion circuit for converting the output signal of the first signal level detection circuit, the output signal of the second signal level detection circuit, and the output signal of the third signal level detection circuit to a plurality of signal components included in the reception signal;
a gain control circuit for adjusting the level of the reception signal to a desired level and supplying the result to the first signal input terminal of the demodulator; and
a local signal generation circuit for generating the local signal with a desired oscillation frequency and supplying the result to the second signal input terminal of the demodulator.

68. A receiver as set forth in claim 67, further comprising:

a mean signal power computation circuit receiving the output signal of the first signal level detection circuit of the demodulator and computing a mean signal power and
a gain control signal generation circuit for outputting the control signal to the variable gain circuit so that the reception signal levels input to the demodulator become constant based on the mean power found at the mean signal power computation circuit,
the variable gain circuit adjusting the input reception signal to the level in accordance with the control signal by the gain control signal generation circuit and supplying the result to the first signal input terminal of the demodulator.

69. A receiver as set forth in claim 68, wherein the mean signal power computation circuit obtains the mean signal power by computation based on the following signal:

$$\overline{d^2} = \overline{h_{d1}P_1}$$

wherein, $d^2$ is the reception signal power, and $h_{dk}$ and $k = 0, 1, 2, 3$ are the circuit parameter constants found from the circuit elements of the demodulator.

70. A receiver as set forth in claim 67, further comprising:

a frequency error detection circuit for detecting a frequency error based on a plurality of signal components obtained at the conversion circuit of the demodulator and supplying the result to the local signal generation circuit,
the local signal generation circuit setting an oscillation frequency of the local signal so as to become a frequency substantially equal to a carrier frequency of the reception signal based on the frequency error value detected at the frequency error detection circuit.

71. A receiver as set forth in claim 68, further comprising:

a frequency error detection circuit for detecting a frequency error based on a plurality of signal components obtained at the conversion circuit of the demodulator and supplying the result to the local signal generation circuit,
the local signal generation circuit setting an oscillation frequency of the local signal so as to become a frequency substantially equal to a carrier frequency of the reception signal based on the frequency error value detected at the frequency error detection circuit.

**72.** A receiver as set forth in claim 67, wherein the conversion circuit of the demodulator includes:

a first channel selecting means for selecting a desired channel from the output signal of the first signal level detection circuit,
a second channel selecting means for selecting a desired channel from the output signal of the second signal level detection circuit,
a third channel selecting means for selecting a desired channel from the output signal of the third signal level detection circuit, and
a computation circuit for demodulating the In-phase component signal I and the quadrature component signal Q based on the output signal of the first channel selecting means, the output signal of the second channel selecting means, the output signal of the third channel selecting means, and the predetermined circuit parameter constants.

**73.** A receiver as set forth in claim 72, wherein the computation circuit obtains the In-phase component signal I and the quadrature component signal Q by computation based on the following equations:

$$I(t) = h_{i0} + h_{i1}P_1 + h_{i2}P_2 + h_{i3}P_3$$

$$Q(t) = h_{q0} + h_{q1}P_1 + h_{q2}P_2 + h_{q3}P_3$$

wherein, $P_1$ is the output signal of the first channel selecting means, $P_2$ is the output signal of the second channel selecting means, $P_3$ is the output signal of the third channel selecting means, and hik, hqk, k = 0, 1, 2, 3 are circuit parameter constants found from the circuit elements of the present demodulator.

**74.** A receiver as set forth in claim 72, further comprising:

a mean signal power computation circuit receiving the output signal of the first signal level detection circuit of the demodulator and computing a mean signal power and
a gain control signal generation circuit for outputting the control signal to the variable gain circuit so that the reception signal levels input to the demodulator become constant based on the mean power found at the mean signal power computation circuit,
the variable gain circuit adjusting the input reception signal to the level in accordance with the control signal by the gain control signal generation circuit and supplying the result to the first signal input terminal of the demodulator.

**75.** A receiver as set forth in claim 74, wherein the mean signal power computation circuit obtains the mean signal power by computation based on the following signal:

$$\overline{d^2} = \overline{h_{d1}P_1}$$

wherein, $d^2$ is the reception signal power, and hdk and k = 0, 1, 2, 3 are the circuit parameter constants found from the circuit elements of the demodulator.

**76.** A receiver as set forth in claim 72, further comprising:

a frequency error detection circuit for detecting a frequency error based on the In-phase component signal I and the quadrature component signal Q obtained at the conversion circuit of the demodulator and supplying the result to the local signal generation circuit,
the local signal generation circuit setting an oscillation frequency of the local signal so as to become a frequency substantially equal to the carrier frequency of the reception signal based on the frequency error value detected at the frequency error detection circuit.

**77.** A receiver as set forth in claim 74, further comprising:

a frequency error detection circuit for detecting a frequency error based on the In-phase component signal I and the quadrature component signal Q obtained at the conversion circuit of the demodulator and supplying the result to the local signal generation circuit,

the local signal generation circuit setting an oscillation frequency of the local signal so as to become a frequency substantially equal to the carrier frequency of the reception signal based on the frequency error value detected at the frequency error detection circuit.

**78.** A receiver as set forth in claim 72, wherein at least one of the first channel selecting means, second channel selecting means, and third channel selecting means includes a low pass filter.

**79.** A receiver as set forth in claim 73, wherein at least one of the first channel selecting means, second channel selecting means, and third channel selecting means includes a low pass filter.

**80.** A receiver as set forth in claim 67, wherein at least one of the first signal level detection circuit, second signal level detection circuit, and third signal level detection circuit of the demodulator has:

a first field effect transistor having a gate supplied with the input signal,

a second field effect transistor having a source connected to a source of the first field effect transistor,

a first gate bias supply circuit for supplying a gate bias voltage to the gate of the first field effect transistor,

a second gate bias supply circuit for supplying a gate bias voltage to a gate of the second field effect transistor,

a current source connected to a connection point of sources of the first field effect transistor and second field effect transistor,

a drain bias supply circuit for supplying a drain bias voltage to drains of the first field effect transistor and second field effect transistor,

a first capacitor connected between the drain of the first field effect transistor and a reference potential, and

a second capacitor connected between the drain of the second field effect transistor and a reference potential, and

a voltage difference between the drain voltage of the first field effect transistor and the drain voltage of the second field effect transistor is defined as a detected output.

**81.** A receiver as set forth in claim 80, wherein:

the first field effect transistor and second field effect transistor have substantially same characteristics,

the drain bias supply circuit includes a first drain bias use resistance element connected between the drain of the first field effect transistor and a voltage source and a second drain bias use resistance element connected between the drain of the second field effect transistor and a voltage source,

a resistance value of the first drain bias use resistance element and a resistance value of the second drain bias use resistance element being set at substantially equal values, and

a capacitance value of the first capacitor and a capacitance value of the second capacitor being set at substantially equal values.

**82.** A receiver as set forth in claim 80, wherein:

a ratio $Wga/Wgb$ of a gate width $Wga$ of the first field effect transistor and a gate width $Wgb$ of the second field effect transistor is set at N,

the drain bias supply circuit includes a first drain bias use resistance element connected between the drain of 'the first field effect transistor and a voltage source and a second drain bias use resistance element connected between the drain of the second field effect transistor and a voltage source,

a resistance value $Ra$ of the first drain bias use resistance element and a resistance value $Rb$ of the second drain bias use resistance element being set so as to satisfy a condition of $Ra/Rb = 1/N$, and

a capacitance value of the first capacitor and a capacitance value of the second capacitor being set at substantially equal values.

**83.** A receiver comprising:

a demodulator having a first signal input terminal receiving as input a reception signal, a second signal input terminal receiving as input a local signal, a first branch circuit having an input terminal, a first output terminal, a second output terminal, and a third output terminal, the input terminal being connected to the first signal input terminal, branching the reception signal input to the input terminal to first, second, and third reception signals, outputting the first reception signal from the first output terminal, outputting the second reception signal from the second output terminal, and outputting the third reception signal from the third output terminal, a second branch circuit having an input terminal, a first output terminal, and a second output terminal, the input terminal being connected to the second signal input terminal, branching the local signal input to the input terminal to first and second local signals, outputting the first local signal from the first output terminal, and outputting the second local signal from the second output terminal, a first phase shifter for shifting a phase of the first local signal output from the first output terminal of the second branch circuit by exactly a predetermined amount and outputting the result, a second phase shifter for shifting a phase of the second local signal output from the second output terminal of the second branch circuit by exactly a predetermined amount and outputting the result, a first coupler circuit for coupling the second reception signal output from the second output terminal of the first branch circuit and the first local signal shifted in phase by exactly a predetermined amount output from the first phase shifter and outputting the result, a second coupler circuit for coupling the third reception signal output from the third output terminal of the first branch circuit and the second local signal shifted in phase by exactly a predetermined amount output from the second phase shifter and outputting the result, a first signal level detection circuit for detecting the level of the signal output from the first output terminal of the first branch circuit, a second signal level detection circuit for detecting the level of the signal output from the first coupler circuit, a third signal level detection circuit for detecting the level of the signal output from the second coupler circuit, a first analog/digital converter for converting the output signal of the first signal level detection circuit from an analog signal to a digital signal, a second analog/digital converter for converting the output signal of the second signal level detection circuit from an analog signal to a digital signal, a third analog/digital converter for converting the output signal of the third signal level detection circuit from an analog signal to a digital signal, and a conversion circuit for converting the output digital signal of the first analog/digital converter, the output digital signal of the second analog/digital converter, and the output digital signal of the third analog/digital converter to a plurality of signal components included in the reception signal;

a gain control circuit for adjusting the level of the reception signal to a desired level and supplying the result to the first signal input terminal of the demodulator; and

a local signal generation circuit for generating the local signal with a desired oscillation frequency and supplying the result to the second signal input terminal of the demodulator.

84. A receiver as set forth in claim 83, further comprising:

a mean signal power computation circuit receiving the output signal of the first signal level detection circuit of the demodulator and computing a mean signal power and

a gain control signal generation circuit for outputting the control signal to the variable gain circuit so that the reception signal levels input to the demodulator become constant based on the mean power found at the mean signal power computation circuit,

the variable gain circuit adjusting the input reception signal to the level in accordance with the control signal by the gain control signal generation circuit and supplying the result to the first signal input terminal of the demodulator.

85. A receiver as set forth in claim 84, wherein the mean signal power computation circuit obtains the mean signal power by computation based on the following signal:

$$\overline{d^2} = \overline{h_{d1}P_1}$$

wherein, $d^2$ is the reception signal power, and hdk and k = 0, 1, 2, 3 are the circuit parameter constants found from the circuit elements of the demodulator.

86. A receiver as set forth in claim 83, further comprising:

a frequency error detection circuit for detecting a frequency error based on a plurality of signal components obtained at the conversion circuit of the demodulator and supplying the result to the local signal generation circuit,

the local signal generation circuit setting an oscillation frequency of the local signal so as to become a frequency substantially equal to a carrier frequency of the reception signal based on the frequency error value detected at the frequency error detection circuit.

**87.** A receiver as set forth in claim 84, further comprising:

a frequency error detection circuit for detecting a frequency error based on a plurality of signal components obtained at the conversion circuit of the demodulator and supplying the result to the local signal generation circuit,
the local signal generation circuit setting an oscillation frequency of the local signal so as to become a frequency substantially equal to a carrier frequency of the reception signal based on the frequency error value detected at the frequency error detection circuit.

**88.** A receiver as set forth in claim 83, wherein the demodulator further has:

a first filter for removing a high frequency component of the output signal of the first signal level detection circuit and inputting the result to the first analog/digital converter;
a second filter for removing the high frequency component of the output signal of the second signal level detection circuit and inputting the result to the second analog/digital converter; and
a third filter for removing the high frequency component of the output signal of the third signal level detection circuit and inputting the result to the third analog/digital converter, wherein
the conversion circuit includes:

a first channel selecting means for selecting a desired channel from the output signal of the first analog/digital converter,
a second channel selecting means for selecting a desired channel from the output signal of the second analog/digital converter,
a third channel selecting means for selecting a desired channel from the output signal of the third analog/digital converter, and
a computation circuit for demodulating the In-phase component signal I and the quadrature component signal Q based on the output signal of the first channel selecting means, the output signal of the second channel selecting means, the output signal of the third channel selecting means, and predetermined circuit parameter constants.

**89.** A receiver as set forth in claim 88, wherein the computation circuit obtains the In-phase component signal I and the quadrature component signal Q by computation based on the following equations:

$$I(t) = h_{i0} + h_{i1}P_1 + h_{i2}P_2 + h_{i3}P_3$$

$$Q(t) = h_{q0} + h_{q1}P_1 + h_{q2}P_2 + h_{q3}P_3$$

wherein, $P_1$ is the output signal of the first channel selecting means, $P_2$ is the output signal of the second channel selecting means, $P_3$ is the output signal of the third channel selecting means, and hik, hqk, k = 0, 1, 2, 3 are circuit parameter constants found from the circuit elements of the present demodulator.

**90.** A receiver as set forth in claim 88, further comprising:

a mean signal power computation circuit receiving the output signal of the first signal level detection circuit of the demodulator and computing a mean signal power and
a gain control signal generation circuit for outputting the control signal to the variable gain circuit so that the reception signal levels input to the demodulator become constant based on the mean power found at the mean signal power computation circuit,
the variable gain circuit adjusting the input reception signal to the level in accordance with the control signal by the gain control signal generation circuit and supplying the result to the first signal input terminal of the demodulator.

**91.** A receiver as set forth in claim 90, wherein the mean signal power computation circuit obtains the mean signal power by computation based on the following signal:

$$\overline{d^2} = \overline{h_{d1}P_1}$$

wherein, $d^2$ is the reception signal power, and hdk and k = 0, 1, 2, 3 are the circuit parameter constants found from the circuit elements of the demodulator.

**92.** A receiver as set forth in claim 88, further comprising:

a frequency error detection circuit for detecting the frequency error based on the In-phase component signal I and the quadrature component signal Q obtained at the conversion circuit of the demodulator and supplying the result to the local signal generation circuit,
the local signal generation circuit setting an oscillation frequency of the local signal so as to become a frequency substantially equal to the carrier frequency of the reception signal based on the frequency error value detected at the frequency error detection circuit.

**93.** A receiver as set forth in claim 90, further comprising:

a frequency error detection circuit for detecting the frequency error based on the In-phase component signal I and the quadrature component signal Q obtained at the conversion circuit of the demodulator and supplying the result to the local signal generation circuit,
the local signal generation circuit setting an oscillation frequency of the local signal so as to become a frequency substantially equal to the carrier frequency of the reception signal based on the frequency error value detected at the frequency error detection circuit.

**94.** A receiver as set forth in claim 98, wherein at least one of the first channel selecting means, second channel selecting means, and third channel selecting means includes a low pass filter.

**95.** A receiver as set forth in claim 89, wherein at least one of the first channel selecting means, second channel selecting means, and third channel selecting means includes a low pass filter.

**96.** A receiver as set forth in claim 83, further comprising:

a first channel selecting means for selecting a desired channel from the output signal of the first signal level detection circuit and inputting the result to the first analog/digital converter,
a second channel selecting means for selecting a desired channel from the output signal of the second signal level detection circuit and inputting the result to the second analog/digital converter, and
a third channel selecting means for selecting a desired channel from the output signal of the third signal level detection circuit and inputting the result to the third analog/digital converter, wherein
the conversion circuit includes a computation circuit for demodulating the In-phase component signal I and the quadrature component signal Q based on the output digital signal of the first analog/digital converter, the output digital signal of the second analog/digital converter, the output digital signal of the third analog/digital converter, and the predetermined circuit parameter constants.

**97.** A receiver as set forth in claim 96, wherein the computation circuit obtains the In-phase component signal I and the quadrature component signal Q by computation based on the following equations:

$$I(t) = h_{i0} + h_{i1}P_1 + h_{i2}P_2 + h_{i3}P_3$$

$$Q(t) = h_{q0} + h_{q1}P_1 + h_{q2}P_2 + h_{q3}P_3$$

wherein, $P_1$ is the output signal of the first channel selecting means, $P_2$ is the output signal of the second channel selecting means, $P_3$ is the output signal of the third channel selecting means, and hik, hqk, k = 0, 1, 2, 3 are circuit parameter constants found from the circuit elements of the present demodulator.

**98.** A receiver as set forth in claim 96, further comprising:

a mean signal power computation circuit receiving the output signal of the first signal level detection circuit of the demodulator and computing a mean signal power and

a gain control signal generation circuit for outputting the control signal to the variable gain circuit so that the reception signal levels input to the demodulator become constant based on the mean power found at the mean signal power computation circuit,

the variable gain circuit adjusting the input reception signal to the level in accordance with the control signal by the gain control signal generation circuit and supplying the result to the first signal input terminal of the demodulator.

99. A receiver as set forth in claim 98, wherein the mean signal power computation circuit obtains the mean signal power by computation based on the following signal:

$$\overline{d^2} = \overline{h_{d1}P_1}$$

wherein, $d^2$ is the reception signal power, and hdk and k = 0, 1, 2, 3 are the circuit parameter constants found from the circuit elements of the demodulator.

100. A receiver as set forth in claim 96, further comprising:

a frequency error detection circuit for detecting the frequency error based on the In-phase component signal I and the quadrature component signal Q obtained at the conversion circuit of the demodulator and supplying the result to the local signal generation circuit,

the local signal generation circuit setting an oscillation frequency of the local signal so as to become a frequency substantially equal to the carrier frequency of the reception signal based on the frequency error value detected at the frequency error detection circuit.

101. A receiver as set forth in claim 97, further comprising:

a frequency error detection circuit for detecting the frequency error based on the In-phase component signal I and the quadrature component signal Q obtained at the conversion circuit of the demodulator and supplying the result to the local signal generation circuit,

the local signal generation circuit setting an oscillation frequency of the local signal so as to become a frequency substantially equal to the carrier frequency of the reception signal based on the frequency error value detected at the frequency error detection circuit.

102. A receiver as set forth in claim 98, wherein at least one of the first channel selecting means, second channel selecting means, and third channel selecting means includes a low pass filter.

103. A receiver as set forth in claim 97, wherein at least one of the first channel selecting means, second channel selecting means, and third channel selecting means includes a low pass filter.

104. A receiver as set forth in claim 83, wherein at least one of the first signal level detection circuit, second signal level detection circuit, and third signal level detection circuit of the demodulator has:

a first field effect transistor having a gate supplied with the input signal,

a second field effect transistor having a source connected to a source of the first field effect transistor,

a first gate bias supply circuit for supplying a gate bias voltage to a gate of the first field effect transistor,

a second gate bias supply circuit for supplying a gate bias voltage to a gate of the second field effect transistor,

a current source connected to a connection point of sources of the first field effect transistor and second field effect transistor,

a drain bias supply circuit for supplying a drain bias voltage to drains of the first field effect transistor and second field effect transistor,

a first capacitor connected between the drain of the first field effect transistor and a reference potential, and

a second capacitor connected between the drain of the second field effect transistor and a reference potential, and

a voltage difference between the drain voltage of the first field effect transistor and the drain voltage of the second field effect transistor is defined as a detected output.

**105.** A receiver as set forth in claim 104, wherein:

the first field effect transistor and second field effect transistor have substantially same characteristics,
the drain bias supply circuit includes a first drain bias use resistance element connected between the drain of the first field effect transistor and a voltage source and a second drain bias use resistance element connected between the drain of the second field effect transistor and a voltage source,
a resistance value of the first drain bias use resistance element and a resistance value of the second drain bias use resistance element being set at substantially equal values, and
a capacitance value of the first capacitor and a capacitance value of the second capacitor being set at substantially equal values.

**106.** A receiver as set forth in claim 104, wherein:

a ratio Wga/Wgb of a gate width Wga of the first field effect transistor and a gate width Wgb of the second field effect transistor is set at N,
the drain bias supply circuit includes a first drain bias use resistance element connected between the drain of the first field effect transistor and a voltage source and a second drain bias use resistance element connected between the drain of the second field effect transistor and a voltage source,
a resistance value Ra of the first drain bias use resistance element and a resistance value Rb of the second drain bias use resistance element being set so as to satisfy a condition of Ra/Rb = 1/N, and
a capacitance value of the first capacitor and a capacitance value of the second capacitor being set at substantially equal values.

**107.** A receiver comprising:

a demodulator having a first signal input terminal receiving as input a reception signal, a second signal input terminal receiving as input a local signal, a first branch circuit having an input terminal, a first output terminal, a second output terminal, and a third output terminal, the input terminal being connected to the first signal input terminal, branching the reception signal input to the input terminal to first, second, and third reception signals, outputting the first reception signal from the first output terminal, outputting the second reception signal from the second output terminal, and outputting the third reception signal from the third output terminal, a second branch circuit having an input terminal, a first output terminal, a second output terminal, and a third output terminal, the input terminal being connected to the second signal input terminal, branching the local signal input to the input terminal to first, second, and third local signals, outputting the first local signal from the first output terminal, outputting the second local signal from the second output terminal, and outputting the third local signal from the third output terminal, a first phase shifter for shifting a phase of the first local signal output from the first output terminal of the second branch circuit by exactly a predetermined amount and outputting the result, a second phase shifter for shifting a phase of the second local signal output from the second output terminal of the second branch circuit by exactly a predetermined amount and outputting the result, a first coupler circuit for coupling the second reception signal output from the second output terminal of the first branch circuit and the first local signal shifted in phase by exactly a predetermined amount output from the first phase shifter and outputting the result, a second coupler circuit for coupling the third reception signal output from the third output terminal of the first branch circuit and the second local signal shifted in phase by exactly a predetermined amount output from the second phase shifter and outputting the result, a third coupler circuit for coupling the first reception signal output from the first output terminal of the first branch circuit and the third local signal output from the third output terminal of the second branch circuit and outputting the result, a first signal level detection circuit for detecting the level of the signal output from the third coupler circuit, a second signal level detection circuit for detecting the level of the signal output from the first coupler circuit, a third signal level detection circuit for detecting the level of the signal output from the second coupler' circuit, and a conversion circuit for converting the output signal of the first signal level detection circuit, the output signal of the second signal level detection circuit, and the output signal of the third signal level detection circuit to a plurality of signal components included in the reception signal;
a gain control circuit for adjusting the level of the reception signal to a desired level and supplying the result to the first signal input terminal of the demodulator; and
a local signal generation circuit for generating the local signal with a desired oscillation frequency and supplying the result to the second signal input terminal of the demodulator.

**108.** A receiver as set forth in claim 107, further comprising:

a mean signal power computation circuit receiving the output signal of the first signal level detection circuit of the demodulator and computing a mean signal power and

a gain control signal generation circuit for outputting the control signal to the variable gain circuit so that the reception signal levels input to the demodulator become constant based on the mean power found at the mean signal power computation circuit,

the variable gain circuit adjusting the input reception signal to the level in accordance with the control signal by the gain control signal generation circuit and supplying the result to the first signal input terminal of the demodulator.

**109.** A receiver as set forth in claim 108, wherein the mean signal power computation circuit obtains the mean signal power by computation based on the following signal:

$$\overline{d^2} = \overline{h_{d1}P_1}$$

wherein, $d^2$ is the reception signal power, and hdk and k = 0, 1, 2, 3 are the circuit parameter constants found from the circuit elements of the demodulator.

**110.** A receiver as set forth in claim 107, further comprising:

a frequency error detection circuit for detecting a frequency error based on a plurality of signal components obtained at the conversion circuit of the demodulator and supplying the result to the local signal generation circuit,

the local signal generation circuit setting an oscillation frequency of the local signal so as to become a frequency substantially equal to a carrier frequency of the reception signal based on the frequency error value detected at the frequency error detection circuit.

**111.** A receiver as set forth in claim 108, further comprising:

a frequency error detection circuit for detecting a frequency error based on a plurality of signal components obtained at the conversion circuit of the demodulator and supplying the result to the local signal generation circuit,

the local signal generation circuit setting an oscillation frequency of the local signal so as to become a frequency substantially equal to a carrier frequency of the reception signal based on the frequency error value detected at the frequency error detection circuit.

**112.** A receiver as set forth in claim 107, wherein the conversion circuit of the demodulator includes:

a first channel selecting means for selecting a desired channel from the output signal of the first signal level detection circuit,

a second channel selecting means for selecting a desired channel from the output signal of the second signal level detection circuit,

a third channel selecting means for selecting a desired channel from the output signal of the third signal level detection circuit, and

a computation circuit for demodulating the In-phase component signal I and the quadrature component signal Q based on the output signal of the first channel selecting means, the output signal of the second channel selecting means, the output signal of the third channel selecting means, and predetermined circuit parameter constants.

**113.** A receiver as set forth in claim 112, wherein the computation circuit obtains the In-phase component signal I and the quadrature component signal Q by computation based on the following equations:

$$I(t) = h_{i0} + h_{i1}P_1 + h_{i2}P_2 + h_{i3}P_3$$

$$Q(t) = h_{q0} + h_{q1}P_1 + h_{q2}P_2 + h_{q3}P_3$$

wherein, $P_1$ is the output signal of the first channel selecting means, $P_2$ is the output signal of the second channel selecting means, $P_3$ is the output signal of the third channel selecting means, and hik, hqk, k = 0, 1, 2, 3 are circuit parameter constants found from the circuit elements of the present demodulator.

114. A receiver as set forth in claim 113, further comprising:

a mean signal power computation circuit receiving the output signal of the first signal level detection circuit of the demodulator and computing a mean signal power and

a gain control signal generation circuit for outputting the control signal to the variable gain circuit so that the reception signal levels input to the demodulator become constant based on the mean power found at the mean signal power computation circuit,

the variable gain circuit adjusting the input reception signal to the level in accordance with the control signal by the gain control signal generation circuit and supplying the result to the first signal input terminal of the demodulator.

115. A receiver as set forth in claim 114, wherein the mean signal power computation circuit obtains the mean signal power by computation based on the following signal:

$$\overline{d^2} = \overline{h_{d1}P_1}$$

wherein, $d^2$ is the reception signal power, and hdk and k = 0, 1, 2, 3 are the circuit parameter constants found from the circuit elements of the demodulator.

116. A receiver as set forth in claim 112, further comprising:

a frequency error detection circuit for detecting the frequency error based on the In-phase component signal I and the quadrature component signal Q obtained at the conversion circuit of the demodulator and supplying the result to the local signal generation circuit,

the local signal generation circuit setting an oscillation frequency of the local signal so as to become a frequency substantially equal to the carrier frequency of the reception signal based on the frequency error value detected at the frequency error detection circuit.

117. A receiver as set forth in claim 114, further comprising:

a frequency error detection circuit for detecting the frequency error based on the In-phase component signal I and the quadrature component signal Q obtained at the conversion circuit of the demodulator and supplying the result to the local signal generation circuit,

the local signal generation circuit setting an oscillation frequency of the local signal so as to become a frequency substantially equal to the carrier frequency of the reception signal based on the frequency error value detected at the frequency error detection circuit.

118. A receiver as set forth in claim 112, wherein at least one of the first channel selecting means, second channel selecting means, and third channel selecting means includes a low pass filter.

119. A receiver as set forth in claim 113, wherein at least one of the first channel selecting means, second channel selecting means, and third channel selecting means includes a low pass filter.

120. A receiver as set forth in claim 107, wherein at least one of the first signal level detection circuit, second signal level detection circuit, and third signal level detection circuit of the demodulator has:

a first field effect transistor having a gate supplied with the input signal,

a second field effect transistor having a source connected to a source of the first field effect transistor,

a first gate bias supply circuit for supplying a gate bias voltage to the gate of the first field effect transistor,

a second gate bias supply circuit for supplying a gate bias voltage to a gate of the second field effect transistor,

a current source connected to a connection point of sources of the first field effect transistor and second field effect transistor,

a drain bias supply circuit for supplying a drain bias voltage to drains of the first field effect transistor and second field effect transistor,

a first capacitor connected between the drain of the first field effect transistor and a reference potential, and
a second capacitor connected between the drain of the second field effect transistor and a reference potential, and

a voltage difference between the drain voltage of the first field effect transistor and the drain voltage of the second field effect transistor is defined as a detected output.

**121.** A receiver as set forth in claim 120, wherein:

the first field effect transistor and second field effect transistor have substantially same characteristics,
the drain bias supply circuit includes a first drain bias use resistance element connected between the drain of the first field effect transistor and a voltage source and a second drain bias use resistance element connected between the drain of the second field effect transistor and a voltage source,
a resistance value of the first drain bias use resistance element and a resistance value of the second drain bias use resistance element being set at substantially equal values, and
a capacitance value of the first capacitor and a capacitance value of the second capacitor being set at substantially equal values.

**122.** A receiver as set forth in claim 120, wherein:

a ratio Wga/Wgb of a gate width Wga of the first field effect transistor and a gate width Wgb of the second field effect transistor is set at N,
the drain bias supply circuit includes a first drain bias use resistance element connected between the drain of the first field effect transistor and a voltage source and a second drain bias use resistance element connected between the drain of the second field effect transistor and a voltage source,
a resistance value Ra of the first drain bias use resistance element and a resistance value Rb of the second drain bias use resistance element being set so as to satisfy a condition of Ra/Rb = 1/N, and
a capacitance value of the first capacitor and a capacitance value of the second capacitor being set at substantially equal values.

**123.** A receiver comprising:

a demodulator having a first signal input terminal receiving as input a reception signal, a second signal input terminal receiving as input a local signal, a first branch circuit having an input terminal, a first output terminal, and a second output terminal, the input terminal being connected to the first signal input terminal, branching the reception signal input to the input terminal to first and second reception signals, outputting the first reception signal from the first output terminal, and outputting the second reception signal from the second output terminal, a second branch circuit having an input terminal, a first output terminal, and a second output terminal, the input terminal being connected to the first output terminal of the first branch circuit, branching the reception signal input to the input terminal to third and fourth reception signals, outputting the third reception signal from the first output terminal, and outputting the fourth reception signal from the second output terminal, a third branch circuit having an input terminal, a first output terminal, and a second output terminal, the input terminal being connected to the second signal input terminal, branching the local signal input to the input terminal to first and second local signals, outputting the first local signal from the first output terminal, and outputting the second local signal from the second output terminal, a first phase shifter for shifting a phase of the first local signal output from the first output terminal of the third branch circuit by exactly a predetermined amount and outputting the result, a second phase shifter for shifting a phase of the second local signal output from the second output terminal of the third branch circuit by exactly a predetermined amount and outputting the result, a first coupler circuit for coupling the third reception signal output from the first output terminal of the second branch circuit and the first local signal shifted in phase by exactly a predetermined amount output from the first phase shifter and outputting the result, a second coupler circuit for coupling the fourth reception signal output from the second output terminal of the second branch circuit and the second local signal shifted in phase by exactly a predetermined amount output from the second phase shifter and outputting the result, a first signal level detection circuit for detecting the level of the signal output from the first coupler circuit, a second signal level detection circuit for detecting the level of the signal output from the second coupler circuit, a third signal level detection circuit for detecting the level of the signal output from the second output terminal of the first branch circuit, and a conversion circuit for converting the output signal of the first signal level detection circuit, the output signal of the second signal level detection circuit, and the output signal of the third signal level detection circuit to a plurality of signal components included in the reception signal;
a gain control circuit for adjusting the level of the reception signal to a desired level and supplying the result to the first signal input terminal of the demodulator; and
a local signal generation circuit for generating the local signal with a desired oscillation frequency and supplying the result to the second signal input terminal of the demodulator.

124. A receiver as set forth in claim 123, further comprising:

a mean signal power computation circuit receiving the output signal of the first signal level detection circuit of the demodulator and computing a mean signal power and
a gain control signal generation circuit for outputting the control signal to the variable gain circuit so that the reception signal levels input to the demodulator become constant based on the mean power found at the mean signal power computation circuit,
the variable gain circuit adjusting the input reception signal to the level in accordance with the control signal by the gain control signal generation circuit and supplying the result to the first signal input terminal of the demodulator.

125. A receiver as set forth in claim 124, wherein the mean signal power computation circuit obtains the mean signal power by computation based on the following signal:

$$\overline{d^2} = \overline{h_{d1}P_1}$$

wherein, $d^2$ is the reception signal power, and hdk and k = 0, 1, 2, 3 are the circuit parameter constants found from the circuit elements of the demodulator.

126. A receiver as set forth in claim 123, further comprising:

a frequency error detection circuit for detecting a frequency error based on a plurality of signal components obtained at the conversion circuit of the demodulator and supplying the result to the local signal generation circuit,
the local signal generation circuit setting an oscillation frequency of the local signal so as to become a frequency substantially equal to a carrier frequency of the reception signal based on the frequency error value detected at the frequency error detection circuit.

127. A receiver as set forth in claim 124, further comprising:

a frequency error detection circuit for detecting a frequency error based on a plurality of signal components obtained at the conversion circuit of the demodulator and supplying the result to the local signal generation circuit,
the local signal generation circuit setting an oscillation frequency of the local signal so as to become a frequency substantially equal to a carrier frequency of the reception signal based on the frequency error value detected at the frequency error detection circuit.

128. A receiver as set forth in claim 123, wherein the conversion circuit of the demodulator includes:

a first channel selecting means for selecting a desired channel from the output signal of the first signal level detection circuit,
a second channel selecting means for selecting a desired channel from the output signal of the second signal level detection circuit,
a third channel selecting means for selecting a desired channel from the output signal of the third signal level detection circuit, and
a computation circuit for demodulating the In-phase component signal I and the quadrature component signal Q based on the output signal of the first channel selecting means, the output signal of the second channel selecting means, the output signal of the third channel selecting means, and predetermined circuit parameter constants.

129. A receiver as set forth in claim 128, wherein the computation circuit obtains the In-phase component signal I and the quadrature component signal Q by computation based on the following equations:

$$I(t) = h_{i0}+h_{i1}P_1+h_{i2}P_2+h_{i3}P_3$$

$$Q(t) = h_{q0}+h_{q1}P_1+h_{q2}P_2+h_{q3}P_3$$

wherein, $P_1$ is the output signal of the first channel selecting means, $P_2$ is the output signal of the second channel selecting means, $P_3$ is the output signal of the third channel selecting means, and hik, hqk, k = 0, 1, 2, 3 are circuit parameter constants found from the circuit elements of the present demodulator.

130. A receiver as set forth in claim 128, further comprising:

a mean signal power computation circuit receiving the output signal of the first signal level detection circuit of the demodulator and computing a mean signal power and
a gain control signal generation circuit for outputting the control signal to the variable gain circuit so that the reception signal levels input to the demodulator become constant based on the mean power found at the mean signal power computation circuit,
the variable gain circuit adjusting the input reception signal to the level in accordance with the control signal by the gain control signal generation circuit and supplying the result to the first signal input terminal of the demodulator.

131. A receiver as set forth in claim 130, wherein the mean signal power computation circuit obtains the mean signal power by computation based on the following signal:

$$\overline{d^2} = \overline{h_{d1}P_1}$$

wherein, $d^2$ is the reception signal power, and hdk and k = 0, 1, 2, 3 are the circuit parameter constants found from the circuit elements of the demodulator.

132. A receiver as set forth in claim 128, further comprising:

a frequency error detection circuit for detecting the frequency error based on the In-phase component signal I and the quadrature component signal Q obtained at the conversion circuit of the demodulator and supplying the result to the local signal generation circuit,
the local signal generation circuit setting an oscillation frequency of the local signal so as to become a frequency substantially equal to the carrier frequency of the reception signal based on the frequency error value detected at the frequency error detection circuit.

133. A receiver as set forth in claim 130, further comprising:

a frequency error detection circuit for detecting the frequency error based on the In-phase component signal I and the quadrature component signal Q obtained at the conversion circuit of the demodulator and supplying the result to the local signal generation circuit,
the local signal generation circuit setting an oscillation frequency of the local signal so as to become a frequency substantially equal to the carrier frequency of the reception signal based on the frequency error value detected at the frequency error detection circuit.

134. A receiver as set forth in claim 128, wherein at least one of the first channel selecting means, second channel selecting means, and third channel selecting means includes a low pass filter.

135. A receiver as set forth in claim 129, wherein at least one of the first channel selecting means, second channel selecting means, and third channel selecting means includes a low pass filter.

136. A receiver as set forth in claim 123, wherein at least one of the first signal level detection circuit, second signal level detection circuit, and third signal level detection circuit of the demodulator has:

a first field effect transistor having a gate supplied with the input signal,

a second field effect transistor having a source connected to a source of the first field effect transistor,

a first gate bias supply circuit for supplying a gate bias voltage to the gate of the first field effect transistor,

a second gate bias supply circuit for supplying a gate bias voltage to a gate of the second field effect transistor,

a current source connected to a connection point of sources of the first field effect transistor and second field effect transistor,

a drain bias supply circuit for supplying a drain bias voltage to drains of the first field effect transistor and second field effect transistor,

a first capacitor connected between the drain of the first field effect transistor and a reference potential, and

a second capacitor connected between the drain of the second field effect transistor and a reference potential, and

a voltage difference between the drain voltage of the first field effect transistor and the drain voltage of the second field effect transistor is defined as a detected output.

137. A receiver as set forth in claim 136, wherein:

the first field effect transistor and second field effect transistor have substantially same characteristics,

the drain bias supply circuit includes a first drain bias use resistance element connected between the drain of the first field effect transistor and a voltage source and a second drain bias use resistance element connected between the drain of the second field effect transistor and a voltage source,

a resistance value of the first drain bias use resistance element and a resistance value of the second drain bias use resistance element being set at substantially equal values, and

a capacitance value of the first capacitor and a capacitance value of the second capacitor being set at substantially equal values.

138. A receiver as set forth in claim 136, wherein:

a ratio Wga/Wgb of a gate width Wga of the first field effect transistor and a gate width Wgb of the second field effect transistor is set at N,

the drain bias supply circuit includes a first drain bias use resistance element connected between the drain of the first field effect transistor and a voltage source and a second drain bias use resistance element connected between the drain of the second field effect transistor and a voltage source,

a resistance value Ra of the first drain bias use resistance element and a resistance value Rb of the second drain bias use resistance element being set so as to satisfy a condition of Ra/Rb = 1/N, and

a capacitance value of the first capacitor and a capacitance value of the second capacitor being set at substantially equal values.

139. A receiver as set forth in claim 123, wherein an amplifier for amplifying the output signal from the first output terminal is connected to at least the first output terminal between the first output terminal and the second output terminal of the first branch circuit.

140. A receiver comprising:

a demodulator having a first signal input terminal receiving as input a reception signal, a second signal input terminal receiving as input a local signal, a first branch circuit having an input terminal, a first output terminal, a second output terminal, and a third output terminal, the input terminal being connected to the first signal input terminal, branching the reception signal input to the input terminal to first, second, and third reception signals, outputting the first reception signal from the first output terminal, outputting the second reception signal from the second output terminal, and outputting the third reception signal from the third output terminal, a second branch circuit having an input terminal, a first output terminal, and a second output terminal, the input terminal being connected to the second signal input terminal, branching the local signal input to the input terminal to first and second local signals, outputting the first local signal from the first output terminal, and outputting the second local signal from the second output terminal, a first phase shifter for shifting a phase of the first local signal output from the first output terminal of the second branch circuit by exactly a predetermined amount and outputting the result, a second phase shifter for shifting a phase of the third reception signal output from the third output terminal of the first branch circuit by exactly a predetermined amount and outputting the result, a first coupler circuit for coupling the second reception signal output from the second output terminal of the first branch circuit and the first local signal shifted in phase by exactly a predetermined amount output from the first phase shifter and outputting the result, a second coupler circuit for coupling the third reception signal shifted in phase by exactly a predetermined amount output from the second phase shifter and the second local signal output from the second branch circuit and outputting the result, a first signal level detection circuit for detecting the level of the signal output from the first output terminal of the first branch circuit, a second signal level detection circuit for detecting the level of the signal output from the first coupler circuit, and a third signal level detection circuit for detecting the level of the signal output from the second coupler circuit, and a conversion circuit for converting the output signal of the first signal level detection circuit, the output signal of the second signal level detection circuit, and the output signal of the third signal level detection circuit to a plurality of signal components included in the reception signal;

a gain control circuit for adjusting the level of the reception signal to a desired level and supplying the result to the first signal input terminal of the demodulator; and

a local signal generation circuit for generating the local signal with a desired oscillation frequency and supplying the result to the second signal input terminal of the demodulator.

141. A receiver as set forth in claim 140, further comprising:

a mean signal power computation circuit receiving the output signal of the first signal level detection circuit of the demodulator and computing a mean signal power and

a gain control signal generation circuit for outputting the control signal to the variable gain circuit so that the reception signal levels input to the demodulator become constant based on the mean power found at the mean signal power computation circuit,

the variable gain circuit adjusting the input reception signal to the level in accordance with the control signal by the gain control signal generation circuit and supplying the result to the first signal input terminal of the demodulator.

142. A receiver as set forth in claim 141, wherein the mean signal power computation circuit obtains the mean signal power by computation based on the following signal:

$$\overline{d^2} = \overline{h_{d1}P_1}$$

wherein $d^2$ is the reception signal power, and hdk and k = 0, 1, 2, 3 are the circuit parameter constants found from the circuit elements of the demodulator.

143. A receiver as set forth in claim 140, further comprising:

a frequency error detection circuit for detecting a frequency error based on a plurality of signal components obtained at the conversion circuit of the demodulator and supplying the result to the local signal generation circuit,

the local signal generation circuit setting an oscillation frequency of the local signal so as to become a frequency substantially equal to a carrier frequency of the reception signal based on the frequency error value detected at the frequency error detection circuit.

144. A receiver as set forth in claim 141, further comprising:

a frequency error detection circuit for detecting a frequency error based on a plurality of signal components obtained at the conversion circuit of the demodulator and supplying the result to the local signal generation circuit,

the local signal generation circuit setting an oscillation frequency of the local signal so as to become a frequency substantially equal to a carrier frequency of the reception signal based on the frequency error value detected at the frequency error detection circuit.

145. A receiver as set forth in claim 140, wherein the conversion circuit of the demodulator includes:

a first channel selecting means for selecting a desired channel from the output signal of the first signal level detection circuit,

a second channel selecting means for selecting a desired channel from the output signal of the second signal level detection circuit,

a third channel selecting means for selecting a desired channel from the output signal of the third signal level detection circuit, and

a computation circuit for demodulating the In-phase component signal I and the quadrature component signal Q based on the output signal of the first channel selecting means, the output signal of the second channel selecting means, the output signal of the third channel selecting means, and predetermined circuit parameter constants.

146. A receiver as set forth in claim 145, wherein the computation circuit obtains the In-phase component signal I and the quadrature component signal Q by computation based on the following equations:

$$I(t) = h_{i0} + h_{i1}P_1 + h_{i2}P_2 + h_{i3}P_3$$

$$Q(t) = h_{q0} + h_{q1}P_1 + h_{q2}P_2 + h_{q3}P_3$$

wherein, $P_1$ is the output signal of the first channel selecting means, $P_2$ is the output signal of the second channel selecting means, $P_3$ is the output signal of the third channel selecting means, and hik, hqk, k = 0, 1, 2, 3 are circuit parameter constants found from the circuit elements of the present demodulator.

147. A receiver as set forth in claim 145, further comprising:

a mean signal power computation circuit receiving the output signal of the first signal level detection circuit of the demodulator and computing a mean signal power and

a gain control signal generation circuit for outputting the control signal to the variable gain circuit so that the reception signal levels input to the demodulator become constant based on the mean power found at the mean signal power computation circuit,

the variable gain circuit adjusting the input reception signal to the level in accordance with the control signal by the gain control signal generation circuit and supplying the result to the first signal input terminal of the demodulator.

148. A receiver as set forth in claim 147, wherein the mean signal power computation circuit obtains the mean signal power by computation based on the following signal:

$$\overline{d^2} = \overline{h_{d1}P_1}$$

wherein $d^2$ is the reception signal power, and hdk and k = 0, 1, 2, 3 are the circuit parameter constants found from the circuit elements of the demodulator.

149. A receiver as set forth in claim 145, further comprising:

a frequency error detection circuit for detecting the frequency error based on the In-phase component signal I and the quadrature component signal Q obtained at the conversion circuit of the demodulator and supplying the result to the local signal generation circuit,

the local signal generation circuit setting an oscillation frequency of the local signal so as to become a frequency substantially equal to the carrier frequency of the reception signal based on the frequency error value detected at the frequency error detection circuit.

150. A receiver as set forth in claim 147, further comprising:

a frequency error detection circuit for detecting the frequency error based on the In-phase component signal I and the quadrature component signal Q obtained at the conversion circuit of the demodulator and supplying the result to the local signal generation circuit,

the local signal generation circuit setting an oscillation frequency of the local signal so as to become a frequency substantially equal to the carrier frequency of the reception signal based on the frequency error value detected at the frequency error detection circuit.

151. A receiver as set forth in claim 145, wherein at least one of the first channel selecting means, second channel selecting means, and third channel selecting means includes a low pass filter.

152. A receiver as set forth in claim 146, wherein at least one of the first channel selecting means, second channel selecting means, and third channel selecting means includes a low pass filter.

153. A receiver as set forth in claim 140, wherein at least one of the first signal level detection circuit, second signal level detection circuit, and third signal level detection circuit of the demodulator has:

a first field effect transistor having a gate supplied with the input signal,
a second field effect transistor having a source connected to a source of the first field effect transistor,
a first gate bias supply circuit for supplying a gate bias voltage to the gate of the first field effect transistor,
a second gate bias supply circuit for supplying a gate bias voltage to a gate of the second field effect transistor,
a current source connected to a connection point of sources of the first field effect transistor and second field effect transistor,
a drain bias supply circuit for supplying a drain bias voltage to drains of the first field effect transistor and second field effect transistor,
a first capacitor connected between the drain of the first field effect transistor and a reference potential, and
a second capacitor connected between the drain of the second field effect transistor and a reference potential, and
a voltage difference between the drain voltage of the first field effect transistor and the drain voltage of the second field effect transistor is defined as a detected output.

154. A receiver as set forth in claim 153, wherein:

the first field effect transistor and second field effect transistor have substantially same characteristics,
the drain bias supply circuit includes a first drain bias use resistance element connected between the drain of the first field effect transistor and a voltage source and a second drain bias use resistance element connected between the drain of the second field effect transistor and a voltage source,
a resistance value of the first drain bias use resistance element and a resistance value of the second drain bias use resistance element being set at substantially equal values, and
a capacitance value of the first capacitor and a capacitance value of the second capacitor being set at substantially equal values.

155. A receiver as set forth in claim 153, wherein:

a ratio Wga/Wgb of a gate width Wga of the first field effect transistor and a gate width Wgb of the second field effect transistor is set at N,
the drain bias supply circuit includes a first drain bias use resistance element connected between the drain of the first field effect transistor and a voltage source and a second drain bias use resistance element connected between the drain of the second field effect transistor and a voltage source,
a resistance value Ra of the first drain bias use resistance element and a resistance value Rb of the second drain bias use resistance element being set so as to satisfy a condition of Ra/Rb = 1/N, and
a capacitance value of the first capacitor and a capacitance value of the second capacitor being set at substantially equal values.

156. A receiver comprising:

a demodulator having a first signal input terminal receiving as input a reception signal, a second signal input terminal receiving as input a local signal, a first branch circuit having an input terminal, a first output terminal, and a second output terminal, the input terminal being connected to the first signal input terminal, branching the reception signal input to the input terminal to first and second reception signals, outputting the first reception signal from the first output terminal, and outputting the second reception signal from the second output terminal, a second branch circuit having an input terminal, a first output terminal, and a second output terminal, the input terminal being connected to the first output terminal of the first branch circuit, branching the reception signal input to the input terminal to third and fourth reception signals, outputting the third reception signal from the first output terminal, and outputting the fourth reception signal from the second output terminal, a third branch circuit having an input terminal, a first output terminal, and a second output terminal, the input terminal being connected to the second signal input terminal, branching the local signal input to the input terminal to first and second local signals, outputting the first local signal from the first output terminal, and outputting the second local signal from the second output terminal, a fourth branch circuit having an input terminal, a first output terminal, and a second output terminal, the input terminal being connected to the first output terminal of the third branch circuit, branching the local signal input to the input terminal to third and fourth local signals, outputting the third local signal from the first output terminal, and outputting the fourth local signal from the second output terminal, a first phase shifter for shifting a phase of the third local signal output from the first output terminal of the fourth branch circuit by exactly a predetermined amount and outputting the result, a second phase shifter for shifting a phase of the fourth local signal output from the second output terminal of the fourth branch circuit by exactly a predetermined amount and outputting the result, a first coupler circuit for coupling the third reception signal output from the first output terminal of the second branch circuit and the third local signal shifted in phase by exactly a predetermined amount output from the first phase shifter and outputting the result, a second coupler circuit for coupling the fourth reception signal output from the second output terminal of the second branch circuit and the fourth local signal shifted in phase by exactly a predetermined amount output from the second phase shifter and outputting the result, a first signal level detection circuit for detecting the level of the signal output from the first coupler circuit, a second signal level detection circuit for detecting the level of the signal output from the second coupler circuit, a third signal level detection circuit for detecting the level of the signal output from the second output terminal of the first branch circuit, a fourth signal level detection circuit for detecting the level of the signal output from the second output terminal of the third branch circuit, and a conversion circuit for converting the output signal of the first signal level detection circuit, the output signal of the second signal level detection circuit, the output signal of the third signal level detection circuit, and the output signal of the fourth signal level detection circuit to a plurality of signal components included in the reception signal;
a gain control circuit for adjusting the level of the reception signal to a desired level and supplying the result to the first signal input terminal of the demodulator; and
a local signal generation circuit for generating the local signal with a desired oscillation frequency and supplying the result to the second signal input terminal of the demodulator.

157. A receiver as set forth in claim 156, further comprising:

a mean signal power computation circuit receiving the output signal of the first signal level detection circuit of the demodulator and computing a mean signal power and
a gain control signal generation circuit for outputting the control signal to the variable gain circuit so that the reception signal levels input to the demodulator become constant based on the mean power found at the mean signal power computation circuit,
the variable gain circuit adjusting the input reception signal to the level in accordance with the control signal by the gain control signal generation circuit and supplying the result to the first signal input terminal of the demodulator.

158. A receiver as set forth in claim 157, wherein the mean signal power computation circuit obtains the mean signal power by computation based on the following signal:

$$\overline{d^2} = \overline{h_{d1}P_1}$$

wherein, $d^2$ is the reception signal power, and hdk and k = 0, 1, 2, 3 are the circuit parameter constants found from the circuit elements of the demodulator.

159. A receiver as set forth in claim 156, further comprising:

a frequency error detection circuit for detecting a frequency error based on a plurality of signal components obtained at the conversion circuit of the demodulator and supplying the result to the local signal generation circuit,
the local signal generation circuit setting an oscillation frequency of the local signal so as to become a frequency substantially equal to a carrier frequency of the reception signal based on the frequency error value detected at the frequency error detection circuit.

160. A receiver as set forth in claim 157, further comprising:

a frequency error detection circuit for detecting a frequency error based on a plurality of signal components obtained at the conversion circuit of the demodulator and supplying the result to the local signal generation circuit,

the local signal generation circuit setting an oscillation frequency of the local signal so as to become a frequency substantially equal to a carrier frequency of the reception signal based on the frequency error value detected at the frequency error detection circuit.

161. A receiver as set forth in claim 156, wherein the conversion circuit obtains the In-phase component signal I and the quadrature component signal Q by computation based on the following equations:

$$I(t) = h_{i0} + h_{i1}P_1/P_4 + h_{i2}P_1/P_4 + h_{i3}P_1/P_4$$

$$Q(t) = h_{q0} + h_{q1}P_1/P_4 + h_{q2}P_1/P_4 + h_{q3}P_1/P_4$$

wherein, $P_1$ is the output signal of the first signal level detection circuit, and $P_4$ is the output signal of the fourth signal level detection circuit, and hik, hqk, k = 0, 1, 2, 3 are circuit parameter constants found from the circuit elements of the present demodulator.

162. A receiver as set forth in claim 156, wherein at least one of the first signal level detection circuit, second signal level detection circuit, third signal level detection circuit, and fourth signal level detection circuit of the demodulator has:

a first field effect transistor having a gate supplied with the input signal,
a second field effect transistor having a source connected to a source of the first field effect transistor,
a first gate bias supply circuit for supplying a gate bias voltage to the gate of the first field effect transistor,
a second gate bias supply circuit for supplying a gate bias voltage to a gate of the second field effect transistor,
a current source connected to a connection point of sources of the first field effect transistor and second field effect transistor,
a drain bias supply circuit for supplying a drain bias voltage to drains of the first field effect transistor and second field effect transistor,
a first capacitor connected between the drain of the first field effect transistor and a reference potential, and
a second capacitor connected between the drain of the second field effect transistor and a reference potential, and
a voltage difference between the drain voltage of the first field effect transistor and the drain voltage of the second field effect transistor is defined as a detected output.

163. A receiver as set forth in claim 162, wherein:

the first field effect transistor and second field effect transistor have substantially same characteristics,
the drain bias supply circuit includes a first drain bias use resistance element connected between the drain of the first field effect transistor and a voltage source and a second drain bias use resistance element connected between the drain of the second field effect transistor and a voltage source,
a resistance value of the first drain bias use resistance element and a resistance value of the second drain bias use resistance element being set at substantially equal values, and
a capacitance value of the first capacitor and a capacitance value of the second capacitor being set at substantially equal values.

164. A receiver as set forth in claim 162, wherein:

a ratio Wga/Wgb of a gate width Wga of the first field effect transistor and a gate width Wgb of the second field effect transistor is set at N,
the drain bias supply circuit includes a first drain bias use resistance element connected between the drain of the first field effect transistor and a voltage source and a second drain bias use resistance element connected between the drain of the second field effect transistor and a voltage source,
a resistance value Ra of the first drain bias use resistance element and a resistance value Rb of the second drain bias use resistance element being set so as to satisfy a condition of Ra/Rb = 1/N, and
a capacitance value of the first capacitor and a capacitance value of the second capacitor being set at substantially equal values.

**165.**A receiver comprising:

a demodulator having a first signal input terminal receiving as input a reception signal, a second signal input terminal receiving as input a local signal, a branch circuit having an input terminal, a first output terminal, and a second output terminal, the input terminal being connected to the first signal input terminal, branching the reception signal input to the input terminal to first and second reception signals, outputting the first reception signal from the first output terminal, and outputting the second reception signal from the second output terminal, a first phase divider having an input terminal, a first output terminal, and a second output terminal, the input terminal being connected to the first output terminal of the branch circuit, branching the reception signal input to the input terminal to third and fourth reception signals having inverse phases to each other, outputting the third reception signal from the first output terminal, and outputting the fourth reception signal from the second output terminal, a second phase divider having an input terminal, a first output terminal, and a second output terminal, the input terminal being connected to the second signal input terminal, branching the local signal input to the input terminal to first and second local signals having inverse phases to each other, outputting the first local signal from the first output terminal, and outputting the second local signal from the second output terminal, a first phase shifter for shifting a phase of the first local signal output from the first output terminal of the second phase divider by exactly a predetermined amount and outputting the result, a second phase shifter for shifting a phase of the second local signal output from the second output terminal of the second phase divider by exactly a predetermined amount and outputting the result, a first coupler circuit for coupling the third reception signal output from the first output terminal of the first phase divider and the first local signal shifted in phase by exactly a predetermined amount output from the first phase shifter and outputting the result, a second coupler circuit for coupling the fourth reception signal output from the second output terminal of the first phase divider and the second local signal shifted in phase by exactly a predetermined amount output from the second phase shifter and outputting the result, a first signal level detection circuit for detecting the level of the signal output from the first coupler circuit, a second signal level detection circuit for detecting the level of the signal output from the second coupler circuit, a third signal level detection circuit for detecting the level of the signal output from the second output terminal of the branch circuit, and a conversion circuit for converting the output signal of the first signal level detection circuit, the output signal of the second signal level detection circuit, and the output signal of the third signal level detection circuit to a plurality of signal components included in the reception signal;
a gain control circuit for adjusting the level of the reception signal to a desired level and supplying the result to the first signal input terminal of the demodulator; and
a local signal generation circuit for generating the local signal with a desired oscillation frequency and supplying the result to the second signal input terminal of the demodulator.

**166.**A receiver as set forth in claim 165, further comprising:

a mean signal power computation circuit receiving the output signal of the first signal level detection circuit of the demodulator and computing a mean signal power and
a gain control signal generation circuit for outputting the control signal to the variable gain circuit so that the reception signal levels input to the demodulator become constant based on the mean power found at the mean signal power computation circuit,
the variable gain circuit adjusting the input reception signal to the level in accordance with the control signal by the gain control signal generation circuit and supplying the result to the first signal input terminal of the demodulator.

**167.**A receiver as set forth in claim 166, wherein the mean signal power computation circuit obtains the mean signal power by computation based on the following signal:

$$\overline{d^2} = \overline{h_{d1}P_1}$$

wherein, $d^2$ is the reception signal power, and hdk and k = 0, 1, 2, 3 are the circuit parameter constants found from the circuit elements of the demodulator.

**168.** A receiver as set forth in claim 165, further comprising:

a frequency error detection circuit for detecting a frequency error based on a plurality of signal components obtained at the conversion circuit of the demodulator and supplying the result to the local signal generation circuit,
the local signal generation circuit setting an oscillation frequency of the local signal so as to become a frequency substantially equal to a carrier frequency of the reception signal based on the frequency error value detected at the frequency error detection circuit.

**169.** A receiver as set forth in claim 166, further comprising:

a frequency error detection circuit for detecting a frequency error based on a plurality of signal components obtained at the conversion circuit of the demodulator and supplying the result to the local signal generation circuit,
the local signal generation circuit setting an oscillation frequency of the local signal so as to become a frequency substantially equal to a carrier frequency of the reception signal based on the frequency error value detected at the frequency error detection circuit.

**170.** A receiver as set forth in claim 165, wherein the conversion circuit of the demodulator includes:

a first channel selecting means for selecting a desired channel from the output signal of the first signal level detection circuit,
a second channel selecting means for selecting a desired channel from the output signal of the second signal level detection circuit,
a third channel selecting means for selecting a desired channel from the output signal of the third signal level detection circuit, and
a computation circuit for demodulating the In-phase component signal I and the quadrature component signal Q based on the output signal of the first channel selecting means, the output signal of the second channel selecting means, the output signal of the third channel selecting means, and predetermined circuit parameter constants.

**171.** A receiver as set forth in claim 170, wherein the computation circuit obtains the In-phase component signal I and the quadrature component signal Q by computation based on the following equations:

$$I(t) = h_{i0} + h_{i1}P_1 + h_{i2}P_2 + h_{i3}P_3$$

$$Q(t) = h_{q0} + h_{q1}P_1 + h_{q2}P_2 + h_{q3}P_3$$

wherein, $P_1$ is the output signal of the first channel selecting means, $P_2$ is the output signal of the second channel selecting means, $P_3$ is the output signal of the third channel selecting means, and hik, hqk, k = 0, 1, 2, 3 are circuit parameter constants found from the circuit elements of the present demodulator.

**172.** A receiver as set forth in claim 170, further comprising:

a mean signal power computation circuit receiving the output signal of the first signal level detection circuit of the demodulator and computing a mean signal power and
a gain control signal generation circuit for outputting the control signal to the variable gain circuit so that the reception signal levels input to the demodulator become constant based on the mean power found at the mean signal power computation circuit,
the variable gain circuit adjusting the input reception signal to the level in accordance with the control signal by the gain control signal generation circuit and supplying the result to the first signal input terminal of the demodulator.

**173.** A receiver as set forth in claim 172, wherein the mean signal power computation circuit obtains the mean signal power by computation based on the following signal:

$$\overline{d^2} = \overline{h_{d1}P_1}$$

wherein, $d^2$ is the reception signal power, and hdk and k = 0, 1, 2, 3 are the circuit parameter constants found from the circuit elements of the demodulator.

**174.** A receiver as set forth in claim 170, further comprising:

a frequency error detection circuit for detecting the frequency error based on the In-phase component signal I and the quadrature component signal Q obtained at the conversion circuit of the demodulator and supplying the result to the local signal generation circuit,
the local signal generation circuit setting an oscillation frequency of the local signal so as to become a frequency substantially equal to the carrier frequency of the reception signal based on the frequency error value detected at the frequency error detection circuit.

**175.** A receiver as set forth in claim 172, further comprising:

a frequency error detection circuit for detecting the frequency error based on the In-phase component signal I and the quadrature component signal Q obtained at the conversion circuit of the demodulator and supplying the result to the local signal generation circuit,
the local signal generation circuit setting an oscillation frequency of the local signal so as to become a frequency substantially equal to the carrier frequency of the reception signal based on the frequency error value detected at the frequency error detection circuit.

**176.** A receiver as set forth in claim 170, wherein at least one of the first channel selecting means, second channel selecting means, and third channel selecting means includes a low pass filter.

**177.** A receiver as set forth in claim 171, wherein at least one of the first channel selecting means, second channel selecting means, and third channel selecting means includes a low pass filter.

**178.** A receiver as set forth in claim 165, wherein at least one of the first signal level detection circuit, second signal level detection circuit, and third signal level detection circuit of the demodulator has:

a first field effect transistor having a gate supplied with the input signal,
a second field effect transistor having a source connected to a source of the first field effect transistor,
a first gate bias supply circuit for supplying a gate bias voltage to the gate of the first field effect transistor,
a second gate bias supply circuit for supplying a gate bias voltage to a gate of the second field effect transistor,
a current source connected to a connection point of sources of the first field effect transistor and second field effect transistor,
a drain bias supply circuit for supplying a drain bias voltage to drains of the first field effect transistor and second field effect transistor,
a first capacitor connected between the drain of the first field effect transistor and a reference potential, and
a second capacitor connected between the drain of the second field effect transistor and a reference potential, and
a voltage difference between the drain voltage of the first field effect transistor and the drain voltage of the second field effect transistor is defined as a detected output.

**179.** A receiver as set forth in claim 178, wherein:

the first field effect transistor and second field effect transistor have substantially same characteristics,
the drain bias supply circuit includes a first drain bias use resistance element connected between the drain of the first field effect transistor and a voltage source and a second drain bias use resistance element connected between the drain of the second field effect transistor and a voltage source,
a resistance value of the first drain bias use resistance element and a resistance value of the second drain bias use resistance element being set at substantially equal values, and
a capacitance value of the first capacitor and a capacitance value of the second capacitor being set at substantially equal values.

**180.** A receiver as set forth in claim 180, wherein:

a ratio Wga/Wgb of a gate width Wga of the first field effect transistor and a gate width Wgb of the second field effect transistor is set at N,

the drain bias supply circuit includes a first drain bias use resistance element connected between the drain of the first field effect transistor and a voltage source and a second drain bias use resistance element connected between the drain of the second field effect transistor and a voltage source,

a resistance value Ra of the first drain bias use resistance element and a resistance value Rb of the second drain bias use resistance element being set so as to satisfy a condition of Ra/Rb = 1/N, and

a capacitance value of the first capacitor and a capacitance value of the second capacitor being set at substantially equal values.

**181.** A receiver as set forth in claim 165, wherein an amplifier for amplifying the output signal from the first output terminal is connected to at least the first output terminal between the first output terminal and the second output terminal of the first branch circuit.

**182.** A receiver comprising:

a phased array antenna portion including a plurality of antenna elements for receiving radio signals, a plurality of variable phase circuits for controlling phases of signals received at the antenna elements to desired phases, a signal combining circuit for combining output signals of the plurality of variable phase circuits;

a demodulator having a first signal input terminal to which a combined reception signal from the signal combining circuit of the phased array antenna portion is input, a second signal input terminal to which the local signal is input, a first branch circuit having an input terminal, a first output terminal, a second output terminal, and a third output terminal, the input terminal being connected to the first signal input terminal, branching the reception signal input to the input terminal to first, second, and third reception signals, outputting the first reception signal from the first output terminal, outputting the second reception signal from the second output terminal, and outputting the third reception signal from the third output terminal, a second branch circuit having an input terminal, a first output terminal, and a second output terminal, the input terminal being connected to the second signal input terminal, branching the local signal input to the input terminal to first and second local signals, outputting the first local signal from the first output terminal, and outputting the second local signal from the second output terminal, a first phase shifter for shifting a phase of the first local signal output from the first output terminal of the second branch circuit by exactly a predetermined amount and outputting the result, a second phase shifter for shifting a phase of the second local signal output from the second output terminal of the second branch circuit by exactly a predetermined amount and outputting the result, a first coupler circuit for coupling the second reception signal output from the second output terminal of the first branch circuit and the first local signal shifted in phase by exactly a predetermined amount output from the first phase shifter and outputting the result, a second coupler circuit for coupling the third reception signal output from the third output terminal of the first branch circuit and the second local signal shifted in phase by exactly a predetermined amount output from the second phase shifter and outputting the result, a first signal level detection circuit for detecting the level of the signal output from the first output terminal of the first branch circuit, a second signal level detection circuit for detecting the level of the signal output from the first coupler circuit, a third signal level detection circuit for detecting the level of the signal output from the second coupler circuit, and a conversion circuit for converting the output signal of the first signal level detection circuit, the output signal of the second signal level detection circuit, and the output signal of the third signal level detection circuit to a plurality of signal components included in the reception signal;

a gain control circuit for adjusting the level of the reception signal to a desired level and supplying the result to the first signal input terminal of the demodulator; and

a local signal generation circuit for generating the local signal with a desired oscillation frequency and supplying the result to the second signal input terminal of the demodulator.

**183.** A receiver as set forth in claim 182, further comprising:

a mean signal power computation circuit receiving the output signal of the first signal level detection circuit of the demodulator and computing a mean signal power and

a gain control signal generation circuit for outputting the control signal to the variable gain circuit so that the reception signal levels input to the demodulator become constant based on the mean power found at the mean signal power computation circuit,

the variable gain circuit adjusting the input reception signal to the level in accordance with the control signal by the gain control signal generation circuit and supplying the result to the first signal input terminal of the demodulator.

**184.** A receiver as set forth in claim 182, further comprising:

a frequency error detection circuit for detecting a frequency error based on a plurality of signal components obtained at the conversion circuit of the demodulator and supplying the result to the local signal generation circuit,

the local signal generation circuit setting an oscillation frequency of the local signal so as to become a frequency substantially equal to a carrier frequency of the reception signal based on the frequency error value detected at the frequency error detection circuit.

**185.** A receiver comprising:

a phased array antenna portion including a plurality of antenna elements for receiving radio signals, a plurality of variable phase circuits for controlling phases of signals received at the antenna elements to desired phases, a signal combining circuit for combining output signals of the plurality of variable phase circuits;

a demodulator having a first signal input terminal to which a combined reception signal from the signal combining circuit of the phased array antenna portion is input, a second signal input terminal to which the local signal is input, a first branch circuit having an input terminal, a first output terminal, a second output terminal, and a third output terminal, the input terminal being connected to the first signal input terminal, branching the reception signal input to the input terminal to first, second, and third reception signals, outputting the first reception signal from the first output terminal, outputting the second reception signal from the second output terminal, and outputting the third reception signal from the third output terminal, a second branch circuit having an input terminal, a first output terminal, and a second output terminal, the input terminal being connected to the second signal input terminal, branching the local signal input to the input terminal to first and second local signals, outputting the first local signal from the first output terminal, and outputting the second local signal from the second output terminal, a first phase shifter for shifting a phase of the first local signal output from the first output terminal of the second branch circuit by exactly a predetermined amount and outputting the result, a second phase shifter for shifting a phase of the second local signal output from the second output terminal of the second branch circuit by exactly a predetermined amount and outputting the result, a first coupler circuit for coupling the second reception signal output from the second output terminal of the first branch circuit and the first local signal shifted in phase by exactly a predetermined amount output from the first phase shifter and outputting the result, a second coupler circuit for coupling the third reception signal output from the third output terminal of the first branch circuit and the second local signal shifted in phase by exactly a predetermined amount output from the second phase shifter and outputting the result, a first signal level detection circuit for detecting the level of the signal output from the first output terminal of the first branch circuit, a second signal level detection circuit for detecting the level of the signal output from the first coupler circuit, a third signal level detection circuit for detecting the level of the signal output from the second coupler circuit, a first analog/digital converter for converting the output signal of the first signal level detection circuit from an analog signal to a digital signal, a second analog/digital converter for converting the output signal of the second signal level detection circuit from an analog signal to a digital signal, a third analog/digital converter for converting the output signal of the third signal level detection circuit from an analog signal to a digital signal, and a conversion circuit for converting the output digital signal of the first analog/digital converter, the output digital signal of the second analog/digital converter, and the output digital signal of the third analog/digital converter to a plurality of signal components included in the reception signal;

a gain control circuit for adjusting the level of the reception signal to a desired level and supplying the result to the first signal input terminal of the demodulator; and

a local signal generation circuit for generating the local signal with a desired oscillation frequency and supplying the result to the second signal input terminal of the demodulator.

**186.** A receiver as set forth in claim 185, further comprising:

a mean signal power computation circuit receiving the output signal of the first signal level detection circuit of the demodulator and computing a mean signal power and

a gain control signal generation circuit for outputting the control signal to the variable gain circuit so that the reception signal levels input to the demodulator become constant based on the mean power found at the mean signal power computation circuit,

the variable gain circuit adjusting the input reception signal to the level in accordance with the control signal by the gain control signal generation circuit and supplying the result to the first signal input terminal of the demodulator.

**187.** A receiver as set forth in claim 185, further comprising:

a frequency error detection circuit for detecting a frequency error based on a plurality of signal components obtained at the conversion circuit of the demodulator and supplying the result to the local signal generation circuit,

the local signal generation circuit setting an oscillation frequency of the local signal so as to become a frequency substantially equal to a carrier frequency of the reception signal based on the frequency error value detected at the frequency error detection circuit.

**188.** A receiver comprising:

a phased array antenna portion including a plurality of antenna elements for receiving radio signals, a plurality of variable phase circuits for controlling phases of signals received at the antenna elements to desired phases, a signal combining circuit for combining output signals of the plurality of variable phase circuits;

a demodulator having a first signal input terminal to which a combined reception signal of the signal combining circuit of the phased array antenna portion is input, a second signal input terminal to which the local signal is input, a first branch circuit having an input terminal, a first output terminal, a second output terminal, and a third output terminal, the input terminal being connected to the first signal input terminal, branching the reception signal input to the input terminal to first, second, and third reception signals, outputting the first reception signal from the first output terminal, outputting the second reception signal from the second output terminal, and outputting the third reception signal from the third output terminal, a second branch circuit having an input terminal, a first output terminal, a second output terminal, and a third output terminal, the input terminal being connected to the second signal input terminal, branching the local signal input to the input terminal to first, second, and third local signals, outputting the first local signal from the first output terminal, outputting the second local signal from the second output terminal, and outputting the third local signal from the third output terminal, a first phase shifter for shifting a phase of the first local signal output from the first output terminal of the second branch circuit by exactly a predetermined amount and outputting the result, a second phase shifter for shifting a phase of the second local signal output from the second output terminal of the second branch circuit by exactly a predetermined amount and outputting the result, a first coupler circuit for coupling the second reception signal output from the second output terminal of the first branch circuit and the first local signal shifted in phase by exactly a predetermined amount output from the first phase shifter and outputting the result, a second coupler circuit for coupling the third reception signal output from the third output terminal of the first branch circuit and the second local signal shifted in phase by exactly a predetermined amount output from the second phase shifter and outputting the result, a third coupler circuit for coupling the first reception signal output from the first output terminal of the first branch circuit and the third local signal output from the third output terminal of the second branch circuit and outputting the result, a first signal level detection circuit for detecting the level of the signal output from the third coupler circuit, a second signal level detection circuit for detecting the level of the signal output from the first coupler circuit, and a third signal level detection circuit for detecting the level of the signal output from the second coupler circuit, and a conversion circuit for converting the output signal of the first signal level detection circuit, the output signal of the second signal level detection circuit, and the output signal of the third signal level detection circuit to a plurality of signal components included in the reception signal;

a gain control circuit for adjusting the level of the reception signal to a desired level and supplying the result to the first signal input terminal of the demodulator; and

a local signal generation circuit for generating the local signal with a desired oscillation frequency and supplying the result to the second signal input terminal of the demodulator.

**189.** A receiver as set forth in claim 188, further comprising:

a mean signal power computation circuit receiving the output signal of the first signal level detection circuit of the demodulator and computing a mean signal power and

a gain control signal generation circuit for outputting the control signal to the variable gain circuit so that the reception signal levels input to the demodulator become constant based on the mean power found at the mean signal power computation circuit,
the variable gain circuit adjusting the input reception signal to the level in accordance with the control signal by the gain control signal generation circuit and supplying the result to the first signal input terminal of the demodulator.

**190.** A receiver as set forth in claim 188, further comprising:

a frequency error detection circuit for detecting a frequency error based on a plurality of signal components obtained at the conversion circuit of the demodulator and supplying the result to the local signal generation circuit,
the local signal generation circuit setting an oscillation frequency of the local signal so as to become a frequency substantially equal to a carrier frequency of the reception signal based on the frequency error value detected at the frequency error detection circuit.

**191.** A receiver comprising:

a phased array antenna portion including a plurality of antenna elements for receiving radio signals, a plurality of variable phase circuits for controlling phases of signals received at the antenna elements to desired phases, a signal combining circuit for combining output signals of the plurality of variable phase circuits;
a demodulator having a first signal input terminal to which a combined reception signal of the signal combining circuit of the phased array antenna portion is input, a second signal input terminal to which the local signal is input, a first branch circuit having an input terminal, a first output terminal, and a second output terminal, the input terminal being connected to the first signal input terminal, branching the reception signal input to the input terminal to first and second reception signals, outputting the first reception signal from the first output terminal, and outputting the second reception signal from the second output terminal, a second branch circuit having an input terminal, a first output terminal, and a second output terminal, the input terminal being connected to the first output terminal of the first branch circuit, branching the reception signal input to the input terminal to third and fourth reception signals, outputting the third reception signal from the first output terminal, and outputting the fourth reception signal from the second output terminal, a third branch circuit having an input terminal, a first output terminal, and a second output terminal, the input terminal being connected to the second signal input terminal, branching the local signal input to the input terminal to first and second local signals, outputting the first local signal from the first output terminal, and outputting the second local signal from the second output terminal, a first phase shifter for shifting a phase of the first local signal output from the first output terminal of the third branch circuit by exactly a predetermined amount and outputting the result, a second phase shifter for shifting a phase of the second local signal output from the second output terminal of the third branch circuit by exactly a predetermined amount and outputting the result, a first coupler circuit for coupling the third reception signal output from the first output terminal of the second branch circuit and the first local signal shifted in phase by exactly a predetermined amount output from the first phase shifter and outputting the result, a second coupler circuit for coupling the fourth reception signal output from the second output terminal of the second branch circuit and the second local signal shifted in phase by exactly a predetermined amount output from the second phase shifter and outputting the result, a first signal level detection circuit for detecting the level of the signal output from the first coupler circuit, a second signal level detection circuit for detecting the level of the signal output from the second coupler circuit, a third signal level detection circuit for detecting the level of the signal output from the second output terminal of the first branch circuit, and a conversion circuit for converting the output signal of the first signal level detection circuit, the output signal of the second signal level detection circuit, and the output signal of the third signal level detection circuit to a plurality of signal components included in the reception signal;
a gain control circuit for adjusting the level of the reception signal to a desired level and supplying the result to the first signal input terminal of the demodulator; and
a local signal generation circuit for generating the local signal with a desired oscillation frequency and supplying the result to the second signal input terminal of the demodulator.

**192.** A receiver as set forth in claim 191, further comprising:

a mean signal power computation circuit receiving the output signal of the first signal level detection circuit of the demodulator and computing a mean signal power and
a gain control signal generation circuit for outputting the control signal to the variable gain circuit so that the reception signal levels input to the demodulator become constant based on the mean power found at the mean signal power computation circuit,

the variable gain circuit adjusting the input reception signal to the level in accordance with the control signal by the gain control signal generation circuit and supplying the result to the first signal input terminal of the demodulator.

**193.** A receiver as set forth in claim 191, further comprising:

a frequency error detection circuit for detecting a frequency error based on a plurality of signal components obtained at the conversion circuit of the demodulator and supplying the result to the local signal generation circuit,

the local signal generation circuit setting an oscillation frequency of the local signal so as to become a frequency substantially equal to a carrier frequency of the reception signal based on the frequency error value detected at the frequency error detection circuit.

**194.** A receiver comprising:

a phased array antenna portion including a plurality of antenna elements for receiving radio signals, a plurality of variable phase circuits for controlling phases of signals received at the antenna elements to desired phases, a signal combining circuit for combining output signals of the plurality of variable phase circuits;

a demodulator having a first signal input terminal to which a combined reception signal of the signal combining circuit of the phased array antenna portion is input, a second signal input terminal to which the local signal is input, a first branch circuit having an input terminal, a first output terminal, a second output terminal, and a third output terminal, the input terminal being connected to the first signal input terminal, branching the reception signal input to the input terminal to first, second, and third reception signals, outputting the first reception signal from the first output terminal, outputting the second reception signal from the second output terminal, and outputting the third reception signal from the third output terminal, a second branch circuit having an input terminal, a first output terminal, and a second output terminal, the input terminal being connected to the second signal input terminal, branching the local signal input to the input terminal to first and second local signals, outputting the first local signal from the first output terminal, and outputting the second local signal from the second output terminal, a first phase shifter for shifting a phase of the first local signal output from the first output terminal of the second branch circuit by exactly a predetermined amount and outputting the result, a second phase shifter for shifting a phase of the third reception signal output from the third output terminal of the first branch circuit by exactly a predetermined amount and outputting the result, a first coupler circuit for coupling the second reception signal output from the second output terminal of the first branch circuit and the first local signal shifted in phase by exactly a predetermined amount output from the first phase shifter and outputting the result, a second coupler circuit for coupling the third reception signal shifted in phase by exactly a predetermined amount output from the second phase shifter and the second local signal output from the second branch circuit and outputting the result, a first signal level detection circuit for detecting the level of the signal output from the first output terminal of the first branch circuit, a second signal level detection circuit for detecting the level of the signal output from the first coupler circuit, a third signal level detection circuit for detecting the level of the signal output from the second coupler circuit, and a conversion circuit for converting the output signal of the first signal level detection circuit, the output signal of the second signal level detection circuit, and the output signal of the third signal level detection circuit to a plurality of signal components included in the reception signal;

a gain control circuit for adjusting the level of the reception signal to a desired level and supplying the result to the first signal input terminal of the demodulator; and

a local signal generation circuit for generating the local signal with a desired oscillation frequency and supplying the result to the second signal input terminal of the demodulator.

**195.** A receiver as set forth in claim 194, further comprising:

a mean signal power computation circuit receiving the output signal of the first signal level detection circuit of the demodulator and computing a mean signal power and

a gain control signal generation circuit for outputting the control signal to the variable gain circuit so that the reception signal levels input to the demodulator become constant based on the mean power found at the mean signal power computation circuit,

the variable gain circuit adjusting the input reception signal to the level in accordance with the control signal by the gain control signal generation circuit and supplying the result to the first signal input terminal of the demodulator.

**196.** A receiver as set forth in claim 194, further comprising:

a frequency error detection circuit for detecting a frequency error based on a plurality of signal components obtained at the conversion circuit of the demodulator and supplying the result to the local signal generation circuit,
the local signal generation circuit setting an oscillation frequency of the local signal so as to become a frequency substantially equal to a carrier frequency of the reception signal based on the frequency error value detected at the frequency error detection circuit.

**197.** A receiver comprising:

a phased array antenna portion including a plurality of antenna elements for receiving radio signals, a plurality of variable phase circuits for controlling phases of signals received at the antenna elements to desired phases, a signal combining circuit for combining output signals of the plurality of variable phase circuits;
a demodulator having a first signal input terminal to which a combined reception signal of the signal combining circuit of the phased array antenna portion is input, a second signal input terminal to which the local signal is input, a first branch circuit having an input terminal, a first output terminal, and a second output terminal, the input terminal being connected to the first signal input terminal, branching the reception signal input to the input terminal to first and second reception signals, outputting the first reception signal from the first output terminal, and outputting the second reception signal from the second output terminal, a second branch circuit having an input terminal, a first output terminal, and a second output terminal, the input terminal being connected to the first output terminal of the first branch circuit, branching the reception signal input to the input terminal to third and fourth reception signals, outputting the third reception signal from the first output terminal, and outputting the fourth reception signal from the second output terminal, a third branch circuit having an input terminal, a first output terminal, and a second output terminal, the input terminal being connected to the second signal input terminal, branching the local signal input to the input terminal to first and second local signals, outputting the first local signal from the first output terminal, and outputting the second local signal from the second output terminal, a fourth branch circuit having an input terminal, a first output terminal, and a second output terminal, the input terminal being connected to the first output terminal of the third branch circuit, branching the local signal input to the input terminal to third and fourth local signals, outputting the third local signal from the first output terminal, and outputting the fourth local signal from the second output terminal, a first phase shifter for shifting a phase of the third local signal output from the first output terminal of the fourth branch circuit by exactly a predetermined amount and outputting the result, a second phase shifter for shifting a phase of the fourth local signal output from the second output terminal of the fourth branch circuit by exactly a predetermined amount and outputting the result, a first coupler circuit for coupling the third reception signal output from the first output terminal of the second branch circuit and the third local signal shifted in phase by exactly a predetermined amount output from the first phase shifter and outputting the result, a second coupler circuit for coupling the fourth reception signal output from the second output terminal of the second branch circuit and the fourth local signal shifted in phase by exactly a predetermined amount output from the second phase shifter and outputting the result, a first signal level detection circuit for detecting the level of the signal output from the first coupler circuit, a second signal level detection circuit for detecting the level of the signal output from the second coupler circuit, a third signal level detection circuit for detecting the level of the signal output from the second output terminal of the first branch circuit, a fourth signal level detection circuit for detecting the level of the signal output from the second output terminal of the third branch circuit, and a conversion circuit for converting the output signal of the first signal level detection circuit, the output signal of the second signal level detection circuit, the output signal of the third signal level detection circuit, and the output signal of the fourth signal level detection circuit to a plurality of signal components included in the reception signal;
a gain control circuit for adjusting the level of the reception signal to a desired level and supplying the result to the first signal input terminal of the demodulator; and
a local signal generation circuit for generating the local signal with a desired oscillation frequency and supplying the result to the second signal input terminal of the demodulator.

**198.** A receiver as set forth in claim 197, further comprising:

a mean signal power computation circuit receiving the output signal of the first signal level detection circuit of the demodulator and computing a mean signal power and

a gain control signal generation circuit for outputting the control signal to the variable gain circuit so that the reception signal levels input to the demodulator become constant based on the mean power found at the mean signal power computation circuit,

the variable gain circuit adjusting the input reception signal to the level in accordance with the control signal by the gain control signal generation circuit and supplying the result to the first signal input terminal of the demodulator.

**199.** A receiver as set forth in claim 197, further comprising:

a frequency error detection circuit for detecting a frequency error based on a plurality of signal components obtained at the conversion circuit of the demodulator and supplying the result to the local signal generation circuit,

the local signal generation circuit setting an oscillation frequency of the local signal so as to become a frequency substantially equal to a carrier frequency of the reception signal based on the frequency error value detected at the frequency error detection circuit.

**200.** A receiver comprising:

a phased array antenna portion including a plurality of antenna elements for receiving radio signals, a plurality of variable phase circuits for controlling phases of signals received at the antenna elements to desired phases, a signal combining circuit for combining output signals of the plurality of variable phase circuits;

a demodulator having a first signal input terminal to which a combined reception signal of the signal combining circuit of the phased array antenna portion is input, a second signal input terminal to which the local signal is input, a branch circuit having an input terminal, a first output terminal, and a second output terminal, the input terminal being connected to the first signal input terminal, branching the reception signal input to the input terminal to first and second reception signals, outputting the first reception signal from the first output terminal, and outputting the second reception signal from the second output terminal, a first phase divider having an input terminal, a first output terminal, and a second output terminal, the input terminal being connected to the first output terminal of the branch circuit, branching the reception signal input to the input terminal to third and fourth reception signals having inverse phases to each other, outputting the third reception signal from the first output terminal, and outputting the fourth reception signal from the second output terminal, a second phase divider having an input terminal, a first output terminal, and a second output terminal, the input terminal being connected to the second signal input terminal, branching the local signal input to the input terminal to first and second local signals having inverse phases to each other, outputting the first local signal from the first output terminal, and outputting the second local signal from the second output terminal, a first phase shifter for shifting a phase of the first local signal output from the first output terminal of the second phase divider by exactly a predetermined amount and outputting the result, a second phase shifter for shifting a phase of the second local signal output from the second output terminal of the second phase divider by exactly a predetermined amount and outputting the result, a first coupler circuit for coupling the third reception signal output from the first output terminal of the first phase divider and the first local signal shifted in phase by exactly a predetermined amount output from the first phase shifter and outputting the result, a second coupler circuit for coupling the fourth reception signal output from the second output terminal of the first phase divider and the second local signal shifted in phase by exactly a predetermined amount output from the second phase shifter and outputting the result, a first signal level detection circuit for detecting the level of the signal output from the first coupler circuit, a second signal level detection circuit for detecting the level of the signal output from the second coupler circuit, a third signal level detection circuit for detecting the level of the signal output from the second output terminal of the branch circuit, and a conversion circuit for converting the output signal of the first signal level detection circuit, the output signal of the second signal level detection circuit, and the output signal of the third signal level detection circuit to a plurality of signal components included in the reception signal;

a gain control circuit for adjusting the level of the reception signal to a desired level and supplying the result to the first signal input terminal of the demodulator; and

a local signal generation circuit for generating the local signal with a desired oscillation frequency and supplying the result to the second signal input terminal of the demodulator.

**201.** A receiver as set forth in claim 200, further comprising:

a mean signal power computation circuit receiving the output signal of the first signal level detection circuit of the demodulator and computing a mean signal power and

a gain control signal generation circuit for outputting the control signal to the variable gain circuit so that the reception signal levels input to the demodulator become constant based on the mean power found at the mean signal power computation circuit,

the variable gain circuit adjusting the input reception signal to the level in accordance with the control signal by the gain control signal generation circuit and supplying the result to the first signal input terminal of the demodulator.

202. A receiver as set forth in claim 200, further comprising:

a frequency error detection circuit for detecting a frequency error based on a plurality of signal components obtained at the conversion circuit of the demodulator and supplying the result to the local signal generation circuit,

the local signal generation circuit setting an oscillation frequency of the local signal so as to become a frequency substantially equal to a carrier frequency of the reception signal based on the frequency error value detected at the frequency error detection circuit.

# FIG.1

FIG.2A

FIG.2B

FIG.3B

P41

P42

P43

P44

SIX-PORT TO IQ CONVERSION CIRCUIT

49

I

Q

FIG.3A

P41

POWER DETECTOR

45

Sr+Slo

P42

POWER DETECTOR

46

Sr-Slo

RING HYBRID CIRCUIT

43

40

BRANCH CIRCUIT

41

RECEPTION SIGNAL   Sr

LOCAL SIGNAL   Slo

QUADRATURE HYBRID CIRCUIT

42

R41

GND

RING HYBRID CIRCUIT

43

Sr-jSlo

POWER DETECTOR

48

P44

Sr+jSlo

POWER DETECTOR

47

P43

# FIG.4

<u>50</u>

EP 1 387 484 A1

FIG.5

# FIG.6

$$R1/R0 = R0/R2$$

# FIG.7

<u>100</u>

RECEPTION SIGNAL Sr

104

101 MULTI-PORT DEMODULATOR

MEAN SIGNAL POWER COMPUTATION CIRCUIT — 102

S105

S102

GAIN CONTROL SIGNAL GENERATION CIRCUIT — 105

103

S106

SO

FREQUENCY ERROR DETECTION CIRCUIT — 106

I

Q

BASEBAND SIGNAL PROCESSING CIRCUIT

DEMODULATED SIGNAL

107

EP 1 387 484 A1

FIG.8

RECEPTION SIGNAL
Sr

TINSr

101

1001 — I1 BRANCH CIRCUIT
O1    O2    O3

1002

1004
θ2

1006

LOCAL SIGNAL
Slo

TINSlo

1002 — O2 BRANCH CIRCUIT I1
O1

1003 — θ1

1005

1008

1007 — PD1    PD2 — 1008    PD3 — 1009
P1    P2    P3

MEAN SIGNAL POWER COMPUTATION CIRCUIT

102

1010 — MULTI-PORT SIGNAL-TO-IQ SIGNAL CONVERSION CIRCUIT

I    Q

EP 1 387 484 A1

# FIG.9

# FIG.10

# FIG.11

# FIG.12

# FIG.13

$\lambda g/4$

1002a

10021

R107

I1

O1

O2

10022

# FIG.14

L104

1002b

C105

I1

10023

C107

GND

L105

R107

10024

C106

GND

O1

O2

# FIG.15

# FIG.16

# FIG.17

1003a
(1004a)

L106

a ——○—————————————○—— b

C108 ~ C109

GND    GND

# FIG.18

1003b
(1004b)    10031

a ——○—[ TRANSMISSION LINE ]——○—— b

# FIG.19

1003c (1004c)

a ——○——/\/\/——————○—— b

R111    ~ C110

GND

# FIG.20

1005a (1006a)

# FIG.21

# FIG.22

# FIG.23

# FIG.24

# FIG.25

EP 1 387 484 A1

FIG.26

400

P3' P2' P1'

(hq1) 4006
(hq2) 4007
(hq3) 4008
4012
4013
4014
(hq0) 4002
Q

(hi3) 4005
(hi2) 4004
(hi1) 4003
4009
4010
4011
(hi0) 4001
I

# FIG.27

EP 1 387 484 A1

101B

RECEPTION SIGNAL
Sr
○─ T$_{INSr}$

I1
1001 ─ BRANCH CIRCUIT
O1          O2          O3

1004

LOCAL
SIGNAL
Slo ○─ │I1  BRANCH
        │   CIRCUIT  │O2 ─→ │ θ2 │ ─────────────────────────→ ⊕ ─ 1006
T$_{INSlo}$                 1003
                   │O1 ─→ │ θ1 │ ──────────────→ ⊕ ─ 1005

                   │O3 ─────────────→ ⊕ ─ 1023

1002B

1007 ─ │ PD1 │      │ PD2 │      │ PD3 │ ─ 1009
          │P1      1008  │P2          │P3

1010B ─ MULTI-PORT SIGNAL-TO-IQ SIGNAL
        CONVERSION CIRCUIT

              ↓ I          ↓ Q

# FIG.28

EP 1 387 484 A1

RECEPTION SIGNAL
Sr

$T_{INSr}$

1001C

101C

1024

I1
BRANCH CIRCUIT
O1                    O2

1025

I1
BRANCH CIRCUIT
O1                    O2

1002

1003

1004

LOCAL
SIGNAL
Slo

$T_{INSlo}$

BRANCH
CIRCUIT
I1

O1

O2

θ1

θ2

1005

1006

1007

1008

1009

PD1          PD2          PD3

P1            P2            P3

1010C

MULTI-PORT SIGNAL-TO-IQ SIGNAL
CONVERSION CIRCUIT

I                    Q

# FIG.29

EP 1 387 484 A1

101D

RECEPTION SIGNAL
Sr

$T_{INSr}$

1024 — BRANCH CIRCUIT
I1
O1          O2

1026

1025 — BRANCH CIRCUIT
I1
O1          O2

1027

1002                    1003

LOCAL
SIGNAL
Slo            BRANCH
CIRCUIT
I1

$T_{INSlo}$

O1          θ1          1005

O2          θ2          1006

1004

1008

1007 — PD1          PD2          PD3 — 1009

P1          P2          P3

1010D — MULTI-PORT SIGNAL-TO-IQ SIGNAL
CONVERSION CIRCUIT

I          Q

# FIG.30

EP 1 387 484 A1

# FIG.31

EP 1 387 484 A1

# FIG.32

# FIG.33

1031 (1032)

# FIG.34

EP 1 387 484 A1

LIST OF REFERENCES

100, 100A... receiver

101, 101A to 101G... multi-port demodulator

1001... first branch circuit

1002... second branch circuit

1003... first phase shifter

1004... second phase shifter

1005... first coupler circuit

1006... second coupler circuit

1007... first power detector

1008... second power detector

1009... third power detector

1010, 1010B to 1010G... multi-port signal-to-IQ signal

conversion circuit

1011 to 1013... low pass filter

1014 to 1016... amplifier

1017... first analog/digital convertor (ADC)

1018... second analog/digital convertor (ADC)

1019... second analog/digital convertor (ADC)

1020 to 1022... low pass filter

1023... third coupler signal

1024, 1025... branch circuit

1026, 1027... amplifier

1028... phase shifter

1029... branch circuit

1030... fourth power detector

1031, 1032... 180 degree phase divider

102... mean signal power computation circuit

103... local signal generation circuit

104... variable gain circuit

105... gain control signal generation circuit

106... frequency error detection circuit

107... baseband signal processing circuit

200... power detector

201... matching circuit

202, 203... gate bias supply circuit

Q201... first field effect transistor

Q202... second field effect transistor

C201 to C203... capacitor

R201 to R208.. resistance element

V201... voltage source

301 to 303... low pass filter

304... computation circuit

400... computation circuit

## INTERNATIONAL SEARCH REPORT

| | International application No. |
|---|---|
| | PCT/JP01/03833 |

**A. CLASSIFICATION OF SUBJECT MATTER**
Int.Cl$^7$   H03D 1/22, H04B 1/30, H04L 27/38

According to International Patent Classification (IPC) or to both national classification and IPC

**B. FIELDS SEARCHED**

Minimum documentation searched (classification system followed by classification symbols)
Int.Cl$^7$   H03D 1/22, H04B 1/16-1/30, H04L 27/38

Documentation searched other than minimum documentation to the extent that such documents are included in the fields searched
Jitsuyo Shinan Koho          1926-1996      Toroku Jitsuyo Shinan Koho   1994-2001
Kokai Jitsuyo Shinan Koho   1971-2001      Jitsuyo Shinan Toroku Koho   1996-2001

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2001-60982 A (Sony International (Europe) GmbH), 06 March, 2001 (06.03.01), pages 3 to 5 (Family: none) | 1,2,10,22,23, 31,32,41,42, 50,51,57,58, 67,68,70,71, 83,84,86,87, 107,108,110, 111,123,124 126,127,140, 141,143,144, 156,157,159, 160,165,166, 168,169, 182-202 |

☒ Further documents are listed in the continuation of Box C.     ☐ See patent family annex.

| * Special categories of cited documents: | "T" later document published after the international filing date or |
|---|---|
| "A" document defining the general state of the art which is not considered to be of particular relevance | priority date and not in conflict with the application but cited to understand the principle or theory underlying the invention |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 26 July, 2001 (26.07.01) | 07 August, 2001 (07.08.01) |

| Name and mailing address of the ISA/ | Authorized officer |
|---|---|
| Japanese Patent Office | |
| Facsimile No. | Telephone No. |

Form PCT/ISA/210 (second sheet) (July 1992)

**INTERNATIONAL SEARCH REPORT**

International application No.

PCT/JP01/03833

C (Continuation). DOCUMENTS CONSIDERED TO BE RELEVANT

| Category* | Citation of document, with indication, where appropriate, of the relevant passages | Relevant to claim No. |
|---|---|---|
| A | | 3-9,11-21, 24-30,33-40, 43-49,52-56, 59-66,69, 72-82,85, 88-106,109, 112-122,125, 128-139,142, 145-155,158, 161-164,167, 170-181 |
| Y | JP 2000-196693 A (Sony International (Europe) GmbH), 14 July, 2000 (14.07.00), pages 3 to 18   (Family: none) | 1,2,10,22,23, 31,32,41,42, 50,51,57,58, 67,68,70,71, 83,84,86,87, 107,108,110, 111,123,124, 126,127,140, 141,143,144, 156,157,159, 160,165,166, 168,169, 182-202 |
| A | | 3-9,11-21, 24-30,33-40, 43-49,52-56, 59-66,69, 72-82,85, 88-106,109, 112-122,125, 128-139,142, 143-155,158, 161-164,167, 170-181 |

Form PCT/ISA/210 (continuation of second sheet) (July 1992)